# EUROPEAN PATENT APPLICATION

(11) **EP 4 386 053 A2**
(43) Date of publication of application: **19.06.2024**
(21) Application number: 22784741.5
(22) Date of filing: 08.08.2022
(51) Int. Cl.: C08L 83/04, C08K 3/00, C08K 5/00, C09D 183/04, H01L 23/29, H01L 23/31, H05K 3/28

(54) **SILOXANE POLYMER COMPOSITION, CURED PRODUCT, ELECTRONIC COMPONENT, OPTICAL COMPONENT, AND COMPOSITE MEMBER**

(30) Priority: 11.08.2021 JP 2021131057
(71) Applicant: JNC Corporation, Chiyoda-ku Tokyo 100-8105 (JP)
(72) Inventor: HIROTA, Takayuki, Ichihara-shi, Chiba 290-8551 (JP); ENOKI, Nobuo, Ichihara-shi, Chiba 290-8551 (JP); FUJIMORI, Sayaka, Ichihara-shi, Chiba 290-8551 (JP); YANO, Masakazu, Ichihara-shi, Chiba 290-8551 (JP); SUWA, Kazuya, Ichihara-shi, Chiba 290-8551 (JP)
(74) Representative: Becker, Eberhard
(86) International application number: PCT/JP2022/030230
(87) International publication number: WO 2022/215759

(57) **Abstract**

A curable resin composition according to the present invention makes it possible to form a cured product having heat resistance suited for use in applications such as electronic components including printed circuit boards, semiconductor elements and light emitting diodes (LEDs), and automotive electronic components, the curable resin composition containing: a silicon compound (A) that is formed from either one or both of the silsesquioxane groups represented by formula (1) or (2) and from at least one structural unit among the siloxane groups represented by formulas (3)-(5), and that has a weight average molecular weight of 3,000-1,000,000; and a compound (B) that contains at least one element among Ce, La, Pr, Nd, Y and Fe. 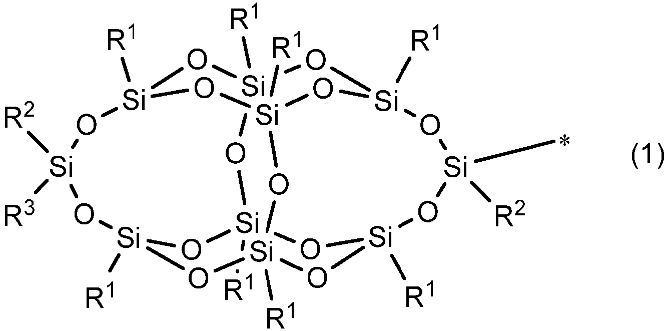 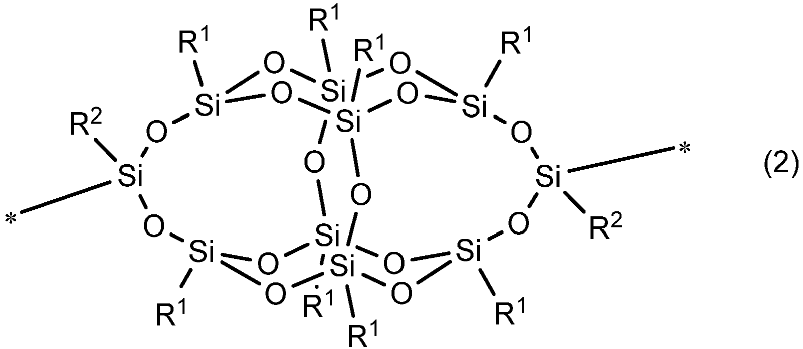 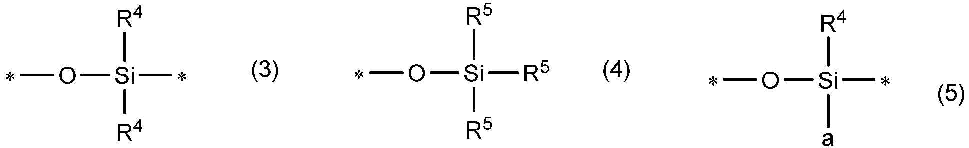 (a represents the structure indicated herein; R¹-R⁷ represent prescribed groups.)

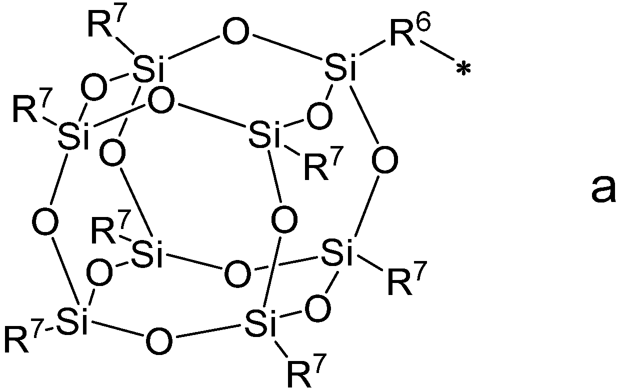

## Description

### [Technical Field]

The present invention relates to a siloxane polymer composition, a cured product, an electronic component, an optical component, and a composite member.

### [Background Art]

Silicone resins are excellent in terms of electrical insulating properties, weather resistance, heat resistance, and the like and are used in sealants, adhesives, protective materials and the like for a variety of electronic devices. Particularly, silicone resins have high heat resistance that cannot be attained from ordinary organic polymers based on the high binding energy of a siloxane bond (Si-O-Si) configuring the resins.

Recently, for electronic components including printed circuit boards, semiconductor elements and light emitting diodes (LEDs), and automotive electronic components, in order to secure additional reliability such as the higher densities and higher output of elements and operation temperature improvement, there has been a demand for more favorable heat resistance than ever, which could not have been met with conventional silicone-based materials.

As means for enhancing heat resistance, there are techniques of adding a variety of inorganic fillers (Patent Literature 1 and 2). However, those techniques are not easily acceptable due to the securement of the dispersibility of the inorganic fillers and polymer systems, the deterioration of transparency and the deterioration of toughness attributed to the addition, the deterioration of workability due to an increase in the viscosity or the like. In addition, depending on the kind of the filler, there has been a report regarding a concern of the deterioration of electrical insulating properties (Patent Literature 3).

Techniques for improving heat resistance by adding a cerium salt also have been devised (Patent Literature 4 and 5). However, these techniques also failed to enhance heat resistance to be high enough to satisfy the above-described demand.

Incidentally, silsesquioxanes are known as materials exhibiting high heat resistance. These materials exhibit not only excellent heat resistance but also high transparency and workability, and thus active research and development has been underway in recent years. Particular, polymer compounds including a double decker-type silsesquioxane structure having favorable characteristics such as solubility in organic solvents, the control of the refractive index, and the imparting of photocurable properties are drawing attention. Among them, siloxane polymers containing a double decker-type silsesquioxane have been reported to have high heat resistance (Patent Literature 6 and 7). However, in spite of the use of these siloxane polymers having high heat resistance, there still has been a demand for additional improvement in heat resistance.

### [Citation List]

### [Patent Literature]

[Patent Literature 1]
   PCT International Publication No. WO 2016/103654
[Patent Literature 2]
   Japanese Patent Laid-Open No. 2017-186497
[Patent Literature 3]
   Japanese Patent Laid-Open No. 2017-14399
[Patent Literature 4]
   Japanese Patent Laid-Open No. 2008-291148
[Patent Literature 5]
   PCT International Publication No. WO 2019/116892
[Patent Literature 6]
   Japanese Patent Laid-Open No. 2010-116464
[Patent Literature 7]
   Japanese Patent Laid-Open No. 2020-90572

### [Summary of Invention]

### [Technical Problem]

The present invention has been made in consideration of the above-described circumstances, and an objective of the present invention is to provide a curable resin composition making it possible to form a cured product having heat resistance suited for use in applications such as electronic components including printed circuit boards, semiconductor elements and light emitting diodes (LEDs), and automotive electronic components, and an electronic component, an optical component, and a composite member each having the cured product.

### [Solution to Problem]

Embodiments of the present invention that have been made to achieve the above-described objective include the following configurations.
[1] A curable resin composition containing: a silicon compound (A) that is formed from any one or more of silsesquioxane groups represented by formula (1) or (2) and from any one or more of siloxane groups represented by formulas (3)-(5), and that has a weight average molecular weight of 3,000-1,000,000; and a compound (B) that contains any one or more elements of Ce, La, Pr, Nd, Y and Fe.
   (R¹'s independently represent aryl having 6-20 carbon atoms, cycloalkyl having 5 or 6 carbon atoms, arylalkyl having 7-40 carbon atoms or alkyl having 1-40 carbon atoms, in the aryl having 6-20 carbon atoms, the cycloalkyl having 5 or 6 carbon atoms and the arylalkyl having 7-40 carbon atoms, an arbitrary hydrogen atom may be independently substituted with a fluorine atom or alkyl having 1-20 carbon atoms, in alkylene in the arylalkyl having 7-40 carbon atoms, an arbitrary hydrogen atom may be substituted with a fluorine atom, arbitrary -CH₂- may be independently substituted with -O-, -CH=CH- or cyclolalkylene having 5-20 carbon atoms, in the alkyl having 1-40 carbon atoms, an arbitrary hydrogen atom may be independently substituted with a fluorine atom, arbitrary -CH₂- may be independently substituted with -O- or cyclolalkylene having 5-20 carbon atoms;
   R²'s independently represent alkyl having 1-8 carbon atoms or aryl having 6-20 carbon atoms;
   R³ represents a hydroxyl group;
   R⁴'s independently represent a hydroxyl group, hydrogen, alkyl having 1-8 carbon atoms or aryl having 6-20 carbon atoms;
   R⁵'s represent a hydroxyl group, alkoxy having 1-8 carbon atoms, hydrogen, alkenyl having 2-40 carbon atoms, alkyl having 1-8 carbon atoms or aryl having 6-20 carbon atoms;
   a represents the following structure; 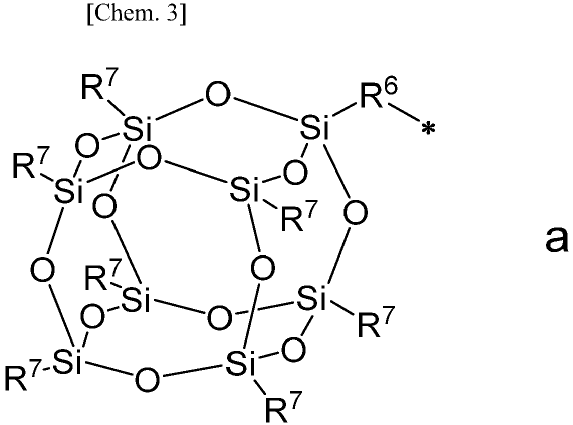
   R⁶'s each independently represent alkylene having 1-40 carbon atoms, in the alkylene having 1-40 carbon atoms, arbitrary -CH₂- may be independently substituted with -O- or cyclolalkylene having 5-20 carbon atoms;
   R⁷'s each independently represent aryl having 6-20 carbon atoms, cycloalkyl having 5-6 carbon atoms, arylalkyl having 7-40 carbon atoms or alkyl having 1-40 carbon atoms, in the aryl having 6-20 carbon atoms, the cycloalkyl having 5-6 carbon atoms and the arylalkyl having 7-40 carbon atoms, an arbitrary hydrogen atom may be independently substituted with a fluorine atom or alkyl having 1-20 carbon atoms, in alkylene in the arylalkyl having 7-40 carbon atoms, an arbitrary hydrogen atom may be substituted with a fluorine atom, arbitrary -CH₂- may be independently substituted with -O-, -CH=CH- or cyclolalkylene having 5-20 carbon atoms, in the alkyl having 1-40 carbon atoms, an arbitrary hydrogen atom may be independently substituted with a fluorine atom, and arbitrary -CH₂- may be independently substituted with -O- or cyclolalkylene having 5-20 carbon atoms. In the present specification, * in formulas represents a binding part, which will be true below.)
[2] The curable resin composition according to [1], in which the silicon compound (A) is formed from any one or more of the silsesquioxane groups represented by formula (1) or (2) and from any one or more of siloxane groups represented by formula (6) or (7), 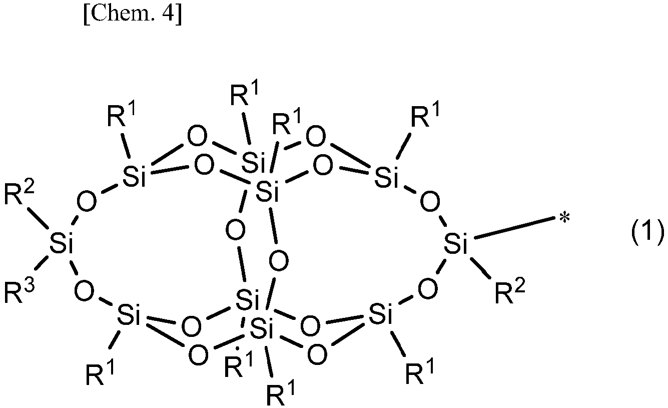 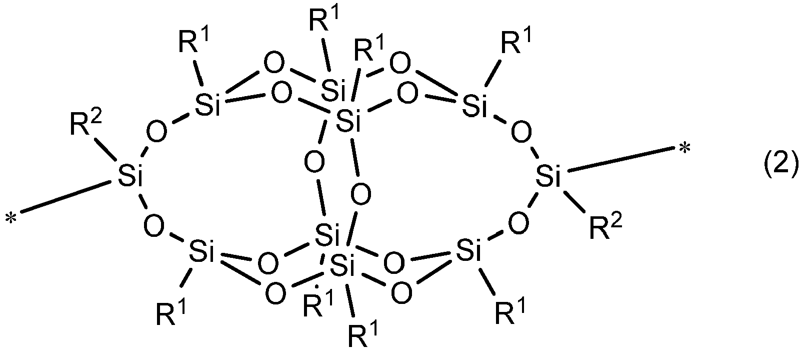 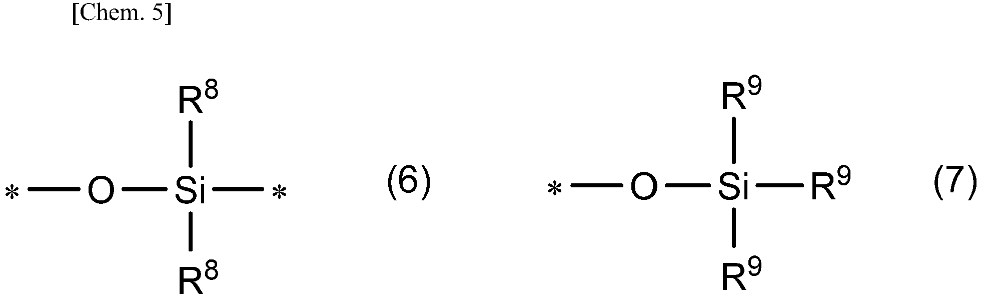
   (R⁸'s each independently represent a hydroxyl group, alkyl having 1-8 carbon atoms or a group represented by aryl having 6-20 carbon atoms;
   R⁹'s independently represent a hydroxyl group, alkoxy having 1-8 carbon atoms, alkyl having 1-8 carbon atoms or aryl having 6-20 carbon atoms, and, in formula (7), at least one R⁹ represents a hydroxyl group or alkoxy having 1-8 carbon atoms.)
[3] The curable resin composition according to any one of [1]-[2], in which the silicon compound (A) is a compound represented by formula (8). 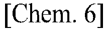 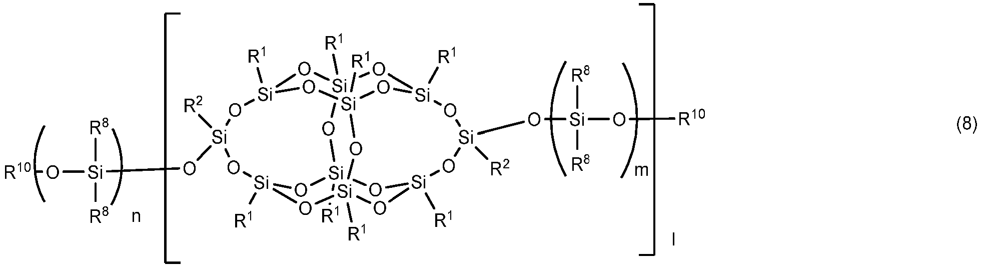 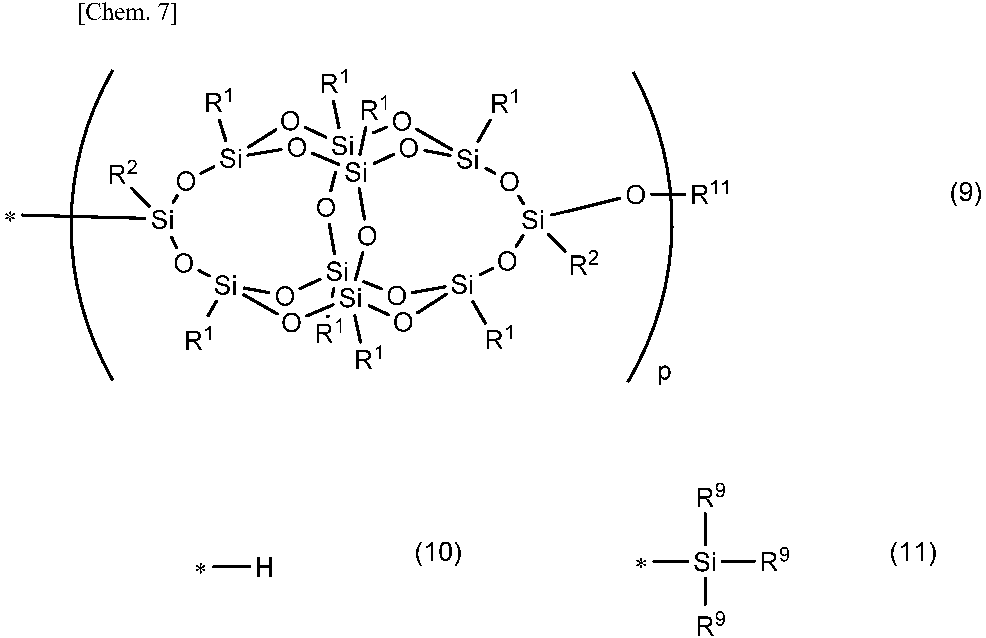
   (R¹ and R² represent groups defined as the same as R¹ and R² in the group represented by formula (1) in [1];
   R⁸ and R⁹ represent groups defined as the same as R⁸ and R⁹ in the groups represented by formulas (6) and (7) in [2], in a group represented by formula (11), at least one R⁹ represents a hydroxyl group or alkoxy having 1-8 carbon atoms;
   R¹⁰ represents a group represented by formula (9);
   R¹¹ represents a group represented by formula (10) or formula (11);
   n is an average value satisfying 1-30;
   m is a positive average value satisfying 0-30;
   1 is a numerical value satisfying a weight average molecular weight of 3,000-1,000,000; and
   p is 0 or 1.)
[4] The curable resin composition according to [2] or [3], further containing: a crosslinking agent (C) other than the silicon compound (A) having two or more crosslinkable groups that can be chemically bound to the silicon compound (A).
[5] The curable resin composition according to any one of [2]-[4], in which the crosslinkable group is a group of any of formulas (12)-(17) bound to Si. 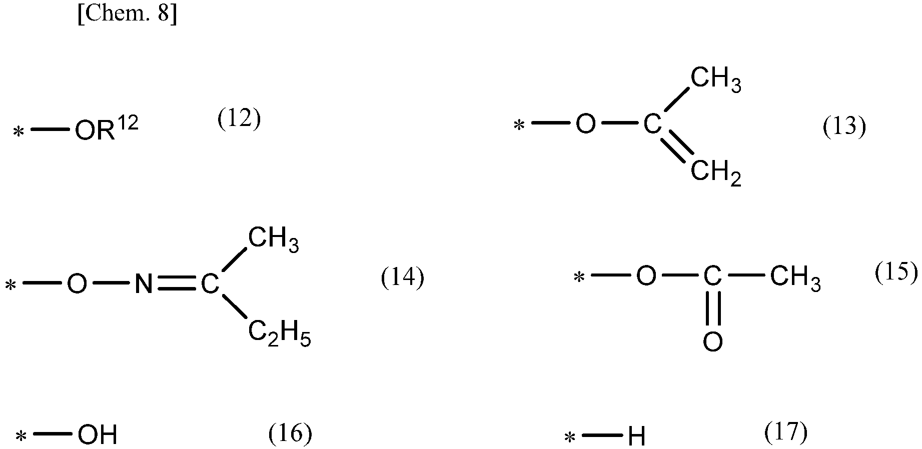 (R¹² represents alkyl having 1-8 carbon atoms.)
[6] The curable resin composition according to any one of [2]-[5], further containing: a catalyst (D).
[7] The curable resin composition according to any one of [2]-[6], in which the catalyst (D) has any one or more of Sn, Zr, Ti, Al, N and Pt.
[8] The curable resin composition according to [1], in which the silicon compound (A) is formed from any one or more of silsesquioxane groups represented by formula (1) or (2) and from at least one of siloxane groups represented by formulas (18)-(20). 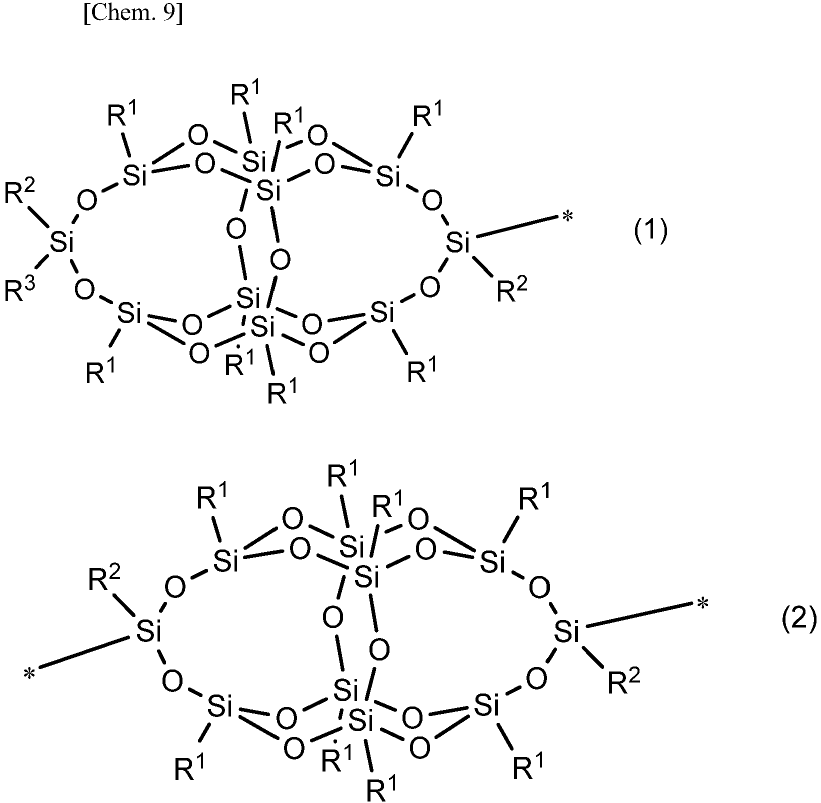 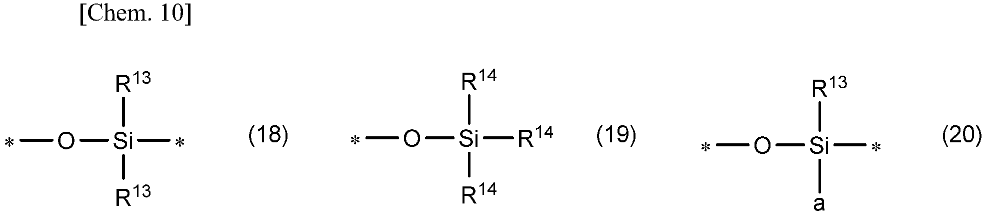
   (R¹³'s independently represent hydrogen, alkyl having 1-8 carbon atoms or aryl having 6-20 carbon atoms;
   R¹⁴'s independently represent hydrogen, a hydroxyl group, alkoxy having 1-8 carbon atoms, alkenyl having 2-40 carbon atoms, alkyl having 1-8 carbon atoms or aryl having 6-20 carbon atoms; and
   a represents the same group as a in [1].)
[9] The curable resin composition according to any one of [1] or [8], in which the silicon compound (A) is a compound represented by formula (21). 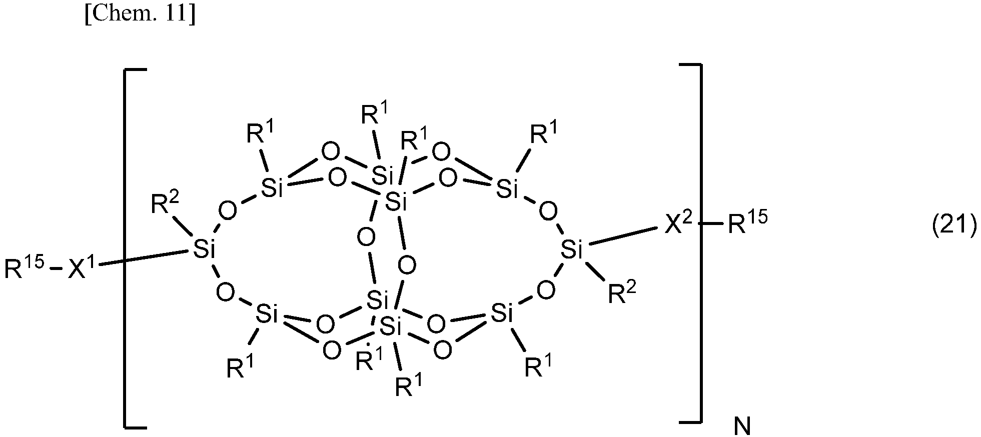 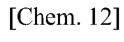 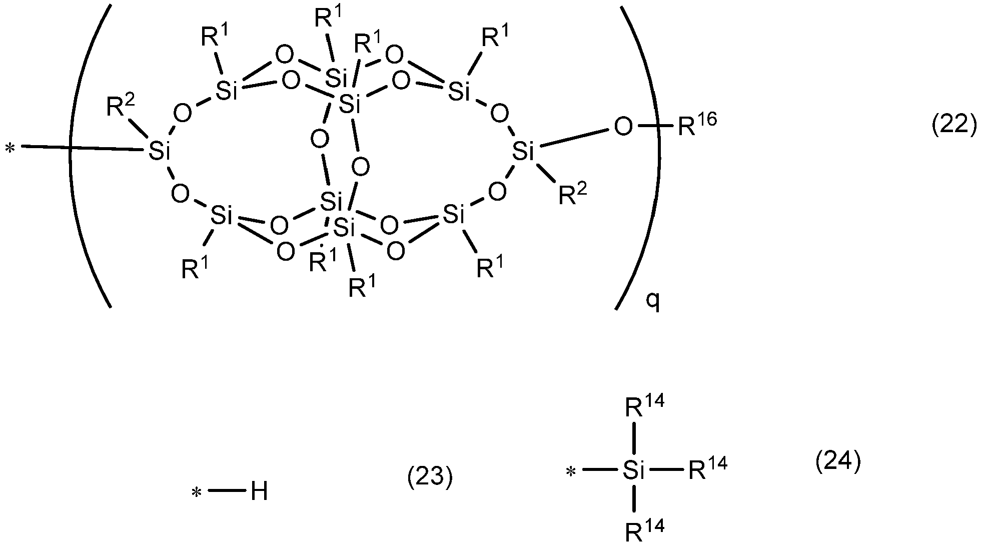
   (N is a value satisfying a weight average molecular weight of 3,000-1,000,000; and;
   R¹ and R² represent groups defined as the same as R¹ and R² in the group represented by formula (1) in [1];
   R¹⁵ represents a group represented by formula (22);
   R¹⁶ represents a group represented by formula (23) or formula (24);
   in the group represented by formula (24), R¹⁴ represents a group defined as the same as R¹⁴ in the group represented by formula (19);
   q is 0 or 1;
   X¹ and X² independently represent at least one selected from repeating units represented by formulas (25)-(30); 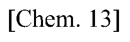 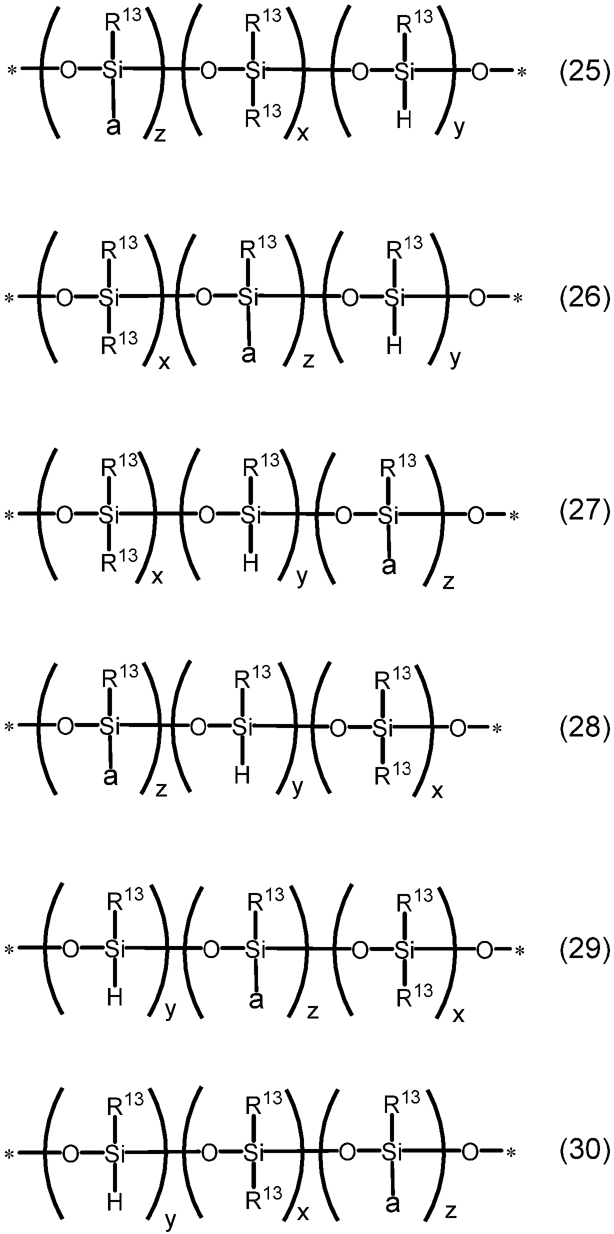
   a represents a group defined as the same as a in [1];
   R¹³ represents a group defined as the same as R¹³ in the group represented by formula (18) in [8];
   x and z are average values satisfying 0-30, and y is a positive average value satisfying 1-30.)
[10] The curable resin composition according to [8] or [9], further containing: a crosslinking agent (C) other than the silicon compound (A) having two or more crosslinkable groups that can be chemically bound to the silicon compound (A).
[11] The curable resin composition according to any one of [8]-[10], in which the crosslinkable group is a group of any of formulas (12)-(17) or (31) bound to Si. 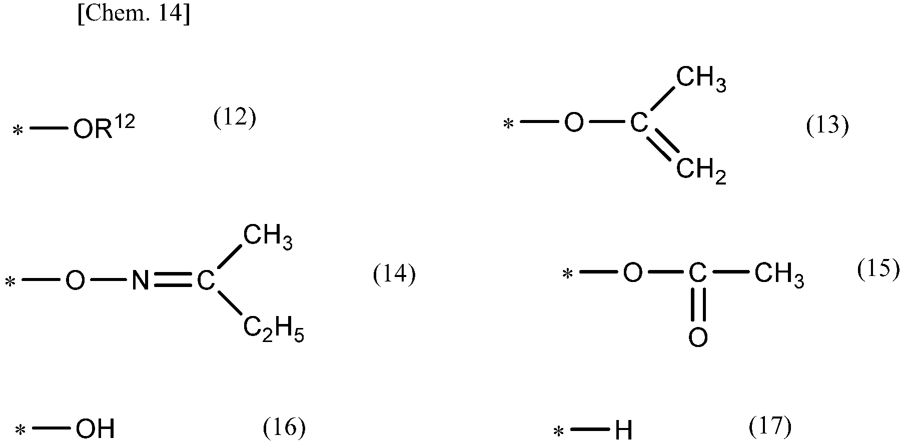 (R¹² represents alkyl having 1-8 carbon atoms.)
[12] The curable resin composition according to any one of [8]-[11], further containing: a catalyst (D).
[13] The curable resin composition according to any one of [8]-[12], in which the catalyst (D) has any one or more of Sn, Zr, Ti, Al, N and Pt.
[14] A cured product formed by curing the curable resin composition according to any one of [1]-[13].
[15] An electronic component having the cured product according to [14].
[16] An optical component having the cured product according to [14].
[17] A composite member including a first member and a resin-containing member in contact with the first member and configuring a part of an electrical element, in which the resin-containing member contains the cured product according to [14].
[18] The composite member according to [17], in which the resin-containing member is a protective film that coats at least a part of the first member.
[19] The composite member according to [18], in which the first member is a wiring board including a wiring in a parent material, and the protective film has insulating properties and coats the wiring.
[20] The composite member according to [17], further including a second member in contact with the resin-containing member.

### [Advantageous Effects of Invention]

According to the present invention, it is possible to provide a curable resin composition making it possible to obtain a cured product having heat resistance suited for use in applications of electronic components and the like, and it is possible to provide a cured product that is obtained from the curable resin composition, an electronic component, an optical component, and a composite member each having the cured product.

### [Description of Embodiments]

Hereinafter, a curable resin composition, a cured product, an electronic component, an optical component, and a composite member according to one embodiment of the present invention will be described in detail.

### <Curable resin composition>

A curable resin composition of the present invention contains a silicon compound (A) and a compound (B) containing any one or more elements of Ce, La, Pr, Nd, Y and Fe. In addition, the curable resin composition may arbitrarily contain a crosslinking agent (C) other than the silicon compound (A) having two or more crosslinkable groups that can be chemically bound to the silicon compound (A), a catalyst (D), other organopolisiloxane other than the silicon compound (A) and the crosslinking agent (C), and a different component such as a curing retarder, an adhesion agent, a filler, an ion scavenger, a surfactant, a flame retardant, an ultraviolet absorber, a light stabilizer, an antioxidant or a solvent.

The curable resin composition of the present invention may be colorless or colored and may be transparent or non-transparent. In addition, the curable resin composition of the present invention may be produced by preparing and mixing each component such as a two-liquid type component or a three-liquid type component. Furthermore, each component of (A)-(D) and the different component can be used singly or two or more thereof can be mixed together and used. Hereinafter, each component configuring the curable resin composition of the present invention will be described in detail.

### <Silicon compound (A)>

The curable resin composition of the present invention contains a silicon compound (A) that is formed from either one or both of the silsesquioxane groups represented by formula (1) or (2) and from any one or more structural units among the siloxane groups represented by formulas (3)-(5), and that has a weight average molecular weight of 3,000-1,000,000.

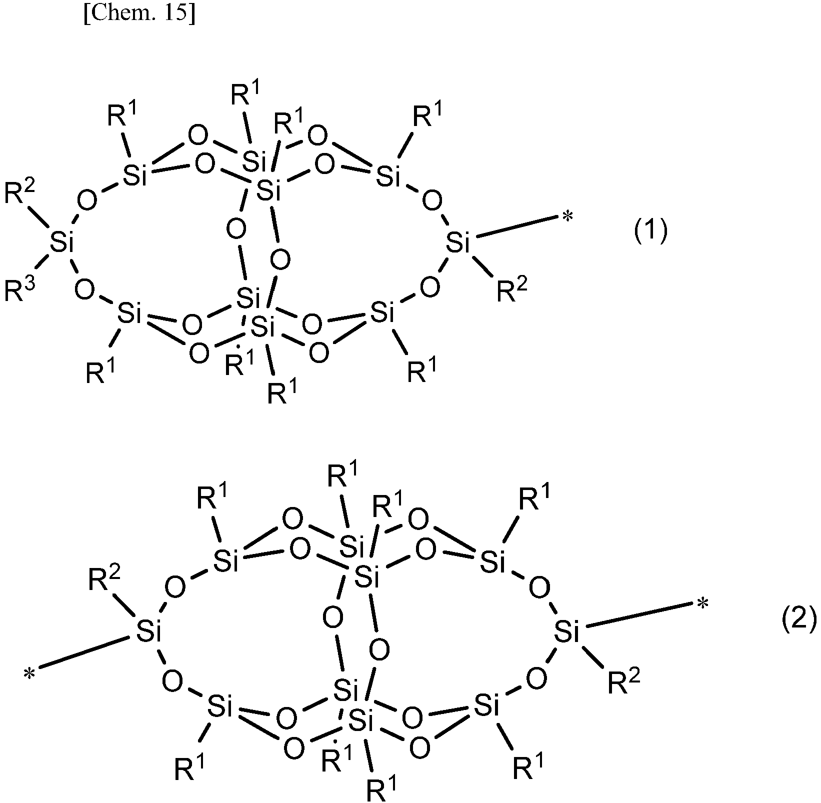

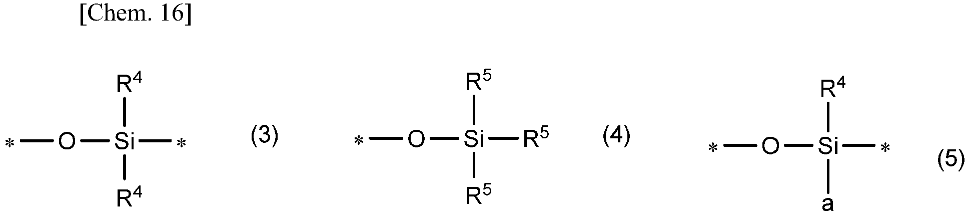

In formula (1) and formula (2), R¹'s each independently represent aryl having 6-20 carbon atoms, cycloalkyl having 5 or 6 carbon atoms, arylalkyl having 7-40 carbon atoms or alkyl having 1-40 carbon atoms, in the aryl having 6-20 carbon atoms, the cycloalkyl having 5 or 6 carbon atoms and the arylalkyl having 7-40 carbon atoms, an arbitrary hydrogen atom may be independently substituted with a fluorine atom or alkyl having 1-20 carbon atoms, in alkylene in the arylalkyl having 7-40 carbon atoms, an arbitrary hydrogen atom may be substituted with a fluorine atom, arbitrary -CH₂- may be independently substituted with -O-, -CH=CH- or cyclolalkylene having 5-20 carbon atoms, in the alkyl having 1-40 carbon atoms, an arbitrary hydrogen atom may be independently substituted with a fluorine atom, arbitrary -CH₂- may be independently substituted with -O- or cyclolalkylene having 5-20 carbon atoms, methyl, ethyl, isopropyl, isobutyl, phenyl or cyclohexyl is preferable and methyl, phenyl or cyclohexyl is more preferable due to easy production.

R²'s independently represent groups represented by alkyl having 1-8 carbon atoms or aryl having 6-20 carbon atoms, and methyl or phenyl is preferable.

R³ in formula (1) represents a hydroxyl group, R⁴'s in formulas (3)-(5) independently represent a hydroxyl group, hydrogen, alkoxy having 1-8 carbon atoms or aryl having 6-20 carbon atoms, R⁵'s represent a hydroxyl group, alkoxy having 1-8 carbon atoms, hydrogen, alkenyl having 2-40 carbon atoms, alkyl having 1-8 carbon atoms or aryl having 6-20 carbon atoms, and a represents the following structure.

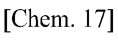

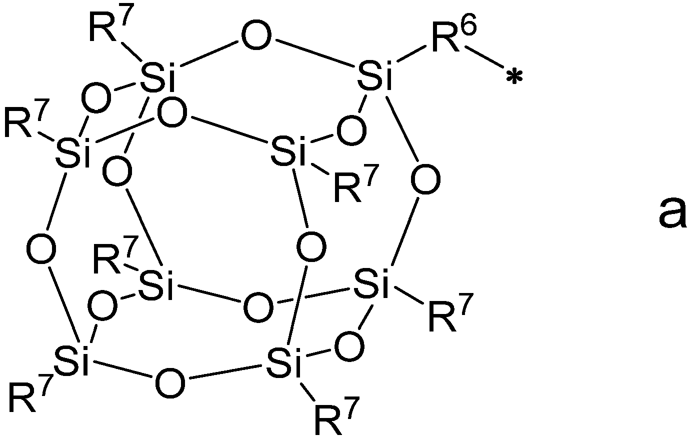

R⁶'s each independently represent alkylene having 1-40 carbon atoms, in the alkylene having 1-40 carbon atoms, arbitrary -CH₂- may be independently substituted with -O- or cyclolalkylene having 5-20 carbon atoms, alkylene having 1-20 carbon atoms is preferable, and alkylene having 1-15 carbon atoms is more preferable.

R⁷'s each independently represent aryl having 6-20 carbon atoms, cycloalkyl having 5-6 carbon atoms, arylalkyl having 7-40 carbon atoms or alkyl having 1-40 carbon atoms, in the aryl having 6-20 carbon atoms, the cycloalkyl having 5-6 carbon atoms and the arylalkyl having 7-40 carbon atoms, an arbitrary hydrogen atom may be independently substituted with a fluorine atom or alkyl having 1-20 carbon atoms, in alkylene in the arylalkyl having 7-40 carbon atoms, an arbitrary hydrogen atom may be substituted with a fluorine atom, arbitrary -CH₂- may be independently substituted with -O-, -CH=CH- or cyclolalkylene having 5-20 carbon atoms, in the alkyl having 1-40 carbon atoms, an arbitrary hydrogen atom may be independently substituted with a fluorine atom, arbitrary -CH₂- may be independently substituted with -O- or cyclolalkylene having 5-20 carbon atoms, -CH₂CH₂CF₃, phenyl, cyclohexyl, isobutyl, nonafluorohexyl, and pentafluorophenyl are preferable due to easy production. As described above, * in formulas represents a binding part.

In formulas (1)-(5), the hydroxyl group, the alkoxy, the hydrogen, and the alkenyl as R³ to R⁵ are crosslinkable functional groups bound to Si in the silicon compound (A) and can be bound to the silicon compounds (A) or a different compound such as a crosslinking agent (C) to be described below. The crosslinkable functional groups may be all the same as each other or different from each other in one silicon compound (A).

Examples of the silicon compound (A) include compounds that are formed from silsesquioxane groups having the crosslinkable functional group and from siloxane groups represented by formulas (3)-(5) not having the crosslinkable functional group, compounds that are formed from silsesquioxane groups not having the crosslinkable functional group and from siloxane groups represented by formulas (3)-(5) having the crosslinkable functional group, and compounds that are formed from silsesquioxane groups having the crosslinkable functional group and from siloxane groups represented by formulas (3)-(5) having the crosslinkable functional group.

Examples of the siloxane groups represented by formulas (3)-(5) having the crosslinkable functional group include groups that are formed from siloxane groups that are formed from formula (3) having the crosslinkable functional group and from formula (4) and formula (5) not having the crosslinkable functional group, siloxane groups that are formed from formula (3) and formula (5) not having the crosslinkable functional group and from formula (4) having the crosslinkable functional group, siloxane groups that are formed from formula (4) and formula (5) not having the crosslinkable functional group and from formula (3) having the crosslinkable functional group, siloxane groups that are formed from formula (3) having the crosslinkable functional group and from formula (4) and formula (5) having the crosslinkable functional group, and the like.

The silicon compound (A) may further have silsesquioxane groups represented by formula (1) and formula (2) and a different structural unit other than the siloxane groups represented by formulas (3)-(5). However, the different structural unit preferably does not include the crosslinkable functional group. The content proportion of the silsesquioxane groups represented by formula (1) and formula (2) and the different structural unit other than the siloxane groups represented by formulas (3)-(5) is preferably 30 mol% or less and more preferably 20 mol% or less.

The molecular weight of the silicon compound (A) is preferably 3,000-700,000, more preferably 3,000-600,000 in terms of the weight average molecular weight. The molecular weight is still more preferably 3,000-500,000 since the viscosity of the curable resin composition does not increase too much.

### <Silicon compound (A) not containing hydrogen bound to Si other than terminal Si as crosslinkable functional group>

More specific examples thereof include silicon compounds that are formed from either one or both of the silsesquioxane groups represented by formula (1) or (2) and from either one or both of structural units of siloxane groups represented by formula (6) or (7), and that has a weight average molecular weight of 3,000-1,000,000.

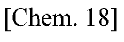

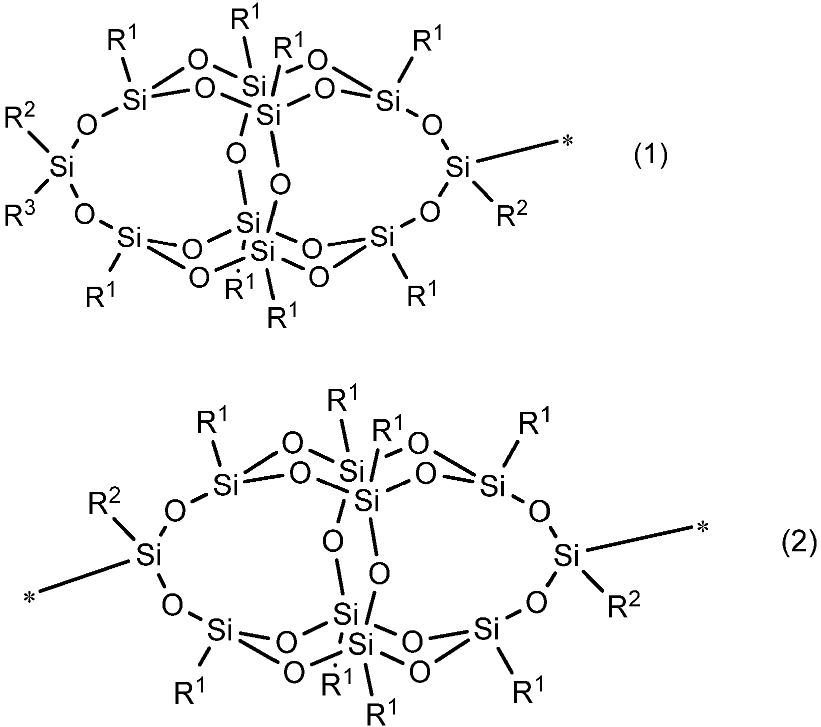

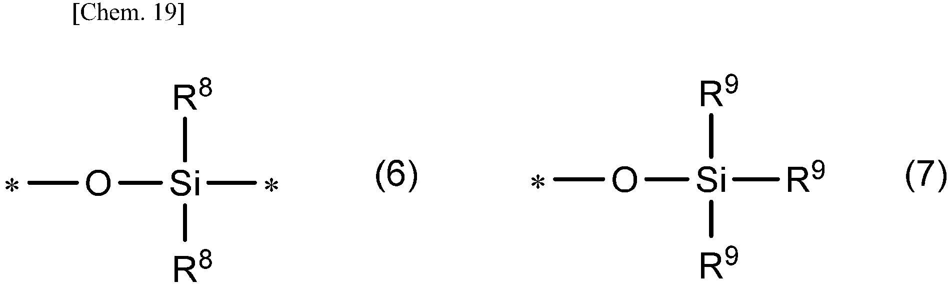

In formula (6), R⁸'s independently represent a hydroxyl group, alkyl having 1-8 carbon atoms or a group represented by aryl having 6-20 carbon atoms, in formula (7), R⁹'s independently represent a hydroxyl group, alkoxy having 1-8 carbon atoms, alkyl having 1-8 carbon atoms or aryl having 6-20 carbon atoms, and, in formula (7), at least one R⁹ represents a hydroxyl group or alkoxy having 1-8 carbon atoms.

Still more specific examples include compounds represented by formula (8).

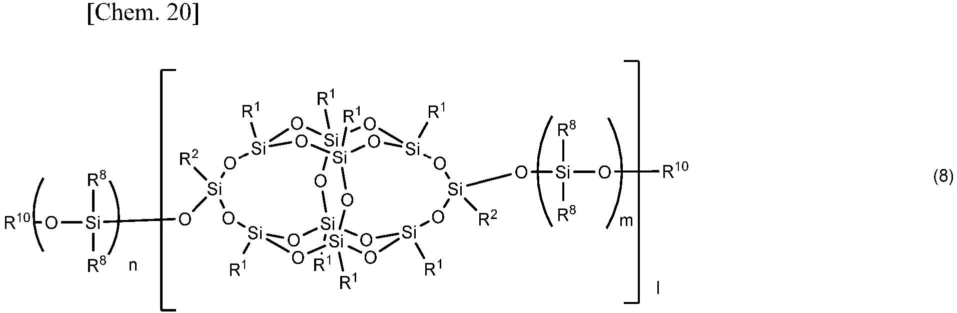

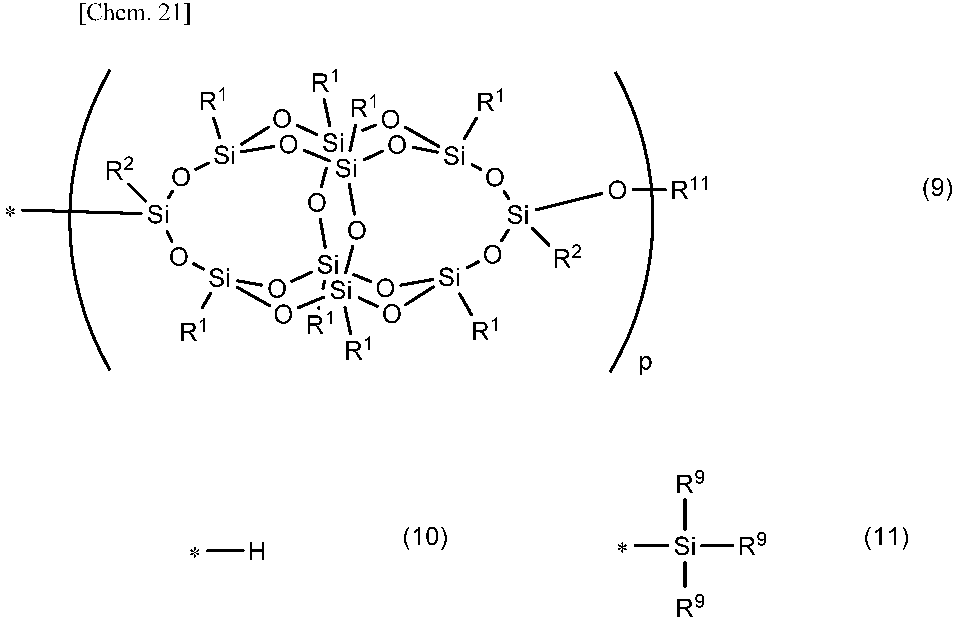

R¹ and R² in formula (8) represent the same groups as R¹ and R² in formula (1), R⁸ is the same group as R⁸ in formula (6), and R¹⁰ represents a group represented by formula (9). R¹¹ in formula (9) represents a group represented by formula (10) or formula (11), R⁹ in formula (11) represents the same group as R⁹ in formula (7), n is an average value satisfying 1-30, m is a positive average value satisfying 0-30, 1 is a numerical value satisfying a weight average molecular weight of 3,000-1,000,000, and p is 0 or 1.

R⁸ is preferably methyl, phenyl or a hydroxyl group from the viewpoint of the easy procurement of a raw material, and, in a case where R⁸ is a hydroxyl group, the hydroxyl group is more preferably 50 mol% or less with respect to the total mole number of all R⁸'s in formula (8) from the viewpoint of the toughness of a cured product.

In formula (11), at least one R⁹ represents a hydroxyl group or alkoxy having 1-8 carbon atoms, but is preferably a hydroxyl group from the viewpoint of the reactivity.

A cured product of the curable resin composition containing the silicon compound represented by formula (8) has an excellent balance between heat resistance and flexibility, and the characteristics of the silicon compound (A) can be controlled with the proportions of the silsesquioxane group represented by formula (1) or (2) and the siloxane group represented by formula (6) or (7). In formula (8), the proportion (α) of the siloxane group with respect to the silsesquioxane group becomes (n + ml)/(l + 2p), (n + ml + 1)/(l + 2p) or (n + ml + 2)/(l + 2p) depending on the number of formulas (11) that is contained in R¹⁰ in Formula (8), and, as the proportion (α) of the siloxane group with respect to the silsesquioxane group becomes smaller, the cured product tends to be stronger and more highly heat-resistant, and, as the proportion becomes larger, the cured product tends to be more flexible, and α is preferably 1-20 from the viewpoint of the comprehensive balance.

The molecular weight of the silicon compound represented by formula (8) is preferably 3,000-700,000, more preferably 3,000-600,000 and still more preferably 3,000-500,000 in terms of the weight average molecular weight since the viscosity of the curable resin composition does not increase too much.

### <Method for producing silicon compound not having hydrogen bound to Si other than terminal Si and hydroxyl group as crosslinkable functional group>

In a case where R⁸ does not contain a hydroxyl group in the silicon compound represented by formula (8), the silicon compound can be obtained by performing equilibrium polymerization of either one or both of a compound represented by formula (A-2) and a compound represented by formula (A-3) into a compound represented by formula (A-1) in the presence of a catalyst. Specific examples of the production method include methods described in Japanese Patent Laid-Open No. 2010-116464 and Japanese Patent Laid-Open No. 2020-90572.

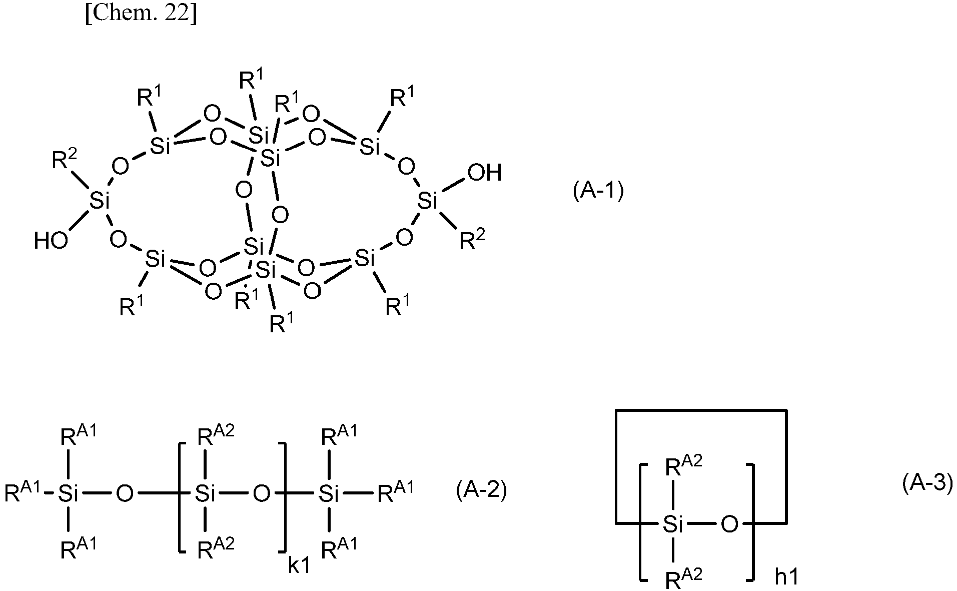

In formula (A-1), R¹ and R² are the same groups as R¹ and R² in formula (8).

In formula (A-2), k1 represents an integer of 0-30, R^{A1}'s independently represent a hydroxyl group, alkoxy having 1-8 carbon atoms, alkyl having 1-8 carbon atoms or aryl having 6-20 carbon atoms, and, in formula (A-2), at least one R^{A1} represents a hydroxyl group or alkoxy having 1-8 carbon atoms. R^{A2} is alkyl having 1-8 carbon atoms or aryl having 6-20 carbon atoms.

k1 in formula (A-2) is preferably 0-9, more preferably 0-5 and still more preferably 1-3 from the viewpoint of easy procurement as a compound.

h1 in formula (A-3) represents 3-6, and R^{2A} is the same group as R^{2A} in formula (A-2). H1 in formula (A-3) is preferably 3 or 4 from the viewpoint of the easy procurement of the compound.

Each of the compounds represented by formula (A-1), formula (A-2), and formula (A-3) may be used singly or two or more thereof may be used. The ratio between the compound represented by formula (A-1) and the compound represented by formula (A-2) and formula (A-3) used can be set as appropriate depending on the degree of polymerization of each structural unit in the silicon compound, which is a target substance or the like.

The catalyst that is used in the method is preferably an acid catalyst. Examples of the acid catalyst include cation exchange resins as acid catalysts such as hydrochloric acid, sulfuric acid, fluorosulfuric acid, methanesulfonic acid, trifluoromethanesulfonic acid, activated clay, a sulfonic acid-based ion exchange resin, and the like. Among these, hydrochloric acid, methanesulfonic acid, trifluoromethanesulfonic acid, activated clay, and cation exchange resins are preferable.

### <Method for producing silicon compound containing hydroxyl group bound to Si other than terminal Si but not containing hydrogen as crosslinkable functional group>

In a case where R⁸ contains a hydroxyl group in the silicon compound represented by formula (8), the silicon compound can be obtained by, for example, preparing formula (A-4) having hydrogen bound to Si in a side chain and converting the hydrogen into a hydroxy group in the presence of a transition metal catalyst.

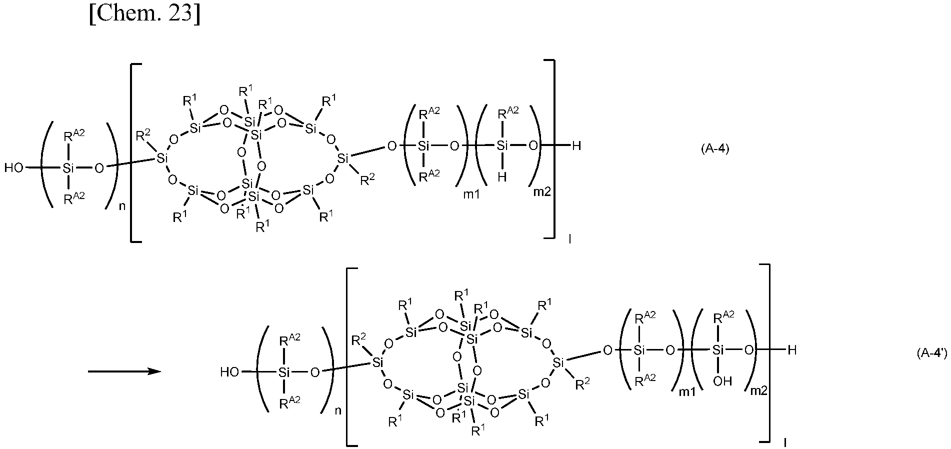

In formulas (A-4) and (A-4'), R^{A2} is the same as R^{A2} in formula (A-2), R¹, R², n, and 1 are the same as R¹, R², n, and 1 in formula (8), and m1 and m2 are positive average values satisfying m1 + 2 = 0-30.

A method for producing a compound represented by formula (A-4) is not particularly limited, and the compound can be obtained by, for example, performing equilibrium polymerization of either one or both of a compound represented by formula (A-7) and the compound represented by formula (A-3) and either one or both of a compound represented by formula (A-5) and a compound represented by formula (A-6) into the compound represented by formula (A-1) in the presence of a catalyst. Specific examples thereof include the method described in Japanese Patent Laid-Open No. 2010-116464.

In the production method, a solvent such as tetrahydrofuran, toluene or ethyl acetate may be used. A reaction is preferably performed in the presence of an acid catalyst such as sulfuric acid. The reaction is preferably performed in an inert gas atmosphere such as nitrogen (N₂). In addition, the reaction is preferably performed under stirring.

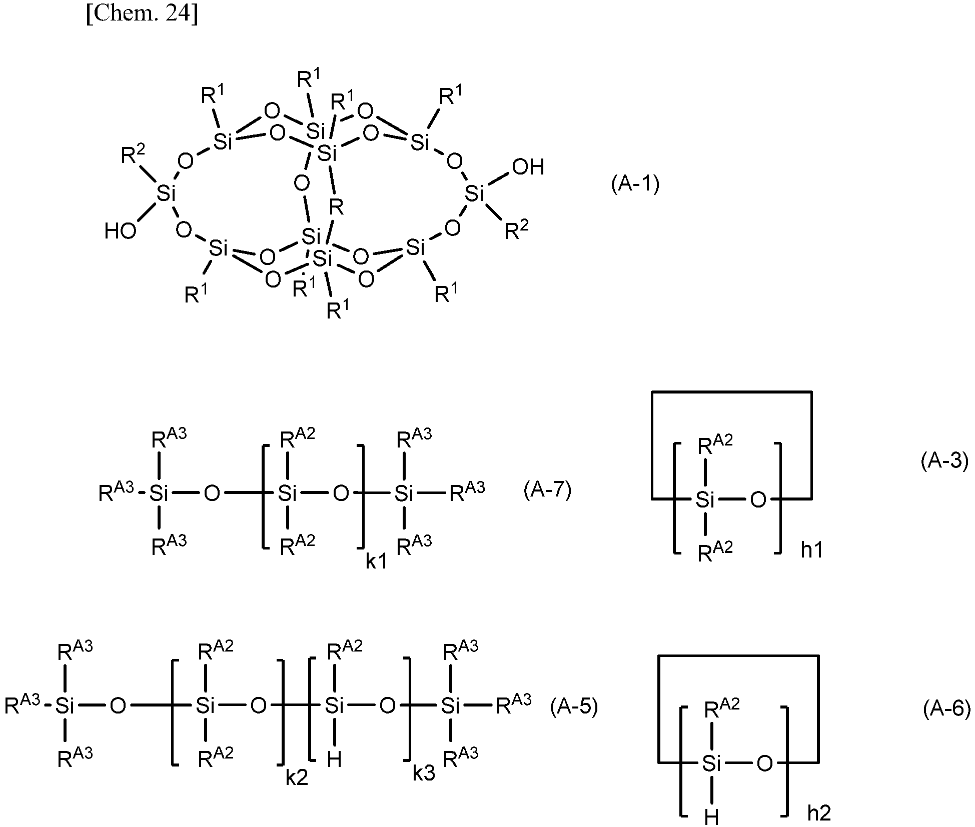

In formulas (A-5) and (A-7), R^{A3}'s independently represent hydrogen, a hydroxyl group, alkoxy having 1-8 carbon atoms, alkyl having 1-8 carbon atoms or aryl having 6-20 carbon atoms, in each of formulas (A-5) and (A-7), at least one R^{A3} represents a hydroxyl group or alkoxy having 1-8 carbon atoms, R^{A2} is the same group as R^{A2} in formula (A-2), and k1, k2 and k3 independently represent an integer of 0-30.

In formula (A-6), R^{A2} is the same group as R^{A2} in formula (A-2), and h2 represents an integer of 3-6.

Subsequently, a step of converting all hydrogen bound to Si in the silicon compound having a repeating unit represented by formula (A-4) into a hydroxyl group is performed, whereby a silicon compound having a repeating unit represented by formula (A-4') containing a hydroxyl group bound to Si can be obtained.

In this step, hydrogen bound to Si of the silicon compound having the repeating unit represented by formula (A-4) is converted into a hydroxyl group, for example, as described below. The silicon compound having the repeating unit represented by formula (A-4) containing hydrogen bound to Si is dissolved in a solvent, and the solution is added dropwise to a mixed liquid of a solvent, water, and a transition metal catalyst under stirring. After the end of the generation of hydrogen, a reaction liquid is aged. After that, the transition metal catalyst is removed using a filter aid or the like, then, an organic solvent such as ethyl acetate is added thereto, the liquid is separated, and an organic layer is dried with sodium sulfate. Next, sodium sulfate is removed, the solution is vacuum-concentrated and then re-precipitated with heptane or the like, and the obtained precipitate is vacuum-dried, thereby acquiring a target substance.

Examples of the transition metal catalyst include a palladium catalyst, a platinum catalyst, a rhodium catalyst, a ruthenium catalyst, a copper catalyst, and a rhenium catalyst, and a palladium catalyst is preferable. Examples of the palladium catalyst include a palladium hydroxide/carbon catalyst and a palladium/carbon catalyst, and the palladium hydroxide/carbon catalyst is preferable from the viewpoint of the reaction efficiency. The amount of the catalyst is not particularly limited, but is preferably 1-30 mol% with respect to the matrix from the viewpoint of the reactivity and the yield.

The reaction solvent that is used in the present step is not particularly limited as long as the reaction solvent is a solvent that does not get involved in the reaction, and examples thereof include aromatic hydrocarbon-based solvents such as toluene and xylene; ester-based solvents such as methyl acetate and ethyl acetate; ether-based solvents such as tetrahydrofuran, diethyl ether, and cyclopentyl methyl ether. Among these, solvents that are miscible with water are preferable, and, in particular, tetrahydrofuran is preferable. The amount of the solvent used is not particularly limited, but the solvent is preferably used so that the solid content concentration (solid content concentration = 100 × the weight of components other than the solvent/the weight of the entire reaction liquid) reaches 1 wt% or more and 50 wt% or less from the viewpoint of the reactivity and the workability.

The amount of water added is not particularly limited, but 1 wt%-15 wt% of water is preferably added to the solvent from the viewpoint with miscibility with the solvent.

The reaction time is not particularly limited; however, when the reaction time is too long, there are cases where the hydroxyl groups bound to Si are condensed together or an exchange reaction between hydrogen and the hydroxyl group may be caused due to hydrogen bound to Si and the hydroxyl group bound to Si. Therefore, the reaction time is preferably 15 minutes or longer and 24 hours or shorter from the viewpoint of securing the yield or preventing an increase in the molecular weight or the like.

The reaction temperature is not particularly limited, but is preferably 1°C or higher and more preferably 5°C or higher and preferably 50°C or lower and more preferably 40°C or lower.

As the present step, specifically, for example, the silicon compound having the repeating unit represented by formula (A-4) containing hydrogen bound to Si is stirred in a mixed solvent of tetrahydrofuran and water using the palladium hydroxide/carbon catalyst in the inert gas atmosphere, whereby all hydrogen bound to Si is converted to a hydroxyl group, and a silicon compound having the repeating unit represented by formula (A-4') can be obtained.

### <Silicon compound (A) containing hydrogen bound to Si other than terminal Si as crosslinkable functional group>

Examples of another silicon compound (A) include silicon compounds that are formed from either one or both of silsesquioxane groups represented by formula (1) or (2) and from at least one structural unit among siloxane groups represented by formulas (18)-(20) and that have a weight average molecular weight of 3,000-1,000,000.

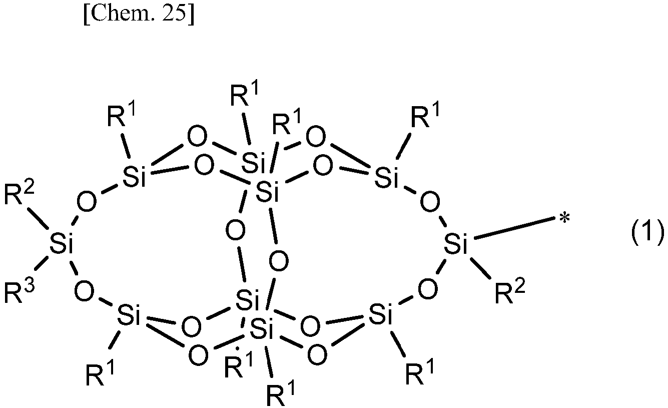

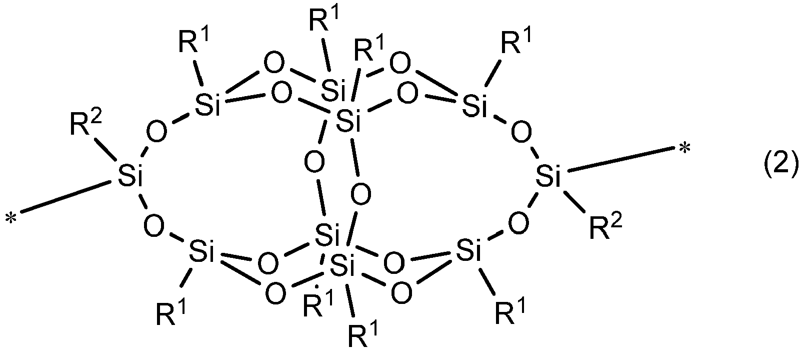

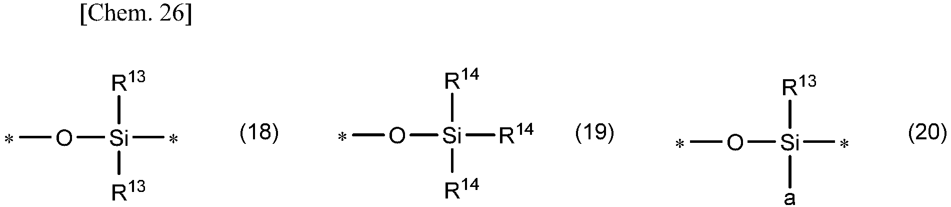

In formulas (18) and (20), R¹³'s independently represent hydrogen, alkyl having 1-8 carbon atoms or aryl having 6-20 carbon atoms, R¹⁴'s independently represent hydrogen, a hydroxyl group, alkoxy having 1-8 carbon atoms, alkenyl having 2-40 carbon atoms, alkyl having 1-8 carbon atoms or aryl having 6-20 carbon atoms, and a is the same group as a described in the section <silicon compound (A)>.

More specific examples thereof include compounds represented by formula (21).

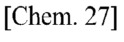

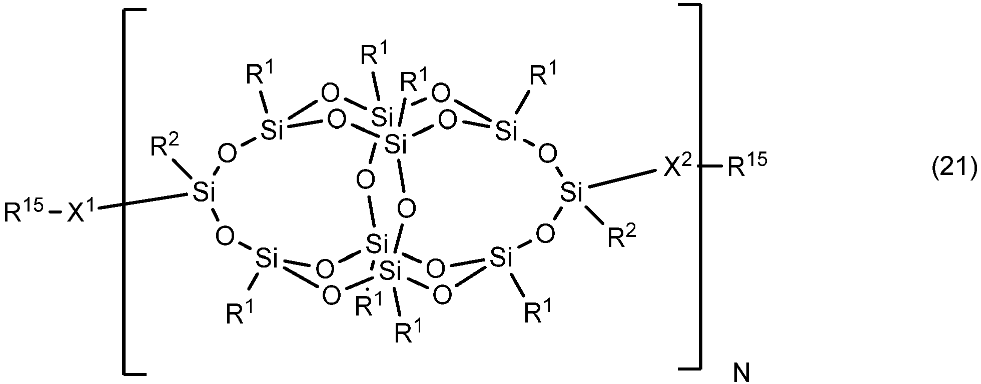

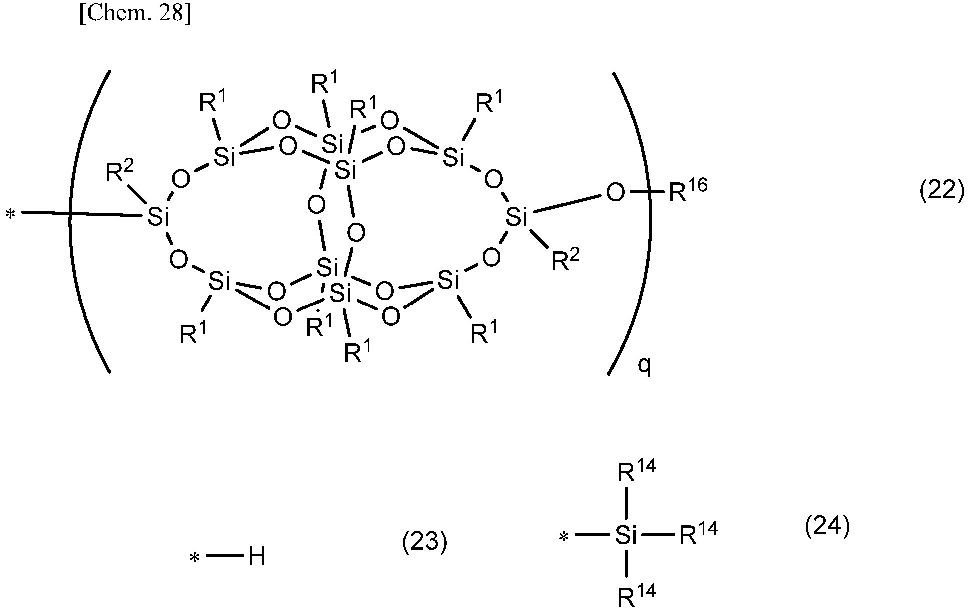

In formula (21), N is a numerical value satisfying a weight average molecular weight of 3,000-1,000,000, R¹ and R² are the same as R¹ and R² in formula (1), R¹⁵ represents formula (22), R¹⁶ represents formula (23) or formula (24), in formula (24), R¹⁴ is the same as R¹⁴ in formula (19), q is 0 or 1, X¹ and X² independently have at least one selected from repeating units represented by formulas (25)-(30);

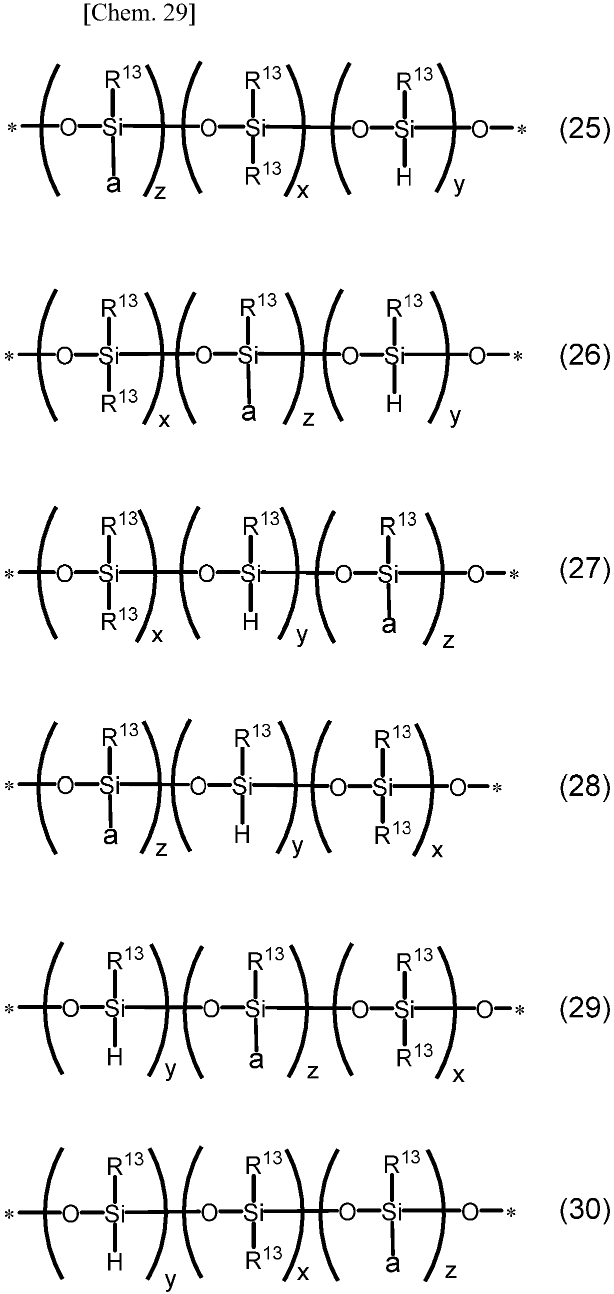

In formulas (25)-(30), a represents the same group as a described in the section <silicon compound (A)>, R¹³ represents the same group as formula (18), x and z are average values satisfying 0-30, and y is a positive average value satisfying 1-30.

A strong cured product can be obtained from the curable resin composition containing the silicon compound represented by formula (21), and the characteristics of the silicon compound (A) can be controlled with the proportions of the silsesquioxane group represented by formula (1) or (2) and the siloxane group represented by formulas (18)-(20). Atypical formula of the proportion (β) of the siloxane group with respect to the silsesquioxane group in formula (21) becomes {(x1' + y1' + z1') + N(x1 + y1 + z1)}/(N + 2q), {(x1' + y1' + z1') + N(x1 + y1 + z1) + 1}/(N + 2q) or {(x1' + y1' + z1') + N(x1 + y1 + z1) + 2}/(N + 2q) depending on the number of formulas (24) that is contained in R¹⁵ in Formula (21) when x, y, and z in X¹ and X² in formula (21) are each replaced with x1' and x1, y1' and y1, and z1' and z1. As the proportion (β) of the siloxane group with respect to the silsesquioxane group becomes smaller, the cured product tends to be more flexible and more highly heat-resistant, and, as the proportion becomes larger, the cured product tends to be stronger, and β is preferably 1-20 from the viewpoint of the comprehensive balance.

The molecular weight of the silicon compound represented by formula (21) is preferably 3,000-700,000, more preferably 3,000-600,000 and still more preferably 3,000-500,000 in terms of the weight average molecular weight since the viscosity of the curable resin composition does not increase too much.

### <Method for producing silicon compound not having a in silicon compound (A) having hydrogen bound to Si other than terminal Si as crosslinkable functional group>

Many examples of a method for producing a silicon compound (A) not having a in formula (21), that is, z1 = z1' = 0 are known, and the silicon compound can be obtained by, for example, performing the equilibrium polymerization of ether one or both of formula (A-3) and formula (A-9) and ether one or both of formula (A-6) and formula (A-8) into formula (A-1) in the presence of a catalyst. Specific examples thereof include the method described in Japanese Patent Laid-Open No. 2010-116464.

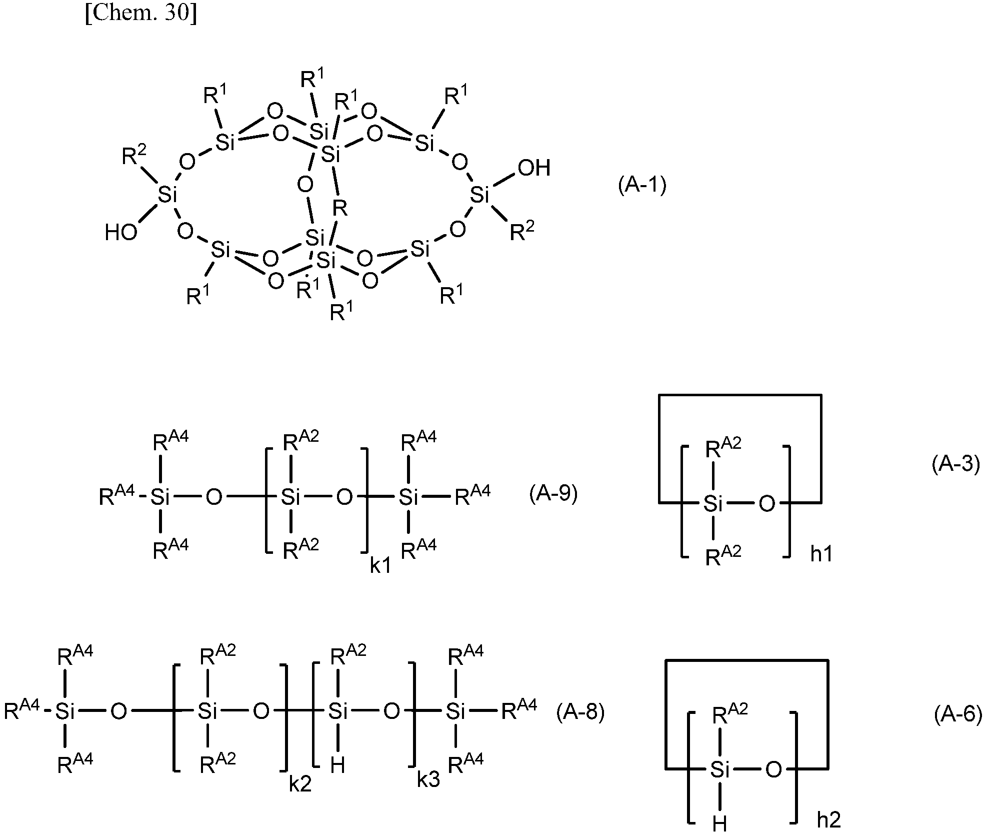

Formulas (A-1), (A-3), and (A-6) are the same as the compounds described in the section <method for producing silicon compound containing hydroxyl group bound to Si other than terminal Si but not containing hydrogen as crosslinkable functional group>, R^{A2} in formulas (A-8) and (A-9) is the same as R^{A2} in formula (A-3), R^{A4}'s independently represent hydrogen, a hydroxyl group, alkoxy having 1-8 carbon atoms, alkenyl having 2-40 carbon atoms, alkyl having 1-8 carbon atoms or aryl having 6-20 carbon atoms, in each of formulas (A-8) and (A-9), at least one R^{A4} has a hydroxyl group or alkoxy having 1-8 carbon atoms, and k¹, k² and k³ are integers of 0-30.

### <Method for producing silicon compound having a in silicon compound (A) having hydrogen bound to Si other than terminal Si as crosslinkable functional group>

In the case of having a, that is, at least one of z1 or z1' being larger than 0, a silicon compound can be produced by performing an addition reaction, elimination reaction or substitution reaction of a compound corresponding to the structure of a (POSS) on hydrogen bound to Si in the silicon compound produced in the section <method for producing silicon compound not having a in silicon compound (A) having hydrogen bound to Si other than terminal Si as crosslinkable functional group>.

For example, the silicon compound can be produced by introducing a compound corresponding to a side chain a (POSS) into a silicon compound represented by formula (A-10) by an addition reaction as shown in the following reaction formula.

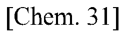

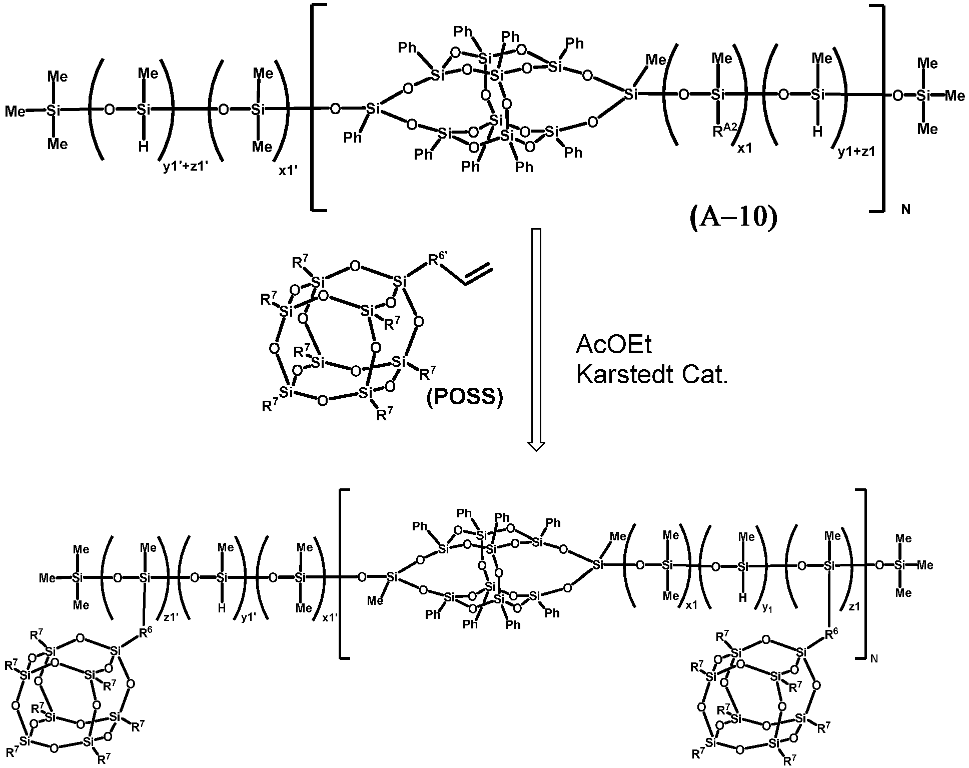

In formula (A-10), x1, z1, x1', and z1' represent positive average values of 0-30, and y1 and y1' are positive average values of 1-30.

The compound (POSS) corresponds to the side chain a, and, in this example, a double bond of (POSS) addition-reacts with some of hydrogen bound to Si in formula (A-10). In this example, the structure of R⁶' of the compound (POSS) turns into a structure in which two carbon atoms have decreased from R⁶ (the portion of the two carbon atoms turns into -CH=CH₂ and gets involved in the addition reaction).

Examples of the compound corresponding to the side chain a (POSS) include (POSS-1)-(POSS-8) and the like.

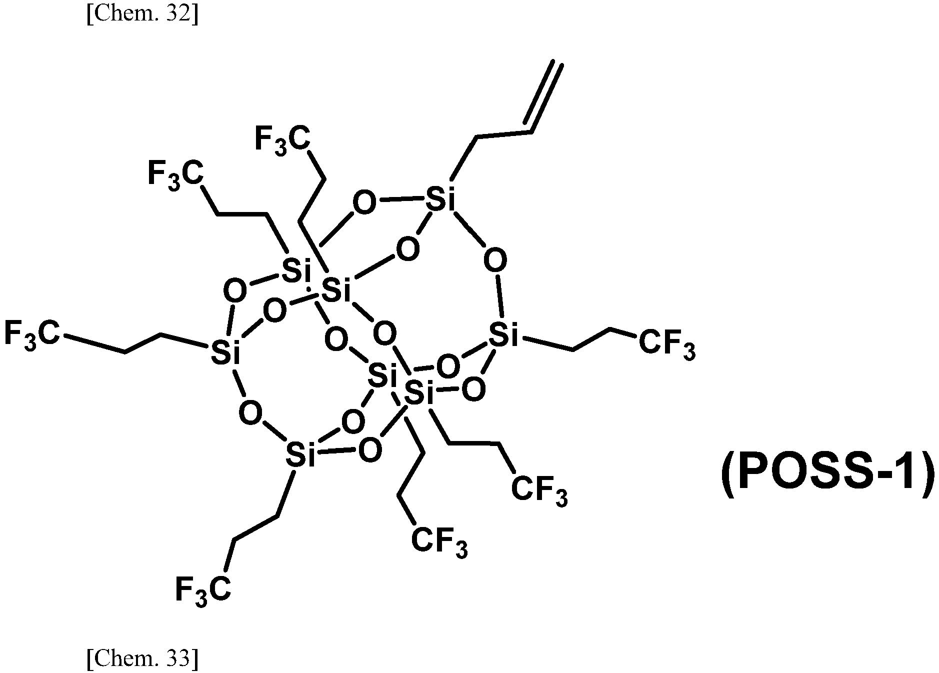

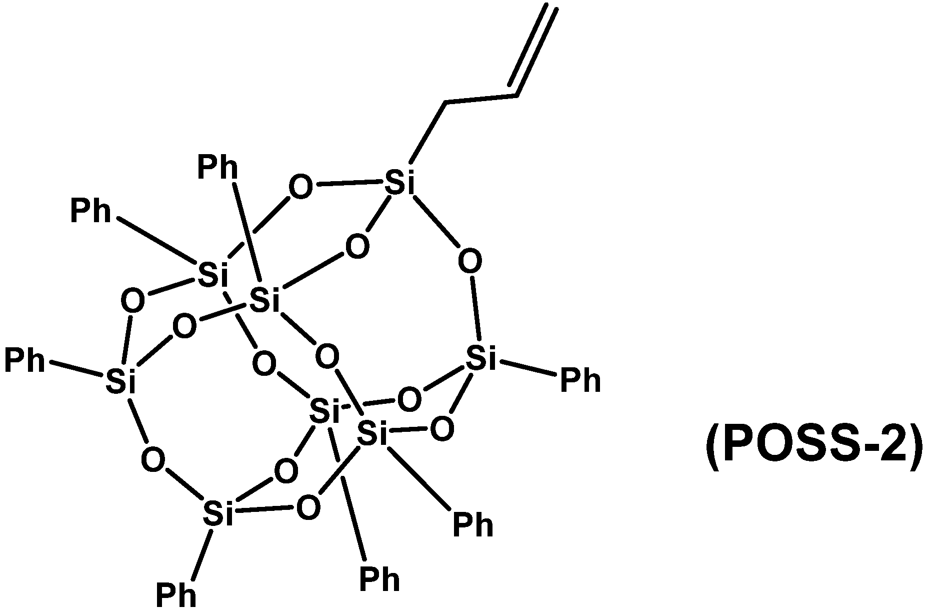

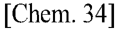

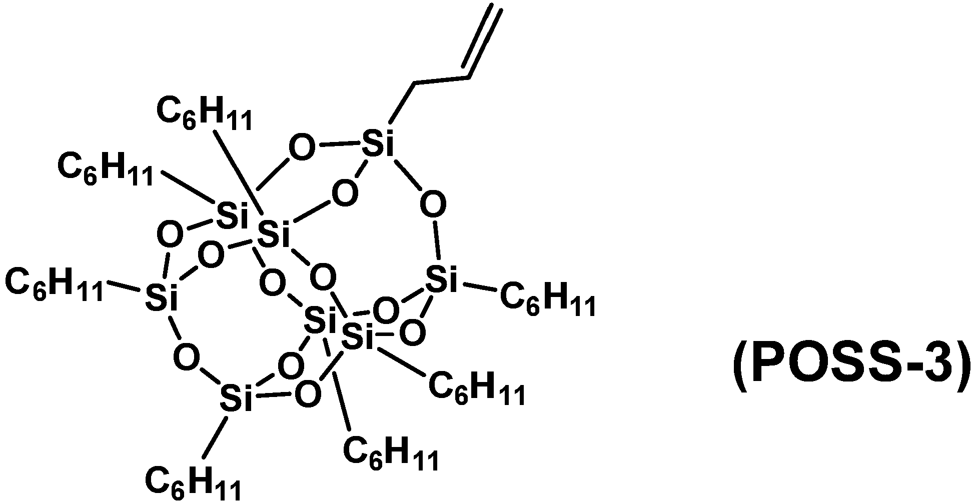

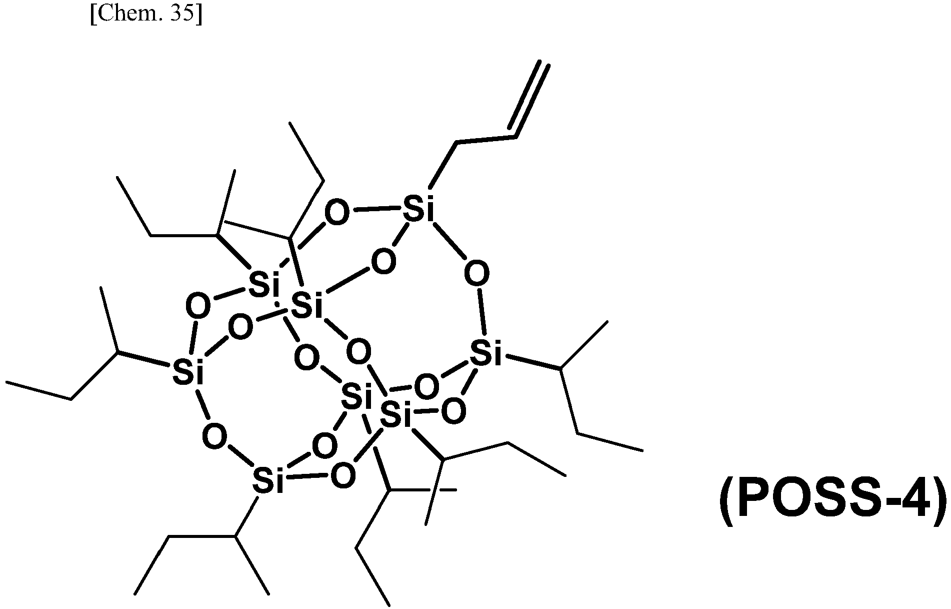

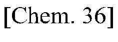

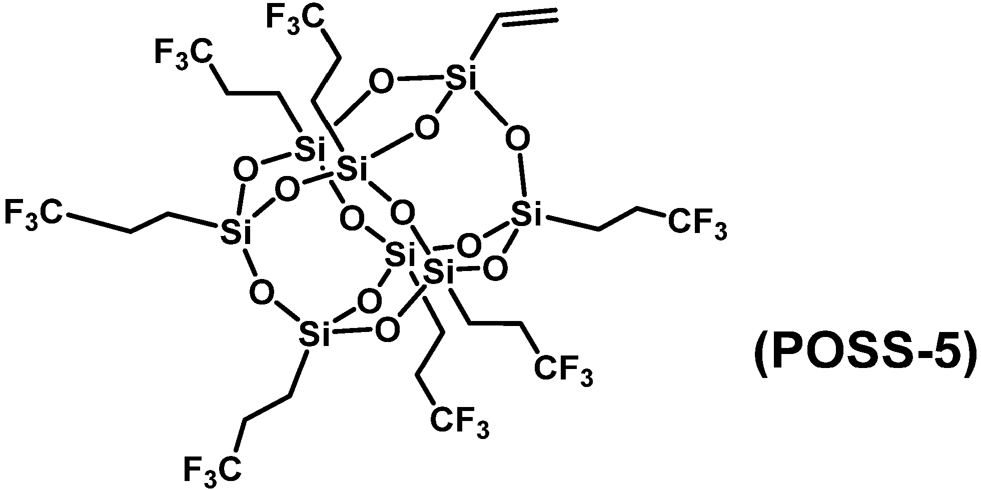

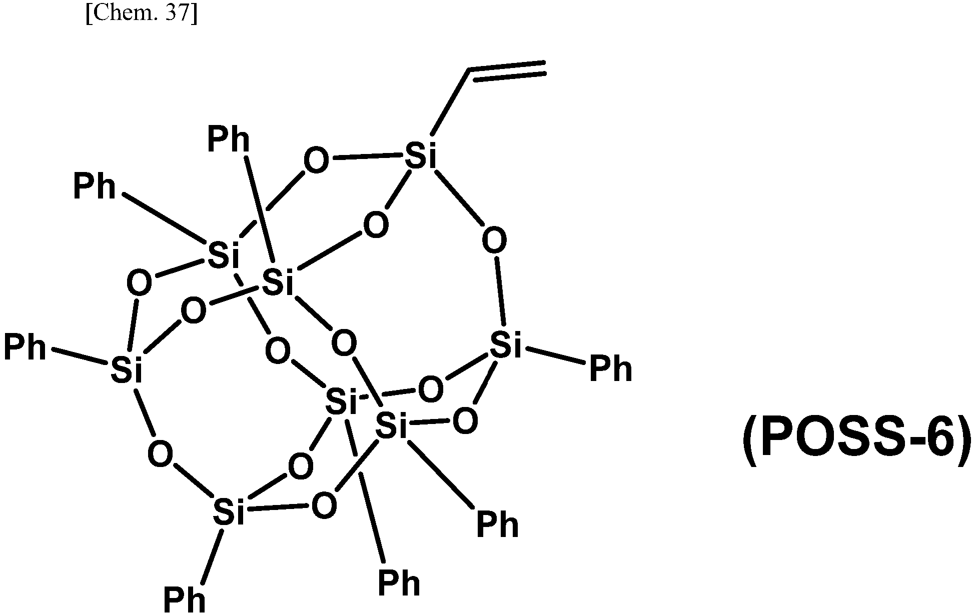

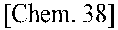

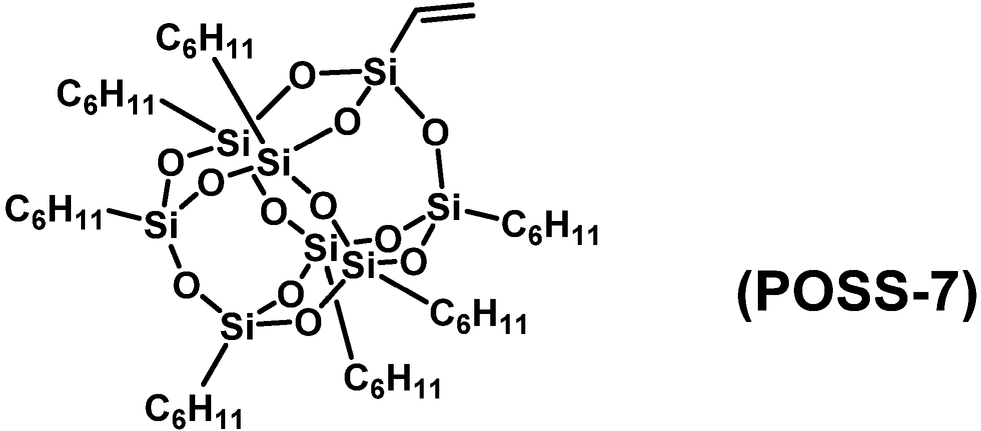

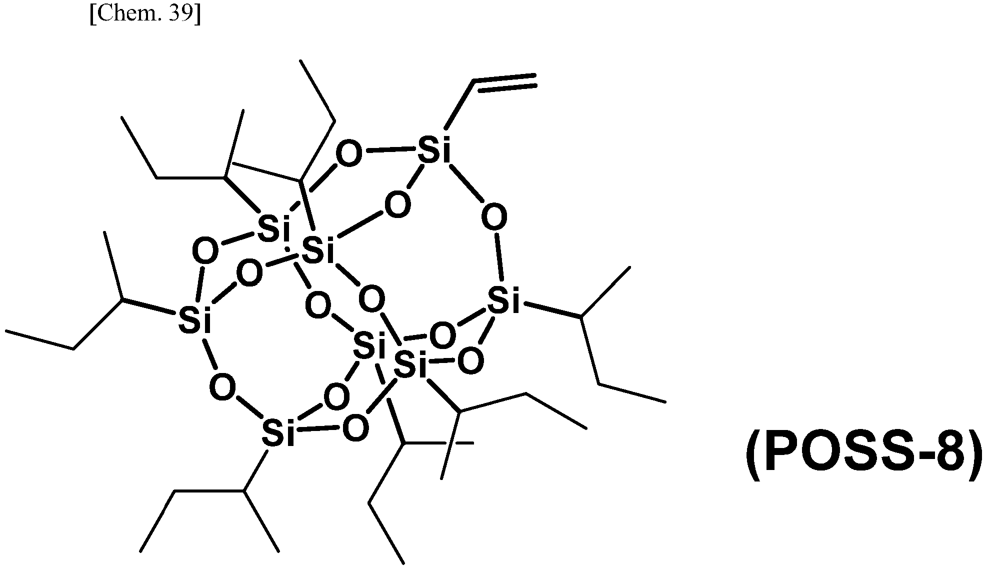

In the above-shown examples, the compounds (POSS) in which reactive groups having R⁶' as a partial structure are -CH=CH₂ and -CH₂CH=CH₂ have been exemplified; however, in a case where alkylene having 4-12 carbon atoms is desired to be introduced, the following groups correspond.
-CH₂CH₂CH=CH₂,
-CH₂CH₂CH₂CH=CH₂,
-CH₂CH₂CH₂CH₂CH=CH₂,
-CH₂CH₂CH₂CH₂CH₂CH=CH₂,
-CH₂CH₂CH₂CH₂CH₂CH₂CH=CH₂,
-CH₂CH₂CH₂CH₂CH₂CH₂CH₂CH=CH₂,
-CH₂CH₂CH₂CH₂CH₂CH₂CH₂CH₂CH=CH₂,
-CH₂CH₂CH₂CH₂CH₂CH₂CH₂CH₂CH₂CH=CH₂,
-CH₂CH₂CH₂CH₂CH₂CH₂CH₂CH₂CH₂CH₂CH=CH₂.

The silicon compound of the present invention can be produced by performing the addition reaction of these compounds (POSS) on, for example, formula (A-10). As a preferable example of the addition reaction, a hydrosilylation reaction using a Karstedt catalyst is known.

In addition, in the case of introducing a side chain in which R⁶ is -CH₂-, as (POSS), compounds as shown below can be selected as a raw material.

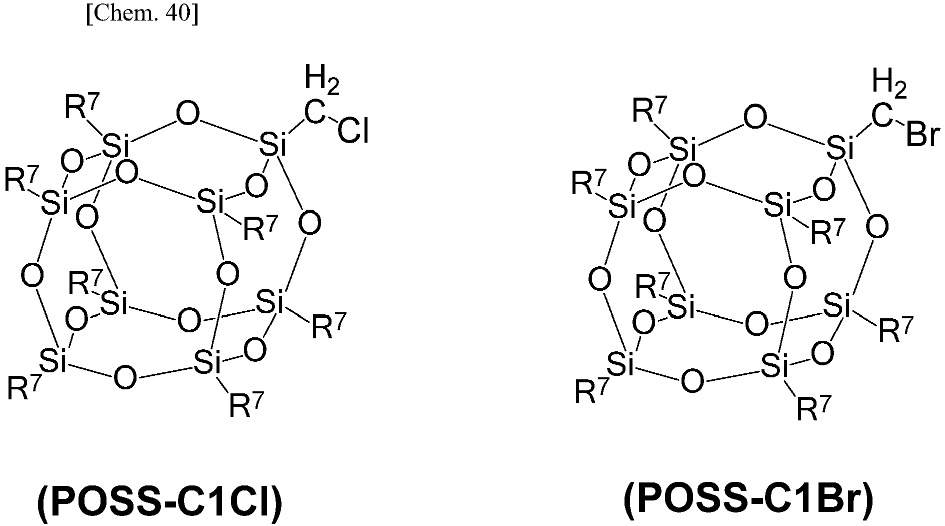

In addition, in the case of introducing a side chain in which R⁶ is -O-, a silicon compound can be produced by, for example, introducing a compound represented by a compound (POSS-OH) into the silicon compound represented by formula (A-10) by a dehydration reaction as in the following reaction formula.

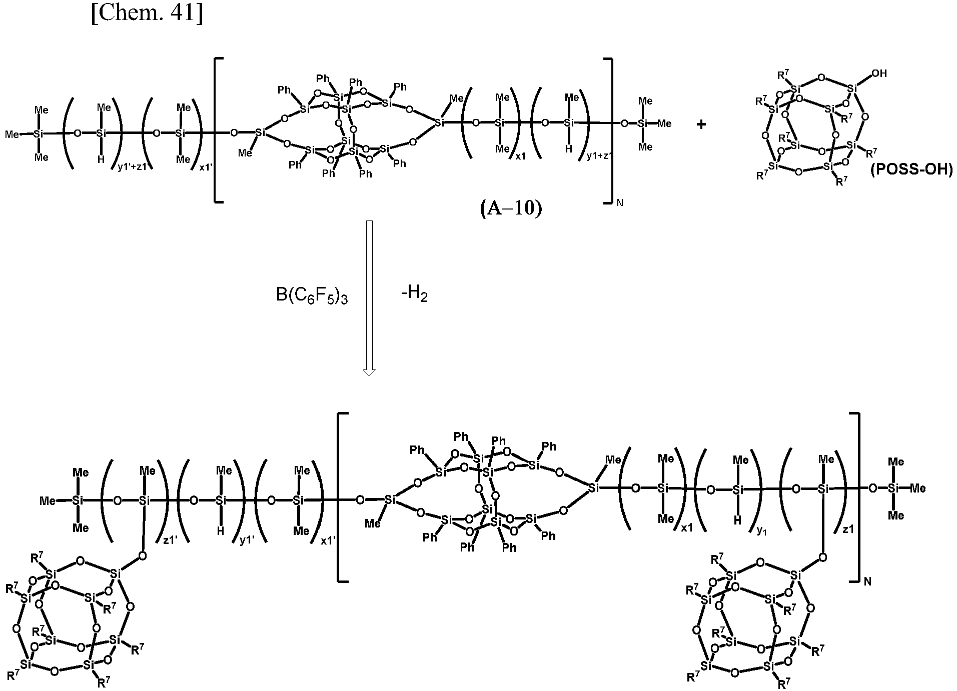

The compound (POSS-OH) corresponds to the side chain a, and, in this example, terminal silanol and hydrogen bound to Si of the silicon compound represented by formula (A-10) perform a dehydration reaction in the presence of a boron compound catalyst.

In addition, the silicon compound of the present invention can be produced by the elimination reaction or substitution reaction of a silicon compound (A-11) in which some of a side chain is a hydroxyl group and a compound (POSS-H).

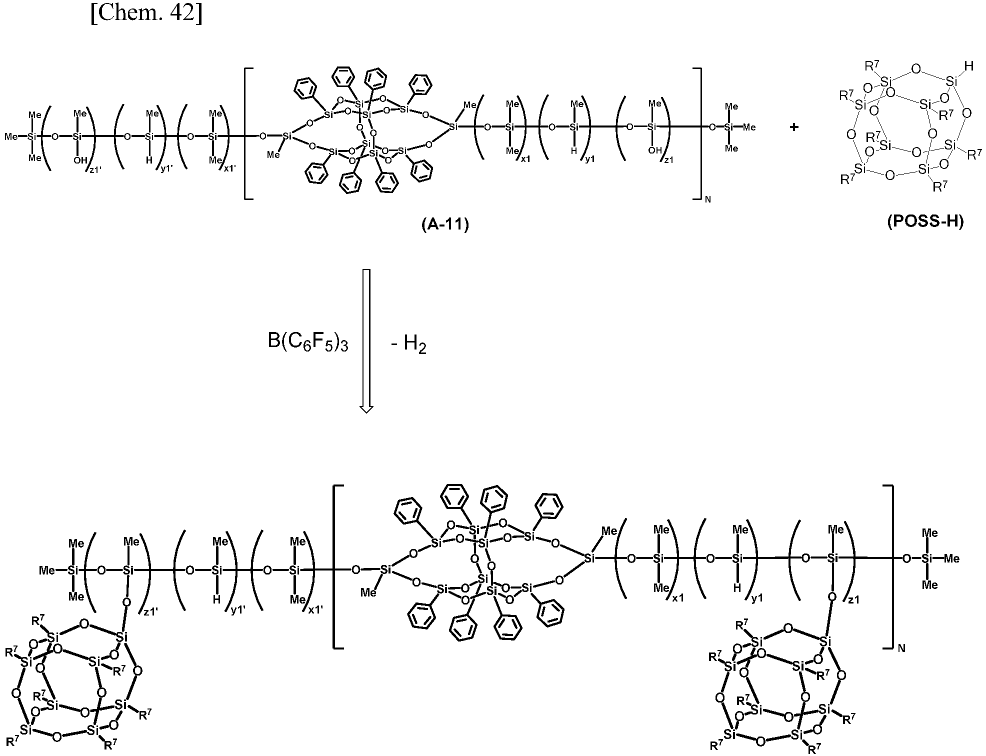

In formula (A-11), x1, z1, x1', and z1' represent positive average values of 0-30, and y1 and y1' are positive average values of 1-30.

The compound (POSS-H) corresponds to the side chain a, and, in this example, terminal hydrosilyl and a hydroxyl group bound to Si of the silicon compound represented by formula (A-11) perform a dehydration reaction in the presence of a boron compound catalyst.

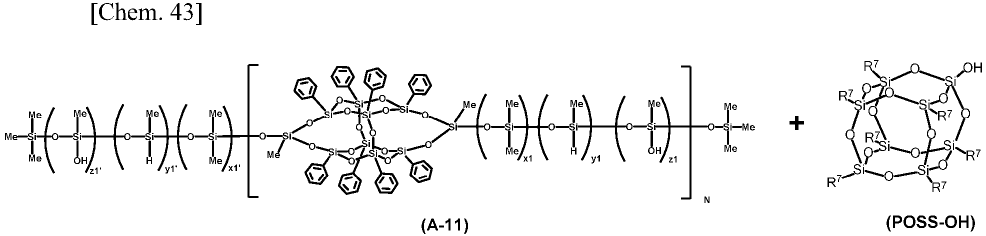

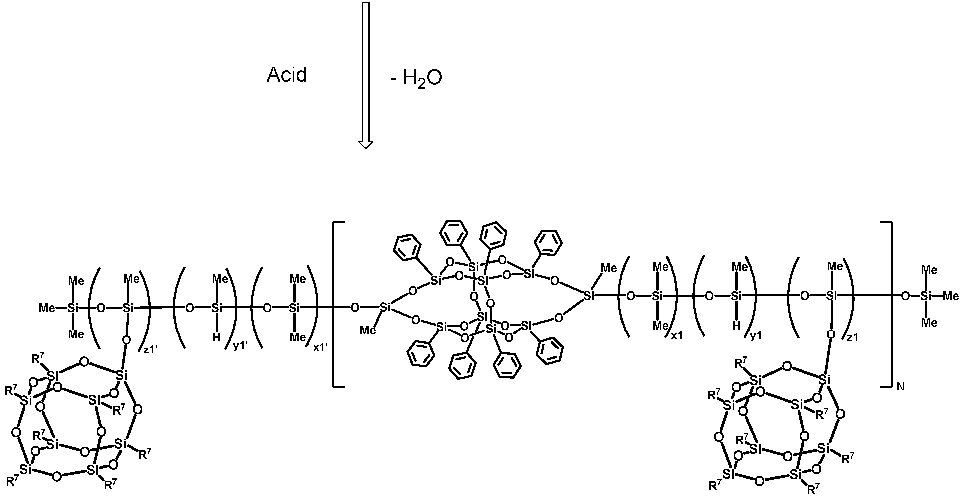

The compound (POSS-OH) corresponds to the side chain a, and, in this example, terminal silanol and a hydroxyl group bound to Si of the silicon compound (A-11) perform a dehydration reaction under an acidic condition.

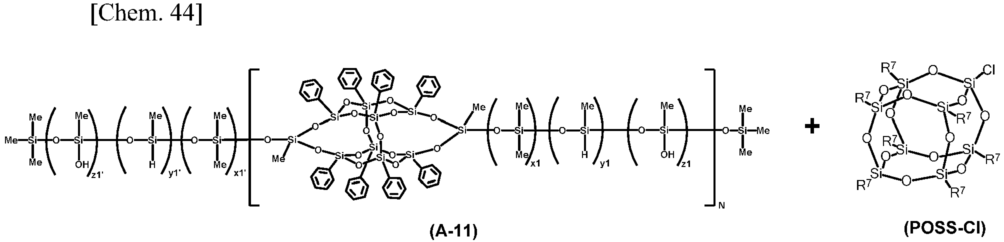

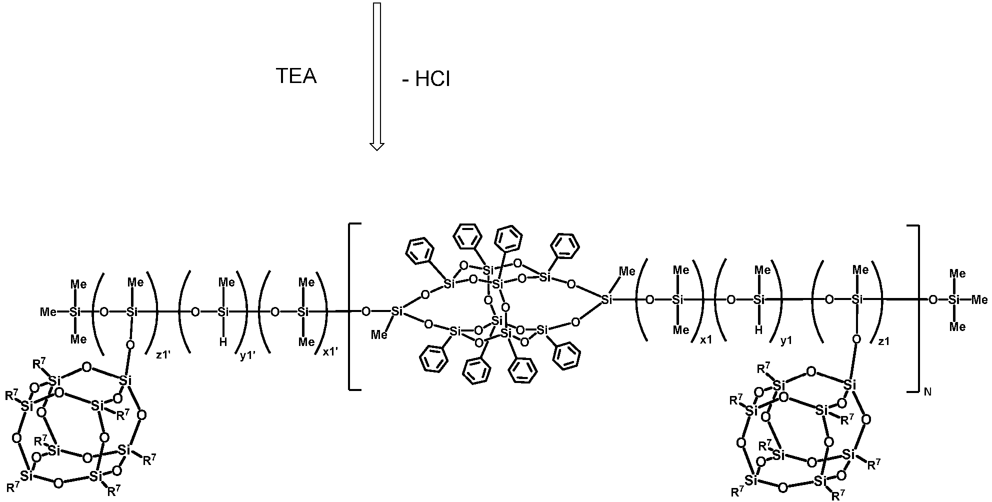

The compound (POSS-Cl) corresponds to the side chain a, and, in this example, terminal chlorosilane and a hydroxyl group bound to Si of the silicon compound (A-11) perform a dehydrochlorination reaction. This reaction can be easily accelerated by adding a compound having an amino group such as triethylamine (TEA) or an organic compound exhibiting basicity.

In a method for producing the silicon compound represented by formula (A-11), the silicon compound can be produced by, for example, reacting the silicon compound represented by formula (A-10) in the presence of a transition metal catalyst.

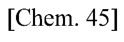

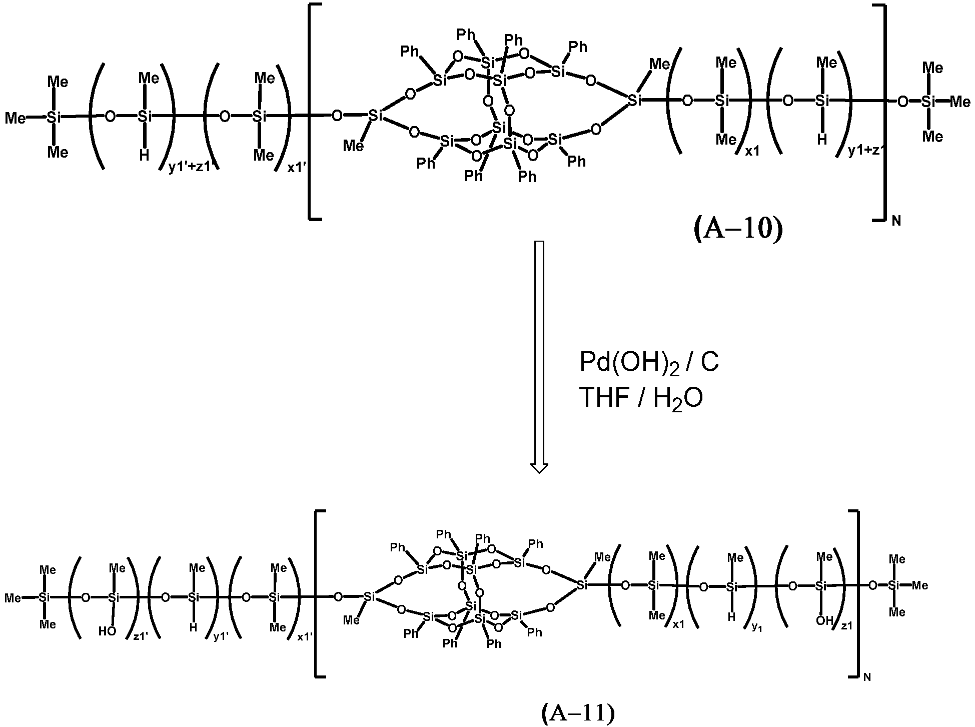

Subsequently, a method for producing the compound (POSS) will be described.

For example, a compound (POSS-2ph) represented by the following formula can be produced by reacting a compound (POSS-0) and allyltrichlorsilane.

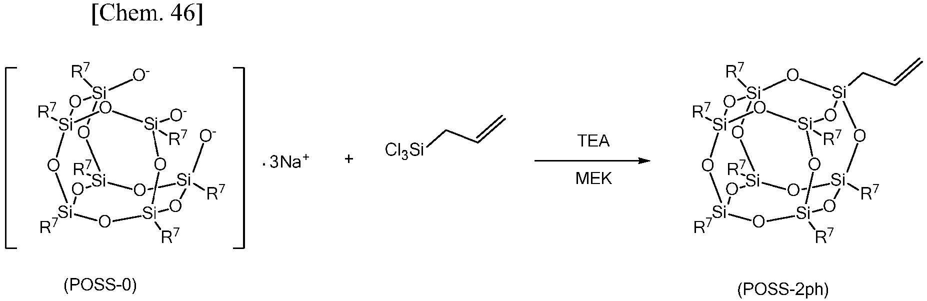

The compound (POSS-OH) can be produced by hydrolyzing the compound (POSS-Cl).

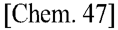

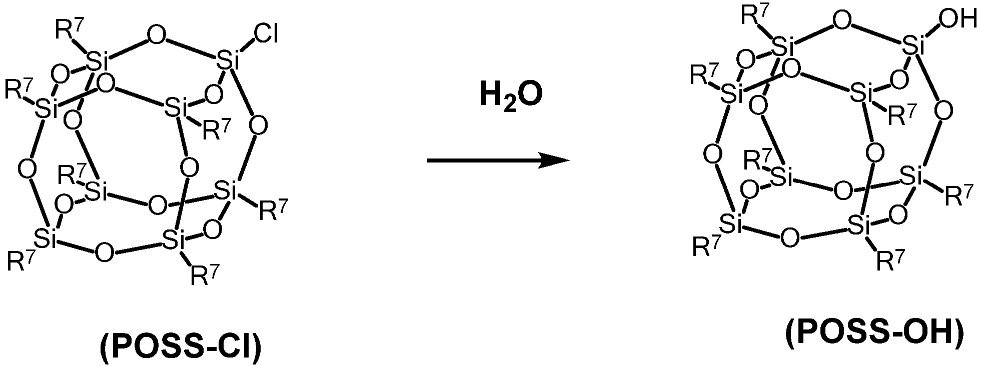

The compound (POSS-Cl) can be produced by reacting the compound (POSS-0) and tetrachlorosilane.

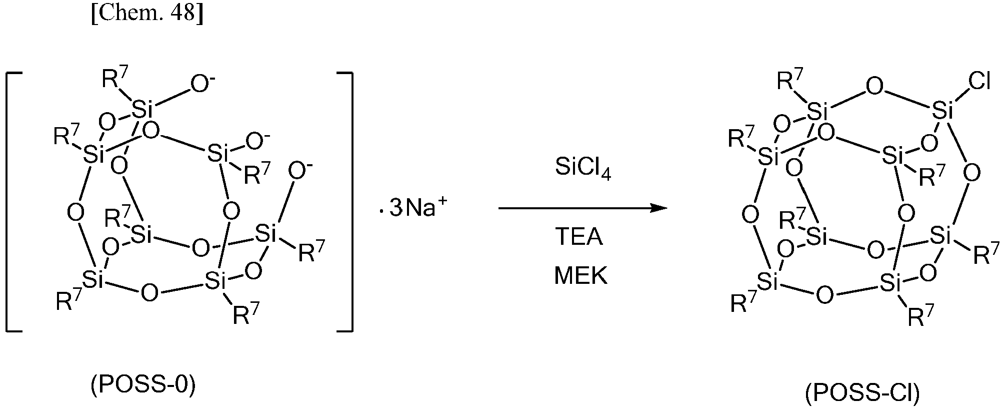

The compound (POSS-H) can be produced by reacting the compound (POSS-0) and trichlorosilane.

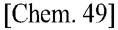

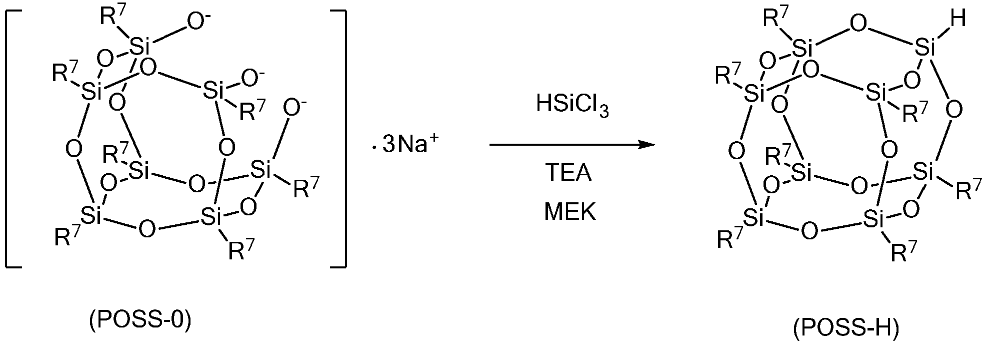

Regarding a method for producing the compound (POSS-0), many examples are known, and the compound (POSS-0) can be produced by, for example, hydrolyzing and polycondensing trifluoropropyltrimethoxysilane in the presence of an alkali metal hydroxide.

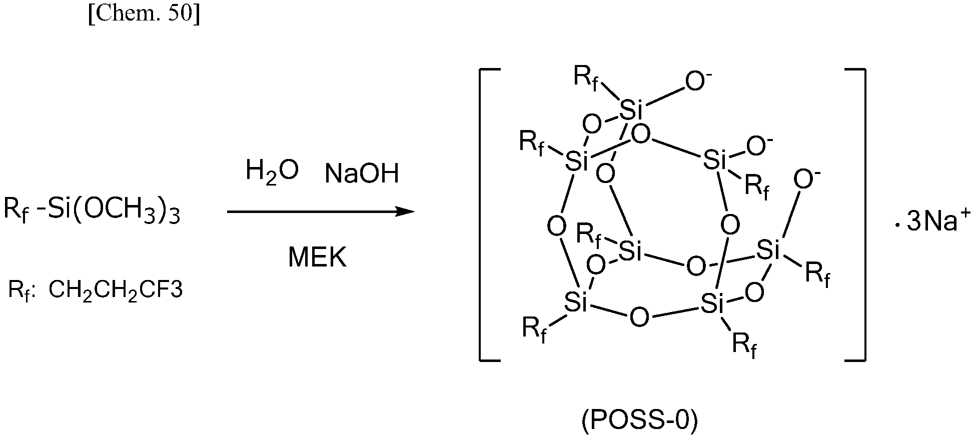

These production methods are described in, for example, paragraph [0032] of Japanese Patent Laid-Open No. 2005-15738.

### <Compound (B) having any one or more elements of Ce, La, Pr, Nd, Y and Fe>

The curable resin composition of the present invention has a compound (B) having any one or more elements of Ce, La, Pr, Nd, Y and Fe. When the curable resin composition has the compound (B) having any one or more elements of Ce, La, Pr, Nd, Y and Fe, the heat resistance improves.

The valences of Ce, La, Pr, Nd, Y and Fe may be divalent to tetravalent.

The compound (B) may have one kind or two or more kinds of any element of Ce, La, Pr, Nd, Y and Fe.

The compound (B) having any one or more elements of Ce, La, Pr, Nd, Y and Fe may or may not be a hydrate.

Examples of the compound (B) having any one or more elements of Ce, La, Pr, Nd, Y and Fe include cerium compounds such as cerium (IV) oxide, cerium (III) bromide, cerium (III) acetylacetonate, cerium (IV) methoxyethoxide, cerium (IV) isopropoxide, tris(isopropylcyclopentadienyl)cerium, tris(cyclopentadienyl)cerium, cerium silicide, diammonium cerium (IV) nitrate, cerium (IV) hydroxide, cerium (III) acetate, cerium (III) tungstate, cerium (III) oxalate, cerium (III) perchlorate, cerium (III) bromide, tetrakis(2,2,6,6-tetramethyl-3,5-heptanedionato)cerium (IV), tris(1,2,3,4-tetramethyl-2,4-cyclopentadienyl)cerium (III), 2,4-pentanedionatocerium (III), cerium (III) trifluoroacetylacetonate, cerium (III) fluoride, cerium (III) sulfide, cerium (III) phosphate, cerium (III) stearate, cerium (III) 2-ethylhexanoate, cerium trifluoromethanesulfonate (III), cerium (III) chloride, cerium (IV) fluoride, cerium (IV) sulfate, cerium (III) iodide, cerium (III) nitrate, cerium (III) carbonate and cerium (IV) trifluoromethanesulfonate,
yttrium compounds such as yttrium (III) oxide, yttrium (III) isopropoxide, yttrium (III) hexafluoroacetylacetonate, tris(cyclopentadienyl)yttrium, tris(butylcyclopentadienyl)yttrium, tris(methylcyclopentadienyl)yttrium, tris(n-propylcyclopentadienyl)yttrium, tris[N,N-bis(trimethylsilyl)amide]yttrium (III), yttrium (III) perchlorate, tris(2,2,6,6-tetramethyl-3,5-heptanedionato)yttrium (III), yttrium (III) acetylacetonate, yttrium (III) chloride, yttrium (III) oxalate, yttrium (III) acetate, yttrium (III) fluoride, yttrium (III) iodide, yttrium (III) 2-ethylhexanoate, yttrium (III) nitrate, yttrium (III) sulfide, yttrium (III) bromide, yttrium (III) trifluoromethanesulfonate, yttrium (III) neodecanoate, yttrium (III) phosphate, yttrium (III) carbonate, yttrium (III) sulfate and yttrium (III) naphthenate,
compounds having lanthanum such as lanthanum (III) oxide, lanthanum (III) isopropoxide, lanthanum tris(hexamethyldisilazide), lanthanum (III) ethoxide, tris(cyclopentadienyl)lanthanum, tris[N,N-bis(trimethylsilyl)amide]lanthanum, tris(isopropylcyclopentadienyl)lanthanum, lanthanum carbonate, tris(6,6,7,7,8,8-heptafluoro-2,2-dimethyl-3,5-octanedionato)lanthanum (III), lanthanum (III) perchlorate, tris(2,2,6,6-tetramethyl-3,5-heptanedionato)lanthanum (III), tris[N,N-bis(trimethylsilyl)amide]lanthanum (III), lanthanum (III) acetylacetonate, lanthanum chloride, lanthanum (III) sulfate, lanthanum (III) 2-ethylhexanoate, lanthanum (III) fluoride, lanthanum chloride, lanthanum (III) iodide, lanthanum boride, lanthanum (III) sulfide, lanthanum (III) bromide, lanthanum (III) nitride, lanthanum (III) trifluoromethanesulfonate, lanthanum (III) nitrate, lanthanum (III) carbonate, lanthanum (III) acetate, tris(N,N'-di-i-propylformamidinato)lanthanum (III) and lanthanum (III) phosphate,
praseodymium compounds such as praseodymium (III) oxide, praseodymium (IV) oxide, praseodymium (III) hexafluoroacetylacetonate, praseodymium (III) hexafluoro-2,4-pentanedionate, praseodymium (III) acetylacetonate, tris(2,2,6,6-tetramethyl-3,5-heptanedionato)praseodymium (III), tris(6,6,7,7,8,8,8-heptafluoro-2,2-dimethyl-3,5-octanedionate)praseodymium (III), tris(isopropylcyclopentadienyl)praseodymium (III), isopropoxypraseodymium (III), praseodymium (III) chloride, praseodymium (III) fluoride, praseodymium (III) acetate, praseodymium (III) sulfate, praseodymium (III) bromide, praseodymium (III) iodide, praseodymium (III) phosphate, praseodymium (III) carbonate, praseodymium (III) trifluoromethanesulfonate, praseodymium (III) nitrate and praseodymium (III) perchlorate,
neodymium compounds such as neodymium (III) oxide, neodymium (III) isopropoxide, trifluoroacetylacetonate neodymium (III), tris(2,2,6,6-tetramethyl-3,5-heptanedionato)neodymium, tris(tetramethylcyclopentadienyl)neodymium, neodymium trifluoroacetylacetonate, tris(isopropylcyclopentadienyl)neodymium, neodymium (III) trifluoromethanesulfonate, neodymium fluoride, tris(cyclopentadienyl)neodymium, neodymium (III) perchlorate, neodymium (III) fluoride, neodymium (III) 2,4-pentanedionate, tris[N,N-bis(trimethylsilyl)amide]neodymium (III), tris(2,2,6,6-tetramethyl-3,5-heptanedionato)neodymium (III), tris(6,6,7,7 , 8,8,8-heptafluoro-2,2-dimethyl-3,5-octanedionato) neodymium (III), neodymium (III) hexafluoroacetylacetonate, neodymium (III) 2-ethylhexanoate, neodymium (III) chloride, neodymium (III) titanate, neodymium (III) bromide, neodymium (III) iodide, neodymium (III) nitride, neodymium (III) acetate, neodymium (III) nitrate, neodymium carbonate, neodymium (III) sulfate and neodymium (III) oxalate, and
iron compounds such as iron (II) oxide, iron (III) oxide, iron (III) acetylacetonate, iron (III) ethoxide, iron (III) isopropoxide, iron (III) 2,4-pentanedionate, iron (III) trifluoroacetylacetonate, tris(2,2,6,6-tetramethyl-3,5-heptanedionato) iron (III), tris(hexafluoroacetylacetonato) iron (III), iron (III) sulfate, iron (III) hexacyanoferrate (II), iron (III) acrylate, ethylenediaminetetraacetic acid, iron (III)-sodium salt, ammonium iron (III) citrate, triammonium iron (III) trioxalate, iron (III) tris(2-ethylhexanoate), iron (III) phosphate, iron (III) fluoride, iron (III) chloride, iron (III) hydroxide oxide, iron (III) bromide, iron (III) trifluoromethanesulfonate, tetraphenylporphine iron (III) chloride, ammonium iron (III) hexacyanoferrate (II), iron (III) nitrate, potassium hexacyanoferrate (III), sodium pentacyanonitrosylferrate (III), iron (III) citrate, iron (III) diphosphate, iron (III) perchlorate, Iron (III) potassium trisoxalate (III), iron(III) 1,3,5-benzenetricarboxylate and iron (III) phosphate.

In addition, among compounds (B) having any one or more elements of Ce, La, Pr, Nd, Y and Fe other than the compounds listed above, compounds into which a siloxane skeleton has been introduced can also be used. In the case of cerium-containing compounds, examples thereof include reactants of cerium carboxylate and a siloxane compound having carboxylate as described in Japanese Patent Laid-Open No. 2020-132789.

Among these, cerium (III) acetylacetonate, cerium (III) nitrate, cerium (III) 2-ethylhexanoate, tris(cyclopentadienyl)cerium, yttrium (III) (acetylacetonate), yttrium (III) nitrate, yttrium (III) 2-ethylhexanoate, tris(cyclopentadienyl)yttrium, lanthanum (III) acetylacetonate, lanthanum (III) 2-ethylhexanoate, tris(cyclopentadienyl)lanthanum, praseodymium (III) nitrate, neodymium (III) nitrate, neodymium (III) 2-ethylhexanoate, tris(cyclopentadienyl)neodymium, iron (III) acetylacetonate, iron (III) 2,4-pentanedionate, tris(2,2,6,6-tetramethyl-3,5-heptanedionato) iron (III), iron (III) acrylate, iron (III) tris(2-ethylhexanoate) and iron (III) nitrate are preferable.

As the compound (B) having any one or more elements of Ce, La, Pr, Nd, Y and Fe, a commercially available product, for example, trade name "OCTOPE R" (manufactured by Hope Chemical Co., Ltd.) may be used.

The content of the compound (B) having any one or more elements of Ce, La, Pr, Nd, Y and Fe is not particularly limited, but is preferably 5 ppm or more and less than 5,000 ppm, more preferably 7 ppm or more and less than 3,000 ppm and still more preferably 10 ppm or more and less than 2,000 ppm of the total weight of the silicon compound (A) + the crosslinking agent (C) in the curable resin composition of the present invention from the viewpoint of the balance between the heat resistance and the solubility.

### <Crosslinking agent (C)>

The curable resin composition of the present invention may contain a crosslinking agent (C) other than the silicon compound (A) having two or more crosslinkable groups that can be chemically bound to the silicon compound (A).

The crosslinking agent (C) is not particularly limited as long as the crosslinking agent has two or more crosslinkable groups and is capable of performing a crosslinking reaction with the silicon compound (A).

Examples of the crosslinkable group include formulas (12)-(17) and (31) bound to Si and the like.

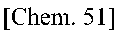

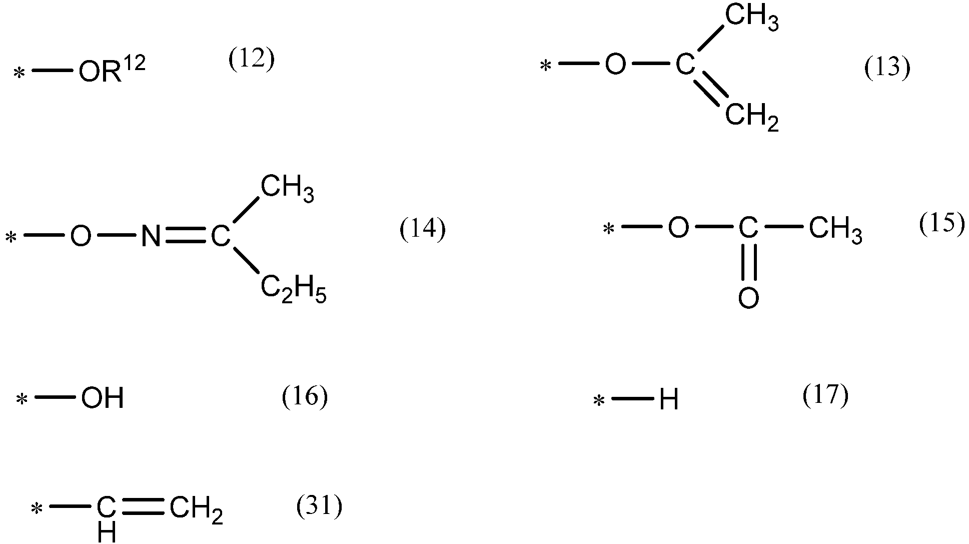

In formula (12), R¹² represents alkyl having 1-8 carbon atoms.

The crosslinking agent (C) may be linear, branched or cyclic.

Specific examples of the crosslinking agent (C) include compounds having one or more structural units of formulas (C-1)-(C-4).

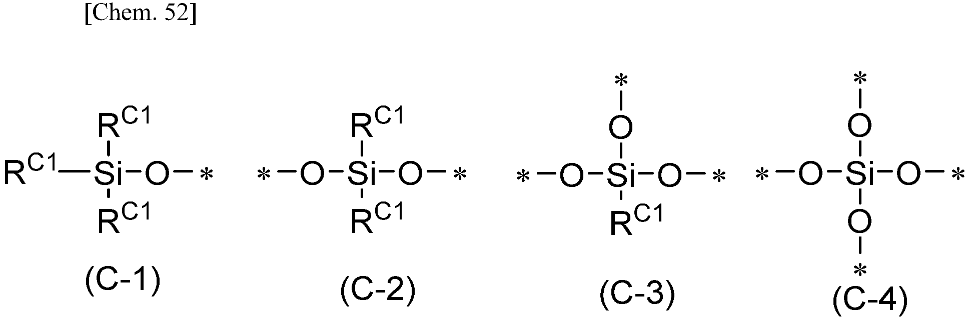

In formulas (C-1)-(C-3), R^{C1,}s independently represent any of the groups represented by formulas (12)-(17) and (31), alkyl such as methyl, ethyl, propyl, isopropyl, butyl, isobutyl, tert-butyl, pentyl, neopentyl, hexyl, cyclohexyl, octyl, nonyl and decyl, aryl such as phenyl, tolyl, xylyl and naphthyl, aralkyl such as benzyl, phenylethyl and phenylpropyl, or the above-described group in which part or all of hydrogen atoms have been substituted with halogen atoms such as fluorine, bromine or chlorine, cyano groups or the like, examples of which include any of chloromethyl, chloropropyl, bromoethyl, trifluoropropyl and cyanoethyl, and at least two R^{C1,}s represent the groups represented by formulas (12)-(17) and (31).

These compounds can be obtained by, for example, a well-known method such as ring-opening polymerization or hydrolysis condensation using at least one of the compounds of formulas (C-5) and (C-6), a method described in the pamphlet of PCT International Publication No. WO 2014/098189 or the like.

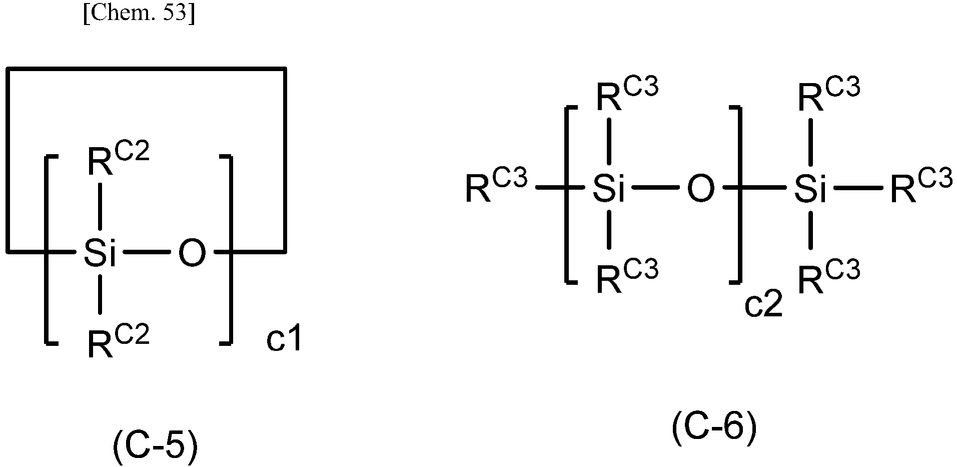

In formula (C-5), R^{C2,}s independently represent any of the groups represented by formulas (12)-(17) and (31), alkyl such as methyl, ethyl, propyl, isopropyl, butyl, isobutyl, tert-butyl, pentyl, neopentyl, hexyl, cyclohexyl, octyl, nonyl and decyl, aryl such as phenyl, tolyl, xylyl and naphthyl, aralkyl such as benzyl, phenylethyl and phenylpropyl, or the above-described group in which part or all of hydrogen atoms have been substituted with halogen atoms such as fluorine, bromine or chlorine, cyano groups or the like, examples of which include any of chloromethyl, chloropropyl, bromoethyl, trifluoropropyl, cyanoethyl and the like.

In formula (C-6), R^{C3,}s independently represent any of the groups represented by formulas (12)-(17) and (31), alkyl such as methyl, ethyl, propyl, isopropyl, butyl, isobutyl, tert-butyl, pentyl, neopentyl, hexyl, cyclohexyl, octyl, nonyl and decyl, aryl such as phenyl, tolyl, xylyl and naphthyl, aralkyl such as benzyl, phenylethyl and phenylpropyl, or the above-described group in which part or all of hydrogen atoms have been substituted with halogen atoms such as fluorine, bromine or chlorine, cyano groups or the like, examples of which include any of chloromethyl, chloropropyl, bromoethyl, trifluoropropyl, cyanoethyl and the like, and at least one R^{C3} represents any of formula (12) or (16).

In formulas (C-5) and (C-6), c1 is an integer of 3-6, and c2 is an integer of 0-9.

More specific examples of the crosslinking agent (C) include 1,3-dimethoxytetramethyldisiloxane, 1,5-dimethoxyhexamethyltrisiloxane, polydimethylsiloxane with dimethylmethoxysiloxy blocked at both molecular chain ends, polymethylphenylsiloxane with dimethylmethoxysiloxy blocked at both molecular chain ends, polydiphenylsiloxane with dimethylmethoxysiloxy blocked at both molecular chain ends, dimethylsiloxane/dimethoxysiloxane copolymers with dimethylmethoxysiloxy blocked at both molecular chain ends, methylphenylsiloxane/dimethoxysiloxane copolymers with dimethylmethoxysiloxy blocked at both molecular chain ends, diphenylsiloxane/dimethoxysiloxane copolymers with dimethylmethoxysiloxy blocked at both molecular chain ends, polydimethylsiloxane with methyldimethoxysiloxy blocked at both molecular chain ends, polymethylphenylsiloxane with methyldimethoxysiloxy blocked at both molecular chain ends, polydiphenylsiloxane with methyldimethoxysiloxy blocked at both molecular chain ends, dimethylsiloxane/dimethoxysiloxane copolymers with methyldimethoxysiloxy blocked at both molecular chain ends, methylphenylsiloxane/dimethoxysiloxane copolymers with methyldimethoxysiloxy blocked at both molecular chain ends, diphenylsiloxane/dimethoxysiloxane copolymers with methyldimethoxysiloxy blocked at both molecular chain ends, polydimethylsiloxane with trimethoxysiloxy blocked at both molecular chain ends, polymethylphenylsiloxane with trimethoxysiloxy blocked at both molecular chain ends, polydiphenylsiloxane with trimethoxysiloxy blocked at both molecular chain ends, dimethylsiloxane/dimethoxysiloxane copolymers with trimethoxysiloxy blocked at both molecular chain end, methylphenylsiloxane/dimethoxysiloxane copolymers with trimethoxysiloxy blocked at both molecular chain ends, diphenylsiloxane/dimethoxysiloxane copolymers with trimethoxysiloxy blocked at both molecular chain ends;
1,3-diethoxytetramethyldisiloxane, 1,5-diethoxyhexamethyltrisiloxane, polydimethylsiloxane with dimethylethoxysiloxy blocked at both molecular chain ends, polymethylphenylsiloxane with dimethylethoxysiloxy blocked at both molecular chain ends, polymethylphenylsiloxane with dimethylethoxysiloxy blocked at both molecular chain ends, polydiphenylsiloxane with dimethylethoxysiloxy blocked at both molecular chain ends, dimethylsiloxane/diethoxysiloxane copolymers with dimethylethoxysiloxy blocked at both molecular chain ends, methylphenylsiloxane/diethoxysiloxane copolymers with dimethylethoxysiloxy blocked at both molecular chain ends, diphenylsiloxane/diethoxysiloxane copolymers with dimethylethoxysiloxy blocked at both molecular chain ends, polydimethylsiloxane with methyldiethoxysiloxy blocked at both molecular chain ends, polymethylphenylsiloxane with methyldiethoxysiloxy blocked at both molecular chain ends, polydiphenylsiloxane with methyldiethoxysiloxy blocked at both molecular chain ends, dimethylsiloxane/diethoxysiloxane copolymers with methyldiethoxysiloxy blocked at both molecular chain ends, methylphenylsiloxane/diethoxysiloxane copolymers with methyldiethoxysiloxy blocked at both molecular chain ends, diphenylsiloxane/diethoxysiloxane copolymers with methyldiethoxysiloxy blocked at both molecular chain ends, polydimethylsiloxane with triethoxysiloxy blocked at both molecular chain ends, polymethylphenylsiloxane with triethoxysiloxy blocked at both molecular chain ends, polydiphenylsiloxane with triethoxysiloxy blocked at both molecular chain ends, dimethylsiloxane/diethoxy siloxane copolymers with triethoxysiloxy blocked at both molecular chain ends, methylphenylsiloxane/diethoxysiloxane copolymers with triethoxysiloxy blocked at both molecular chain ends, diphenylsiloxane/diethoxysiloxane copolymers with triethoxysiloxy blocked at both molecular chain ends;
1,3-dihydroxytetramethyldisiloxane, 1,5-dihydroxyhexamethyltrisiloxane, 1,5-dihydroxyhexaphenyltrisiloxane, polydimethylsiloxane with dimethylhydroxysiloxy blocked at both molecular chain ends, polymethylphenylsiloxane with dimethylhydroxysiloxy blocked at both molecular chain ends, polydiphenylsiloxane with dimethylhydroxysiloxy blocked at both molecular chain ends, dimethylsiloxane/dihydroxysiloxane copolymers with dimethylhydroxysiloxy blocked at both molecular chain ends, methylphenylsiloxane/dihydroxysiloxane copolymers with dimethylhydroxysiloxy blocked at both molecular chain ends, diphenylsiloxane/dihydroxysiloxane copolymers with dimethylhydroxysiloxy blocked at both molecular chain ends, polydimethylsiloxane with methyldihydroxysiloxy blocked at both molecular chain ends, polymethylphenylsiloxane with methyldihydroxysiloxy blocked at both molecular chain ends, polydiphenylsiloxane with methyldihydroxysiloxy blocked at both molecular chain ends, dimethylsiloxane/dihydroxysiloxane copolymers with methyldihydroxysiloxy blocked at both molecular chain ends, methylphenylsiloxane/dihydroxysiloxane copolymers with methyldihydroxysiloxy blocked at both molecular chain ends, diphenylsiloxane/dihydroxysiloxane copolymers with methyldihydroxysiloxy blocked at both molecular chain ends, polydimethylsiloxane with trihydroxysiloxy blocked at both molecular chain ends, polymethylphenylsiloxane with trihydroxysiloxy blocked at both molecular chain ends, polydiphenylsiloxane with trihydroxysiloxy blocked at both molecular chain ends, dimethylsiloxane/dihydroxy siloxane copolymers with trihydroxysiloxy blocked at both molecular chain ends, methylphenylsiloxane/dihydroxysiloxane copolymers with trihydroxysiloxy blocked at both molecular chain ends, diphenylsiloxane/dihydroxysiloxane copolymers with trihydroxysiloxy blocked at both molecular chain ends;
1,3-divinyltetramethyldisiloxane, 1,5-divinylhexamethyltrisiloxane, polydimethylsiloxane with dimethylvinylsiloxy blocked at both molecular chain ends, polymethylphenylsiloxane with dimethylvinylsiloxy blocked at both molecular chain ends, polydiphenylsiloxane with dimethylvinylsiloxy blocked at both molecular chain ends, dimethylsiloxane/divinylsiloxane copolymers with dimethylvinylsiloxy blocked at both molecular chain ends, methylphenylsiloxane/divinylsiloxane copolymers with dimethylvinylsiloxy blocked at both molecular chain ends, diphenylsiloxane/divinylsiloxane copolymers with dimethylvinylsiloxy blocked at both molecular chain ends, polydimethylsiloxane with methyldivinylsiloxy blocked at both molecular chain ends, polymethylphenylsiloxane with methyldivinylsiloxy blocked at both molecular chain ends, polydiphenylsiloxane with methyldivinylsiloxy blocked at both molecular chain ends, dimethylsiloxane/divinylsiloxane copolymers with methyldivinylsiloxy blocked at both molecular chain ends, methylphenylsiloxane/divinylsiloxane copolymers with methyldivinylsiloxy blocked at both molecular chain ends, diphenylsiloxane/divinylsiloxane copolymers with methyldivinylsiloxy blocked at both molecular chain ends, polydimethylsiloxane with trivinylsiloxy blocked at both molecular chain ends, polymethylphenylsiloxane with trivinylsiloxy blocked at both molecular chain ends, polydiphenylsiloxane with trivinylsiloxy blocked at both molecular chain ends, dimethylsiloxane/divinylsiloxane copolymers with trivinylsiloxy blocked at both molecular chain ends, methylphenylsiloxane/divinylsiloxane copolymers with trivinylsiloxy blocked at both molecular chain ends, diphenylsiloxane/divinylsiloxane copolymers with trivinylsiloxy blocked at both molecular chain ends;
1,1,3,3-tetramethyldisiloxane, 1,1,3,3,5,5-hexamethyltrisiloxane, polydimethylsiloxane with dimethylhydrogensiloxy blocked at both molecular chain ends, polymethylphenylsiloxane with dimethylhydrogensiloxy blocked at both molecular chain ends, polydiphenylsiloxane with dimethylhydrogensiloxy blocked at both molecular chain ends, dimethylsiloxane/dihydrogensiloxane copolymers with dimethylhydrogensiloxy blocked at both molecular chain ends, methylphenylsiloxane/dihydrogensiloxane copolymers with dimethylhydrogensiloxane blocked at both molecular chain ends, diphenylsiloxane/dihydrogensiloxane copolymers with dimethylhydrogensiloxy blocked at both molecular chain ends, polydimethylsiloxane with methyldihydrogensiloxy blocked at both molecular chain ends, polymethylphenylsiloxane with methyldihydrogensiloxy blocked at both molecular chain ends, polydiphenylsiloxane with methyldihydrogensiloxy blocked at both chain ends, dimethylsiloxane/dihydrogensiloxane copolymers with methyldihydrogensiloxy blocked at both molecular chain ends, methylphenylsiloxane/dihydrogensiloxane copolymers with methyldihydrogensiloxy blocked at both molecular chain ends, diphenylsiloxane/dihydrogensiloxane copolymers with methyldihydrogensiloxy blocked at both molecular chain ends, polydimethylsiloxane with trihydrogensiloxy blocked at both molecular chain ends, polymethylphenylsiloxane with trihydrogensiloxy blocked at both molecular chain ends, polydiphenylsiloxane with trihydrogensiloxy blocked at both molecular chain ends, dimethylsiloxane/dihydrogensiloxane copolymers with trihydrogensiloxy blocked at both molecular chain ends, methylphenylsiloxane/dihydrogensiloxane copolymers with trihydrogensiloxy blocked at both molecular chain ends, diphenylsiloxane/dihydrogensiloxane copolymers with trihydrogensiloxy blocked at both molecular chain ends;
1,3-diacetoxytetramethyldisiloxane, 1,5-diacetoxyhexamethyltrisiloxane, polydimethylsiloxane with dimethylacetoxysiloxy blocked at both molecular chain ends, polymethylphenylsiloxane with dimethylacetoxysiloxy blocked at both molecular chain ends, polydiphenylsiloxane with dimethylacetoxysiloxy blocked at both molecular chain ends, dimethylsiloxane/diacetoxysiloxane copolymers with dimethylacetoxysiloxy blocked at both molecular chain ends, methylphenylsiloxane/diacetoxysiloxane copolymers with dimethylacetoxysiloxy blocked at both molecular chain ends, diphenylsiloxane/diacetoxysiloxane copolymers with dimethylacetoxysiloxy blocked at both molecular chain ends, polydimethylsiloxane with methyldiacetoxysiloxy blocked at both molecular chain ends, polymethylphenylsiloxane with methyldiacetoxysiloxy blocked at both molecular chain ends, polydiphenylsiloxane with methyldiacetoxysiloxy blocked at both molecular chain ends, dimethylsiloxane/diacetoxysiloxane copolymers with methyldiacetoxysiloxy blocked at both molecular chain ends, methylphenylsiloxane/diacetoxysiloxane copolymers with methyldiacetoxysiloxy blocked at both molecular chain ends, diphenylsiloxane/diacetoxysiloxane copolymers with methyldiacetoxy blocked at both molecular chain ends, polydimethylsiloxane with triacetoxysiloxy blocked at both molecular chain ends, polymethylphenylsiloxane with triacetoxysiloxy blocked at both molecular chain ends, polydiphenylsiloxane with triacetoxysiloxy blocked at both molecular chain ends, dimethylsiloxane/diacetoxysiloxane copolymers with triacetoxysiloxy blocked at both molecular chain ends, methylphenylsiloxane/diacetoxysiloxane copolymers with triacetoxysiloxy blocked at both molecular chain ends, diphenylsiloxane/diacetoxysiloxane copolymers with triacetoxysiloxy blocked at both molecular chain ends;
1,3-diethylmethylketoxime tetramethyldisiloxane, 1,5-diethylmethylketoxime hexamethyltrisiloxane, polydimethylsiloxane with dimethylethylmethylketoximesiloxy blocked at both molecular chain ends, polymethylphenylsiloxane with dimethylethylmethylketoximesiloxy blocked at both molecular chain ends, polydiphenylsiloxane with dimethylethylmethylketoximesiloxy blocked at both molecular chain ends, dimethylsiloxane/diethylmethylketoximesiloxane copolymers with dimethylethylmethylketoximesiloxy blocked at both molecular chain ends, methylphenylsiloxane/diethylmethylketoximesiloxane copolymers with dimethylethylmethylketoximesiloxy blocked at both molecular chain ends, diphenylsiloxane/diethylmethylketoximesiloxane copolymers with dimethylethylmethylketoximesiloxy blocked at both molecular chain ends, polydimethylsiloxane with methyldiethylmethylketoximesiloxy blocked at both molecular chain ends, polymethylphenylsiloxane with methyldiethylmethylketoximesiloxy blocked at both molecular chain ends, polydiphenylsiloxane with methyldiethylmethylketoximesiloxy blocked at both molecular chain ends, dimethylsiloxane/diethylmethylketoximesiloxane copolymers with methyldiethylmethylketoximesiloxy blocked at both molecular chain ends, methylphenylsiloxane/diethylmethylketoximesiloxane copolymers with methyldiethylmethylketoximesiloxy blocked at both molecular chain ends, diphenylsiloxane/diethylmethylketoximesiloxane copolymers with methyldiethylmethylketoxime blocked at both molecular chain ends, polydimethylsiloxane with triethylmethylketoximesiloxy blocked at both molecular chain ends, polymethylphenylsiloxane with triethylmethylketoximesiloxy blocked at both molecular chain ends, polydiphenylsiloxane with triethylmethylketoximesiloxy blocked at both molecular chain ends, dimethylsiloxane/diethylmethylketoximesiloxane copolymers with triethylmethylketoximesiloxy blocked at both molecular chain ends, methylphenylsiloxane/diethylmethylketoximesiloxane copolymers with triethylmethylketoximesiloxy blocked at both molecular chain ends, diphenylsiloxane/diethylmethylketoximesiloxane copolymers with triethylmethylketoximesiloxy blocked at both molecular chain ends;
copolymers that are formed from a (CH₃)₂(OCH₃)SiO_{1/2} unit, a (CH₃)₂SiO_{2/2} unit and a SiO_{4/2} unit, copolymers that are formed from a (CH₃)₃SiO_{1/2} unit, a (CH₃)₂SiO_{2/2} unit, a (CH₃)(OCH₃)SiO_{2/2} unit and a (CH₃)SiO_{3/2} unit, copolymers that are formed from a (CH₃)₂(OCH₃)SiO_{1/2} unit, a (CH₃)₂SiO_{2/2} unit and a (CH₃)SiO_{3/2} unit, copolymers that are formed from a (CH₃)₂(OCH₃)SiO_{1/2} unit, a (CH₃)₂SiO_{2/2} unit, a (C₆H₅)₂SiO₂/₂ unit and a (CH₃)SiO_{3/2} unit;
copolymers that are formed from a (CH₃)₂(OC₂H₅)SiO_{1/2} unit, a (CH₃)₂SiO_{2/2} unit and a SiO_{4/2} unit, copolymers that are formed from a (CH₃)₃SiO_{1/2} unit, a (CH₃)₂SiO_{2/2} unit, a (CH₃)(OC₂H₅)SiO_{2/2} unit and a (CH₃)SiO_{3/2} unit, copolymers that are formed from a (CH₃)₂(OC₂H₅)SiO_{1/2} unit, a (CH₃)₂SiO_{2/2} unit and a (CH₃)SiO_{3/2} unit, copolymers that are formed from a (CH₃)₂(OC₂H₅)SiO_{1/2} unit, a (CH₃)₂SiO_{2/2} unit, a (C₆H₅)₂SiO₂/₂ unit and a (CH₃)SiO_{3/2} unit,
copolymers that are formed from a (CH₃)₂(OH)SiO_{1/2} unit, a (CH₃)₂SiO_{2/2} unit and a SiO_{4/2} unit, copolymers that are formed from a (CH₃)₃SiO_{1/2} unit, a (CH₃)₂SiO_{2/2} unit, a (CH₃)(OH)SiO_{2/2} unit and a (CH₃)SiO_{3/2} unit, copolymers that are formed from a (CH₃)₂(OH)SiO_{1/2} unit, a (CH₃)₂SiO_{2/2} unit and a (CH₃)SiO_{3/2} unit, copolymers that are formed from a (CH₃)₂(OH)SiO_{1/2} unit, a (CH₃)₂SiO_{2/2} unit, a (C₆H₅)₂SiO₂/₂ unit and a (CH₃)SiO_{3/2} unit;
copolymers that are formed from a (CH₃)₂(CH=CH₂)SiO_{1/2} unit, a (CH₃)₂SiO_{2/2} unit and a SiO_{4/2} unit, copolymers that are formed from a (CH₃)₃SiO_{1/2} unit, a (CH₃)₂SiO_{2/2} unit, a (CH₃)(CH=CH₂)SiO_{2/2} unit and a (CH₃)SiO_{3/2} unit, copolymers that are formed from a (CH₃)₂(CH=CH₂)SiO_{1/2} unit, a (CH₃)₂SiO_{2/2} unit and a (CH₃)SiO_{3/2} unit, copolymers that are formed from a (CH₃)₂(CH=CH₂)SiO_{1/2} unit, a (CH₃)₂SiO_{2/2} unit, a (C₆H₅)₂SiO₂/₂ unit and a (CH₃)SiO_{3/2} unit;
copolymers that are formed from a (CH₃)₂HsiO_{1/2} unit, a (CH₃)₂SiO_{2/2} unit and a SiO_{4/2} unit, copolymers that are formed from a (CH₃)₃SiO_{1/2} unit, a (CH₃)₂SiO_{2/2} unit, a (CH₃)HsiO_{2/2} unit and a (CH₃)SiO_{3/2} unit, copolymers that are formed from a (CH₃)₂HsiO_{1/2} unit, a (CH₃)₂SiO_{2/2} unit and a (CH₃)SiO_{3/2} unit, copolymers that are formed from a (CH₃)₂HsiO_{1/2} unit, a (CH₃)₂SiO_{2/2} unit, a (C₆H₅)₂SiO₂/₂ unit and a (CH₃)SiO_{3/2} unit, each of the above-exemplified compounds in which part or all of methyl has been substituted with other alkyl such as ethyl or propyl or aryl such as phenyl;
methyltrimethoxysilane, methyltriethoxysilane, phenyltrimethoxysilane, phenyltriethoxysilane, glycidyltrimethoxysilane, mercaptotrimethoxysilane, mercaptotriethoxysilane, aminopropyltriethoxysilane, tetramethoxysilane, partially condensed tetramethoxysilane, tetraethoxysilane, partially condensed tetraethoxysilane, vinyltrimethoxysilane, vinyltriethoxysilane, isobutyltrimethoxysilane, ethyltrimethoxysilane, vinyltriethoxysilane, phenyltrimethoxysilane, 3,3,3-trifluoropropyltrimethoxysilane, methyltriacetoxysilane, vinyltriacetoxysilane, ethyltriacetoxysilane, di-butoxydiacetoxysilane, phenyl-tripropionoxysilane, methyltris(methylethylketoximo)silane, vinyl-tris-methylethylketoximosilane, methyltris(methylethylketoxyimino)silane, methyltris(isopropenoxy)silane, vinyltris(isopropenoxy)silane, ethylpolysilicate, n-propylorthosilicate, ethylorthosilicate, dimethyltetraacetoxydisiloxane, oxime silane, acetoxy silane, acetonoxime silane, enoxy silane and the like.

Examples of a compound having one or more structural units of formulas (C-1)-(C-4) also include compounds to be listed below.

Compounds having an organic group in a main chain such as 1,6-bis(trimethoxysilyl)hexane, bis(trialkoxysilylalkyl)amine, bis(dialkoxyalkylsilylalkyl)amine, bis(trialkoxysilylalkyl) N-alkylamine, bis(dialkoxyalkylsilylalkyl) N-alkylamine, bis(trialkoxysilylalkyl)urea, bis(dialkoxyalkylsilylalkyl)urea, bis(3-trimethoxysilylpropyl)amine, bis(3-triethoxysilylpropyl)amine, bis(4-trimethoxysilylbutyl)amine, bis(4-triethoxysilylbutyl)amine, bis(3-trimethoxysilylpropyl) N-methylamine, bis(3-triethoxysilylpropyl) N-methylamine, bis(4-trimethoxysilylbutyl) N-methylamine, bis(4-triethoxysilylbutyl) N-methylamine, bis(3-trimethoxysilylpropyl)urea, bis(3-triethoxysilylpropyl)urea, bis(4-trimethoxysilylbutyl)urea, bis(4-triethoxysilylbutyl)urea, bis(3-dimethoxymethylsilylpropyl)amine, bis(3-diethoxymethylsilylpropyl)amine, bis(4-dimethoxymethylsilylbutyl)amine, bis(4-diethoxymethylsilylbutyl)amine, bis(3-dimethoxymethylsilylpropyl) N-methylamine, bis(3-diethoxymethylsilylpropyl) N-methylamine, bis(4-dimethoxymethylsilylbutyl) N-methylamine, bis(4-diethoxymethylsilylbutyl) N-methylamine, bis(3-dimethoxymethylsilylpropyl)urea, bis(3-diethoxymethylsilylpropyl)urea, bis(4-dimethoxymethylsilylbutyl)urea, bis(4-diethoxymethylsilylbutyl)urea, bis(3-dimethoxyethylsilylpropyl)amine, bis(3-diethoxyethylsilylpropyl)amine, bis( 4-dimethoxyethylsilylbutyl)amine, bis(4-diethoxyethylsilylbutyl)amine, bis(3-dimethoxyethylsilylpropyl) N-methylamine, bis(3-diethoxyethylsilylpropyl) N-methylamine, bis(4-dimethoxyethylsilylbutyl) N-methylamine, bis(4-diethoxyethylsilylbutyl) N-methylamine, bis(3 -dimethoxyethylsilylpropyl)urea, bis(3 -diethoxyethylsilylpropyl)urea, bis(4-dimethoxyethylsilylbutyl)urea, and/or bis(4-diethoxyethylsilylbutyl)urea; bis(triethoxysilylpropyl)amine, bis(trimethoxysilylpropyl)amine, bis(trimethoxysilylpropyl)urea, bis(triethoxysilylpropyl)urea, bis(diethoxymethylsilylpropyl) N-methylamine; di- or trialkoxysilane-terminated polydialkylsiloxane, di- or trialkoxysilyl-terminated polyarylalkylsiloxane, di- or trialkoxysilyl-terminated polypropylene oxide, polyurethane, polyacrylate; polyisobutylene; di- or triacetoxy-terminated polydialkyl; polyarylalkylsiloxane; di- or trioxyiminosilyl-terminated polydialkyl; polyarylalkylsiloxane; and di- or triacetonoxy-terminated polydialkyl or polyarylalkyl.

Examples of commercially available products of the crosslinking agent (C) include SILAPLANE FM11 series, SILAPLANE FM22 series, SILAPLANE FM88 series, SILAPLANE FM99 series and SILAPLANE FM08 series (all trade names) manufactured by JNC Corporation, SR series (trade name) manufactured by Konishi Chemical Ind Co., Ltd., MKC silicate MS57 (trade name), MKC silicate MS51 (trade name) (tetramethoxysilane average pentamer), MKC silicate MS56 and MS56S (all trade names) manufactured by Mitsubishi Chemical Corporation, METHYL SILICATE 51 (tetramethoxysilane average tetramer), METHYL SILICATE 53 (tetramethoxysilane average heptamer), ETHYL SILICATE 40 (tetraethoxysilane average pentamer) and ETHYL SILICATE 48 (tetraethoxysilane average decamer) manufactured by Colcoat Co., Ltd., and the like.

For example, in a case where the silicon compound (A) is a silicon compound that is formed from either one or both of the silsesquioxane groups represented by formula (1) or (2) and from either one or both of the structural unit among the siloxane groups represented by formula (6) or (7), and that has a weight average molecular weight of 3,000-1,000,000, the crosslinkable group is preferably any of formulas (12)-(17) bound to Si.

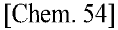

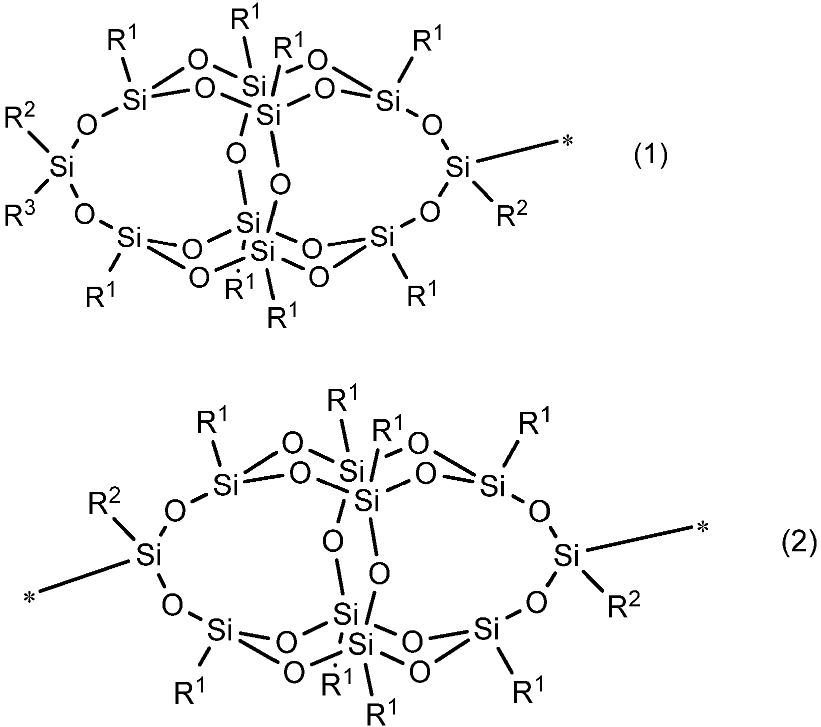

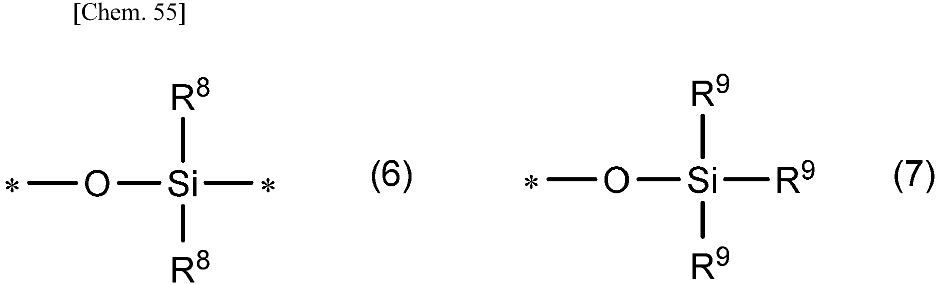

Formulas (1), (2), (6) and (7) are the same as those described in the section <silicon compound (A)>.

As specific examples of preferable crosslinking agents, crosslinking agents having one or more structures of (C-1)-(C-4) in which, in the same formulas, at least two R^{C1,}s are preferably any of formulas (12)-(17).

More specific examples of the preferable crosslinking agents include 1,3-dimethoxytetramethyldisiloxane, 1,5-dimethoxyhexamethyltrisiloxane, polydimethylsiloxane with dimethylmethoxysiloxy blocked at both molecular chain ends, polymethylphenylsiloxane with dimethylmethoxysiloxy blocked at both molecular chain ends, polydiphenylsiloxane with dimethylmethoxysiloxy blocked at both molecular chain ends, dimethylsiloxane/dimethoxysiloxane copolymers with dimethylmethoxysiloxy blocked at both molecular chain ends, methylphenylsiloxane/dimethoxysiloxane copolymers with dimethylmethoxysiloxy blocked at both molecular chain ends, diphenylsiloxane/dimethoxysiloxane copolymers with dimethylmethoxysiloxy blocked at both molecular chain ends, polydimethylsiloxane with trimethoxysiloxy blocked at both molecular chain ends, polymethylphenylsiloxane with trimethoxysiloxy blocked at both molecular chain ends, polydiphenylsiloxane with trimethoxysiloxy blocked at both molecular chain ends, dimethylsiloxane/dimethoxysiloxane copolymers with trimethoxysiloxy blocked at both molecular chain end, methylphenylsiloxane/dimethoxysiloxane copolymers with trimethoxysiloxy blocked at both molecular chain ends, diphenylsiloxane/dimethoxysiloxane copolymers with trimethoxysiloxy blocked at both molecular chain ends;
1,3-diethoxytetramethyldisiloxane, 1,5-diethoxyhexamethyltrisiloxane, polydimethylsiloxane with dimethylethoxysiloxy blocked at both molecular chain ends, polymethylphenylsiloxane with dimethylethoxysiloxy blocked at both molecular chain ends, polydiphenylsiloxane with dimethylethoxysiloxy blocked at both molecular chain ends, dimethylsiloxane/diethoxysiloxane copolymers with dimethylethoxysiloxy blocked at both molecular chain ends, methylphenylsiloxane/diethoxysiloxane copolymers with dimethylethoxysiloxy blocked at both molecular chain ends, diphenylsiloxane/diethoxysiloxane copolymers with dimethylethoxysiloxy blocked at both molecular chain ends, polydimethylsiloxane with triethoxysiloxy blocked at both molecular chain ends, polymethylphenylsiloxane with triethoxysiloxy blocked at both molecular chain ends, polydiphenylsiloxane with triethoxysiloxy blocked at both molecular chain ends, dimethylsiloxane/diethoxy siloxane copolymers with triethoxysiloxy blocked at both molecular chain ends, methylphenylsiloxane/diethoxysiloxane copolymers with triethoxysiloxy blocked at both molecular chain ends, diphenylsiloxane/diethoxysiloxane copolymers with triethoxysiloxy blocked at both molecular chain ends;
1,3-dihydroxytetramethyldisiloxane, 1,5-dihydroxyhexamethyltrisiloxane, 1,5-dihydroxyhexaphenyltrisiloxane, polydimethylsiloxane with dimethylhydroxysiloxy blocked at both molecular chain ends, polymethylphenylsiloxane with dimethylhydroxysiloxy blocked at both molecular chain ends, polydiphenylsiloxane with dimethylhydroxysiloxy blocked at both molecular chain ends, dimethylsiloxane/dihydroxysiloxane copolymers with dimethylhydroxysiloxy blocked at both molecular chain ends, methylphenylsiloxane/dihydroxysiloxane copolymers with dimethylhydroxysiloxy blocked at both molecular chain ends, diphenylsiloxane/dihydroxysiloxane copolymers with dimethylhydroxysiloxy blocked at both molecular chain ends, polydimethylsiloxane with trihydroxysiloxy blocked at both molecular chain ends, polymethylphenylsiloxane with trihydroxysiloxy blocked at both molecular chain ends, polydiphenylsiloxane with trihydroxysiloxy blocked at both molecular chain ends, dimethylsiloxane/dihydroxy siloxane copolymers with trihydroxysiloxy blocked at both molecular chain ends, methylphenylsiloxane/dihydroxysiloxane copolymers with trihydroxysiloxy blocked at both molecular chain ends, diphenylsiloxane/dihydroxysiloxane copolymers with trihydroxysiloxy blocked at both molecular chain ends;
1,1,3,3-tetramethyldisiloxane, 1,1,3,3,5,5-hexamethyltrisiloxane, polydimethylsiloxane with dimethylhydrogensiloxy blocked at both molecular chain ends, polymethylphenylsiloxane with dimethylhydrogensiloxy blocked at both molecular chain ends, polydiphenylsiloxane with dimethylhydrogensiloxy blocked at both molecular chain ends, dimethylsiloxane/dihydrogensiloxane copolymers with dimethylhydrogensiloxy blocked at both molecular chain ends, methylphenylsiloxane/dihydrogensiloxane copolymers with dimethylhydrogensiloxane blocked at both molecular chain ends, diphenylsiloxane/dihydrogensiloxane copolymers with dimethylhydrogensiloxy blocked at both molecular chain ends, polydimethylsiloxane with trihydrogensiloxy blocked at both molecular chain ends, polymethylphenylsiloxane with trihydrogensiloxy blocked at both molecular chain ends, polydiphenylsiloxane with trihydrogensiloxy blocked at both molecular chain ends, dimethylsiloxane/dihydrogensiloxane copolymers with trihydrogensiloxy blocked at both molecular chain ends, methylphenylsiloxane/dihydrogensiloxane copolymers with trihydrogensiloxy blocked at both molecular chain ends, diphenylsiloxane/dihydrogensiloxane copolymers with trihydrogensiloxy blocked at both molecular chain ends;
methyltrimethoxysilane, methyltriethoxysilane, phenyltrimethoxysilane, phenyltriethoxysilane, tetramethoxysilane, partially condensed tetramethoxysilane, tetraethoxysilane, partially condensed tetraethoxysilane;
copolymers that are formed from a (CH₃)₂(OCH₃)SiO_{1/2} unit, a (CH₃)₂SiO_{2/2} unit and a SiO_{4/2} unit, copolymers that are formed from a (CH₃)₃SiO_{1/2} unit, a (CH₃)₂SiO_{2/2} unit, a (CH₃)(OCH₃)SiO_{2/2} unit and a (CH₃)SiO_{3/2} unit, copolymers that are formed from a (CH₃)₂(OCH₃)SiO_{1/2} unit, a (CH₃)₂SiO_{2/2} unit and a (CH₃)SiO_{3/2} unit, copolymers that are formed from a (CH₃)₂(OCH₃)SiO_{1/2} unit, a (CH₃)₂SiO_{2/2} unit, a (C₆H₅)₂SiO₂/₂ unit and a (CH₃)SiO_{3/2} unit;
copolymers that are formed from a (CH₃)₂(OC₂H₅)SiO_{1/2} unit, a (CH₃)₂SiO_{2/2} unit and a SiO_{4/2} unit, copolymers that are formed from a (CH₃)₃SiO_{1/2} unit, a (CH₃)₂SiO_{2/2} unit, a (CH₃)(OC₂H₅)SiO_{2/2} unit and a (CH₃)SiO_{3/2} unit, copolymers that are formed from a (CH₃)₂(OC₂H₅)SiO_{1/2} unit, a (CH₃)₂SiO_{2/2} unit and a (CH₃)SiO_{3/2} unit, copolymers that are formed from a (CH₃)₂(OC2H₅)SiO_{1/2} unit, a (CH₃)₂SiO_{2/2} unit, a (C₆H₅)₂SiO₂/₂ unit and a (CH₃)SiO_{3/2} unit,
copolymers that are formed from a (CH₃)₂SiO_{1/2} unit, a (CH₃)₂SiO_{2/2} unit and a SiO_{4/2} unit, copolymers that are formed from a (CH₃)₃SiO_{1/2} unit, a (CH₃)₂SiO_{2/2} unit, a (CH₃)(OH)SiO_{2/2} unit and a (CH₃)SiO_{3/2} unit, copolymers that are formed from a (CH₃)₂(OH)SiO_{1/2} unit, a (CH₃)₂SiO_{2/2} unit and a (CH₃)SiO_{3/2} unit, copolymers that are formed from a (CH₃)₂(OH)SiO_{1/2} unit, a (CH₃)₂SiO_{2/2} unit, a (C₆H₅)₂SiO₂/₂ unit and a (CH₃)SiO_{3/2} unit;
copolymers that are formed from a (CH₃)₂HsiO_{1/2} unit, a (CH₃)₂SiO_{2/2} unit and a SiO_{4/2} unit, copolymers that are formed from a (CH₃)₃SiO_{1/2} unit, a (CH₃)₂SiO_{2/2} unit, a (CH₃)HsiO_{2/2} unit and a (CH₃)SiO_{3/2} unit, copolymers that are formed from a (CH₃)₂HsiO_{1/2} unit, a (CH₃)₂SiO_{2/2} unit and a (CH₃)SiO_{3/2} unit, copolymers that are formed from a (CH₃)₂HsiO_{1/2} unit, a (CH₃)₂SiO_{2/2} unit, a (C₆H₅)₂SiO₂/₂ unit and a (CH₃)SiO_{3/2} unit and the like.

The number of the kinds of the crosslinking agents (C) may be one or plural.

As the content of the crosslinking agent (C), (the number of the crosslinkable groups in the crosslinking agent (C))/(the number of the crosslinkable functional groups in the silicon compound (A)) is preferably 0.1-40, more preferably 0.3-35 and particularly preferably 0.5-30.

In addition, for example, in a case where the silicon compound (A) is a silicon compound that is formed from either one or both of the silsesquioxane groups represented by formula (1) or (2) and from at least one siloxane groups represented by formulas (18)-(20), and that has a weight average molecular weight of 3,000-1,000,000, the crosslinkable group is preferably any of formulas (12)-(17) or (31) bound to Si.

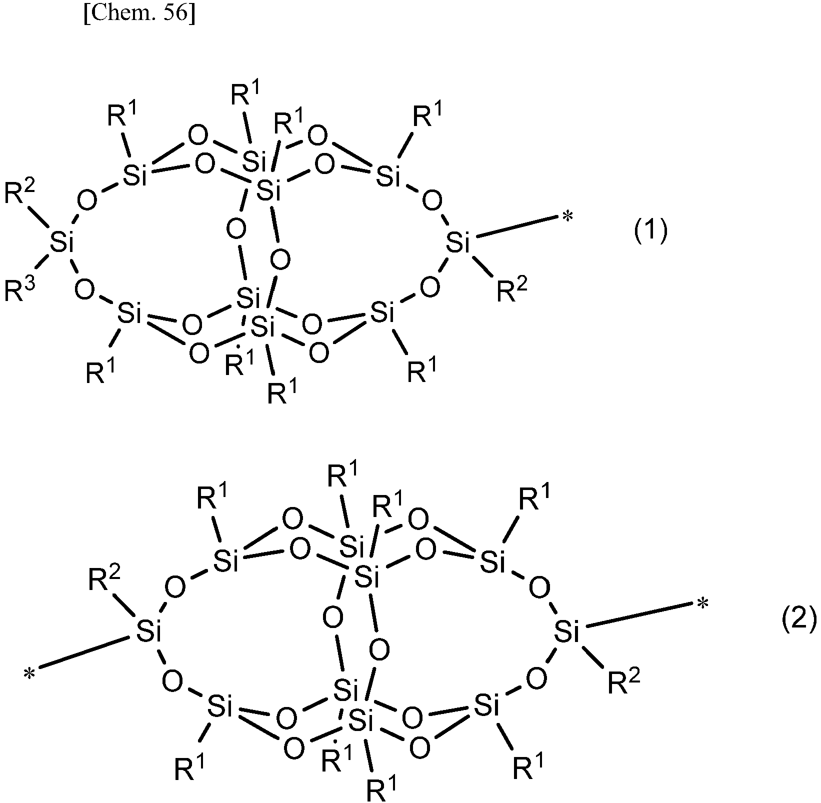

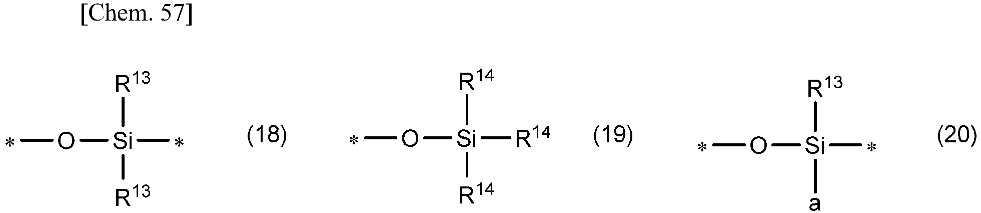

In formulas (1), (2) and (18)-(20), a's are the same as those described in the section <silicon compound (A)>.

As specific examples of preferable crosslinking agents, crosslinking agents having one or more structures of (C-1)-(C-4) in which, in the same formulas, at least two R^{C1,}s are preferably any of formulas (12)-(17) or (31).

More specific examples of the crosslinking agent (C) include 1,3-dimethoxytetramethyldisiloxane, 1,5-dimethoxyhexamethyltrisiloxane, polydimethylsiloxane with dimethylmethoxysiloxy blocked at both molecular chain ends, polymethylphenylsiloxane with dimethylmethoxysiloxy blocked at both molecular chain ends, polydiphenylsiloxane with dimethylmethoxysiloxy blocked at both molecular chain ends, dimethylsiloxane/dimethoxysiloxane copolymers with dimethylmethoxysiloxy blocked at both molecular chain ends, methylphenylsiloxane/dimethoxysiloxane copolymers with dimethylmethoxysiloxy blocked at both molecular chain ends, diphenylsiloxane/dimethoxysiloxane copolymers with dimethylmethoxysiloxy blocked at both molecular chain ends, polydimethylsiloxane with methyldimethoxysiloxy blocked at both molecular chain ends, polymethylphenylsiloxane with methyldimethoxysiloxy blocked at both molecular chain ends, polydiphenylsiloxane with methyldimethoxysiloxy blocked at both molecular chain ends, dimethylsiloxane/dimethoxysiloxane copolymers with methyldimethoxysiloxy blocked at both molecular chain ends, methylphenylsiloxane/dimethoxysiloxane copolymers with methyldimethoxysiloxy blocked at both molecular chain ends, diphenylsiloxane/dimethoxysiloxane copolymers with methyldimethoxysiloxy blocked at both molecular chain ends, polydimethylsiloxane with trimethoxysiloxy blocked at both molecular chain ends, polymethylphenylsiloxane with trimethoxysiloxy blocked at both molecular chain ends, polydiphenylsiloxane with trimethoxysiloxy blocked at both molecular chain ends, dimethylsiloxane/dimethoxysiloxane copolymers with trimethoxysiloxy blocked at both molecular chain end, methylphenylsiloxane/dimethoxysiloxane copolymers with trimethoxysiloxy blocked at both molecular chain ends, diphenylsiloxane/dimethoxysiloxane copolymers with trimethoxysiloxy blocked at both molecular chain ends;
1,3-diethoxytetramethyldisiloxane, 1,5-diethoxyhexamethyltrisiloxane, polydimethylsiloxane with dimethylethoxysiloxy blocked at both molecular chain ends, polymethylphenylsiloxane with dimethylethoxysiloxy blocked at both molecular chain ends, polydiphenylsiloxane with dimethylethoxysiloxy blocked at both molecular chain ends, dimethylsiloxane/diethoxysiloxane copolymers with dimethylethoxysiloxy blocked at both molecular chain ends, methylphenylsiloxane/diethoxysiloxane copolymers with dimethylethoxysiloxy blocked at both molecular chain ends, diphenylsiloxane/diethoxysiloxane copolymers with dimethylethoxysiloxy blocked at both molecular chain ends, polydimethylsiloxane with triethoxysiloxy blocked at both molecular chain ends, polymethylphenylsiloxane with triethoxysiloxy blocked at both molecular chain ends, polydiphenylsiloxane with triethoxysiloxy blocked at both molecular chain ends, dimethylsiloxane/diethoxy siloxane copolymers with triethoxysiloxy blocked at both molecular chain ends, methylphenylsiloxane/diethoxysiloxane copolymers with triethoxysiloxy blocked at both molecular chain ends, diphenylsiloxane/diethoxysiloxane copolymers with triethoxysiloxy blocked at both molecular chain ends;
1,3-dihydroxytetramethyldisiloxane, 1,5-dihydroxyhexamethyltrisiloxane, 1,5-dihydroxyhexaphenyltrisiloxane, polydimethylsiloxane with dimethylhydroxysiloxy blocked at both molecular chain ends, polymethylphenylsiloxane with dimethylhydroxysiloxy blocked at both molecular chain ends, polydiphenylsiloxane with dimethylhydroxysiloxy blocked at both molecular chain ends, dimethylsiloxane/dihydroxysiloxane copolymers with dimethylhydroxysiloxy blocked at both molecular chain ends, methylphenylsiloxane/dihydroxysiloxane copolymers with dimethylhydroxysiloxy blocked at both molecular chain ends, diphenylsiloxane/dihydroxysiloxane copolymers with dimethylhydroxysiloxy blocked at both molecular chain ends, polydimethylsiloxane with methyldihydroxysiloxy blocked at both molecular chain ends, polymethylphenylsiloxane with methyldihydroxysiloxy blocked at both molecular chain ends, polydiphenylsiloxane with methyldihydroxysiloxy blocked at both molecular chain ends, dimethylsiloxane/dihydroxysiloxane copolymers with methyldihydroxysiloxy blocked at both molecular chain ends, methylphenylsiloxane/dihydroxysiloxane copolymers with methyldihydroxysiloxy blocked at both molecular chain ends, diphenylsiloxane/dihydroxysiloxane copolymers with methyldihydroxysiloxy blocked at both molecular chain ends, polydimethylsiloxane with trihydroxysiloxy blocked at both molecular chain ends, polymethylphenylsiloxane with trihydroxysiloxy blocked at both molecular chain ends, polydiphenylsiloxane with trihydroxysiloxy blocked at both molecular chain ends, dimethylsiloxane/dihydroxy siloxane copolymers with trihydroxysiloxy blocked at both molecular chain ends, methylphenylsiloxane/dihydroxysiloxane copolymers with trihydroxysiloxy blocked at both molecular chain ends, diphenylsiloxane/dihydroxysiloxane copolymers with trihydroxysiloxy blocked at both molecular chain ends;
1,3-divinyltetramethyldisiloxane, 1,5-divinylhexamethyltrisiloxane, polydimethylsiloxane with dimethylvinylsiloxy blocked at both molecular chain ends, polymethylphenylsiloxane with dimethylvinylsiloxy blocked at both molecular chain ends, polydiphenylsiloxane with dimethylvinylsiloxy blocked at both molecular chain ends, dimethylsiloxane/divinylsiloxane copolymers with dimethylvinylsiloxy blocked at both molecular chain ends, methylphenylsiloxane/divinylsiloxane copolymers with dimethylvinylsiloxy blocked at both molecular chain ends, diphenylsiloxane/divinylsiloxane copolymers with dimethylvinylsiloxy blocked at both molecular chain ends, polydimethylsiloxane with trivinylsiloxy blocked at both molecular chain ends, polymethylphenylsiloxane with trivinylsiloxy blocked at both molecular chain ends, polydiphenylsiloxane with trivinylsiloxy blocked at both molecular chain ends, dimethylsiloxane/divinylsiloxane copolymers with trivinylsiloxy blocked at both molecular chain ends, methylphenylsiloxane/divinylsiloxane copolymers with trivinylsiloxy blocked at both molecular chain ends, diphenylsiloxane/divinylsiloxane copolymers with trivinylsiloxy blocked at both molecular chain ends;
1,1,3,3-tetramethyldisiloxane, 1,1,3,3,5,5-hexamethyltrisiloxane, polydimethylsiloxane with dimethylhydrogensiloxy blocked at both molecular chain ends, polymethylphenylsiloxane with dimethylhydrogensiloxy blocked at both molecular chain ends, polydiphenylsiloxane with dimethylhydrogensiloxy blocked at both molecular chain ends, dimethylsiloxane/dihydrogensiloxane copolymers with dimethylhydrogensiloxy blocked at both molecular chain ends, methylphenylsiloxane/dihydrogensiloxane copolymers with dimethylhydrogensiloxane blocked at both molecular chain ends, diphenylsiloxane/dihydrogensiloxane copolymers with dimethylhydrogensiloxy blocked at both molecular chain ends, polydimethylsiloxane with trihydrogensiloxy blocked at both molecular chain ends, polymethylphenylsiloxane with trihydrogensiloxy blocked at both molecular chain ends, polydiphenylsiloxane with trihydrogensiloxy blocked at both molecular chain ends, dimethylsiloxane/dihydrogensiloxane copolymers with trihydrogensiloxy blocked at both molecular chain ends, methylphenylsiloxane/dihydrogensiloxane copolymers with trihydrogensiloxy blocked at both molecular chain ends, diphenylsiloxane/dihydrogensiloxane copolymers with trihydrogensiloxy blocked at both molecular chain ends;
copolymers that are formed from a (CH₃)₂(OCH₃)SiO_{1/2} unit, a (CH₃)₂SiO_{2/2} unit and a SiO_{4/2} unit, copolymers that are formed from a (CH₃)₃SiO_{1/2} unit, a (CH₃)₂SiO_{2/2} unit, a (CH₃)(OCH₃)SiO_{2/2} unit and a (CH₃)SiO_{3/2} unit, copolymers that are formed from a (CH₃)₂(OCH₃)SiO_{1/2} unit, a (CH₃)₂SiO_{2/2} unit and a (CH₃)SiO_{3/2} unit, copolymers that are formed from a (CH₃)₂(OCH₃)SiO_{1/2} unit, a (CH₃)₂SiO_{2/2} unit, a (C₆H₅)₂SiO₂/₂ unit and a (CH₃)SiO_{3/2} unit;
copolymers that are formed from a (CH₃)₂(OC₂H₅)SiO_{1/2} unit, a (CH₃)₂SiO_{2/2} unit and a SiO_{4/2} unit, copolymers that are formed from a (CH₃)₃SiO_{1/2} unit, a (CH₃)₂SiO_{2/2} unit, a (CH₃)(OC₂H₅)SiO_{2/2} unit and a (CH₃)SiO_{3/2} unit, copolymers that are formed from a (CH₃)₂(OC₂H₅)SiO_{1/2} unit, a (CH₃)₂SiO_{2/2} unit and a (CH₃)SiO_{3/2} unit, copolymers that are formed from a (CH₃)₂(OC₂H₅)SiO_{1/2} unit, a (CH₃)₂SiO_{2/2} unit, a (C₆H₅)₂SiO₂/₂ unit and a (CH₃)SiO_{3/2} unit,
copolymers that are formed from a (CH₃)₂SiO_{1/2} unit, a (CH₃)₂SiO_{2/2} unit and a SiO_{4/2} unit, copolymers that are formed from a (CH₃)₃SiO_{1/2} unit, a (CH₃)₂SiO_{2/2} unit, a (CH₃)(OH)SiO_{2/2} unit and a (CH₃)SiO_{3/2} unit, copolymers that are formed from a (CH₃)₂(OH)SiO_{1/2} unit, a (CH₃)₂SiO_{2/2} unit and a (CH₃)SiO_{3/2} unit, copolymers that are formed from a (CH₃)₂(OH)SiO_{1/2} unit, a (CH₃)₂SiO_{2/2} unit, a (C₆H₅)₂SiO₂/₂ unit and a (CH₃)SiO_{3/2} unit;
copolymers that are formed from a (CH₃)₂(CH=CH₂)SiO_{1/2} unit, a (CH₃)₂SiO_{2/2} unit and a SiO_{4/2} unit, copolymers that are formed from a (CH₃)₃SiO_{1/2} unit, a (CH₃)₂SiO_{2/2} unit, a (CH₃)(CH=CH₂)SiO_{2/2} unit and a (CH₃)SiO_{3/2} unit, copolymers that are formed from a (CH₃)₂(CH=CH₂)SiO_{1/2} unit, a (CH₃)₂SiO_{2/2} unit and a (CH₃)SiO_{3/2} unit, copolymers that are formed from a (CH₃)₂(CH=CH₂)SiO_{1/2} unit, a (CH₃)₂SiO_{2/2} unit, a (C₆H₅)₂SiO₂/₂ unit and a (CH₃)SiO_{3/2} unit;
copolymers that are formed from a (CH₃)₂HsiO_{1/2} unit, a (CH₃)₂SiO_{2/2} unit and a SiO_{4/2} unit, copolymers that are formed from a (CH₃)₃SiO_{1/2} unit, a (CH₃)₂SiO_{2/2} unit, a (CH₃)HsiO_{2/2} unit and a (CH₃)SiO_{3/2} unit, copolymers that are formed from a (CH₃)₂HsiO_{1/2} unit, a (CH₃)₂SiO_{2/2} unit and a (CH₃)SiO_{3/2} unit, copolymers that are formed from a (CH₃)₂HsiO_{1/2} unit, a (CH₃)₂SiO_{2/2} unit, a (C₆H₅)₂SiO₂/₂ unit and a (CH₃)SiO_{3/2} unit, each of the above-exemplified compounds in which part or all of methyl groups have been substituted with other alkyl groups such as an ethyl group or a propyl group or aryl groups such as a phenyl group;
methyltrimethoxysilane, methyltriethoxysilane, phenyltrimethoxysilane, phenyltriethoxysilane, tetramethoxysilane, partially condensed tetramethoxysilane, tetraethoxysilane, partially condensed tetraethoxysilane, vinyltrimethoxysilane;

The number of the kinds of the crosslinking agents (C) may be one or plural.

As the content of the crosslinking agent (C), (the number of the crosslinkable groups in the crosslinking agent)/(the number of the crosslinkable functional groups in the silicon compound (A)) is preferably 0-40, more preferably 0-35 and particularly preferably 0-30.

### <Catalyst (D)>

The curable resin composition of the present invention may contain a catalyst (D). The catalyst (D) is capable of accelerating a chemical reaction between the crosslinkable functional groups in the silicon compound (A) or accelerating a chemical reaction between the silicon compound (A) and the crosslinking agent (C) at the time of, for example, chemically reacting the silicon compounds (A).

The catalyst (D) of the present invention is not particularly limited as long as the catalyst acts on the above-described chemical reaction.

Examples thereof include catalyst having any one or more of Sn, Zr, Ti, Al, N and Pt.

Examples of the catalyst containing Sn include dibutyltin dilaurate, dioctyltin dilaurate, dibutyltin diacetate, dioctyltin diacetate, dibutyltin maleate, dioctyltin maleate, tin 2-ethylhexanoate and the like.

Examples of the catalyst containing Zr include normal propyl zirconate, normal butyl zirconate, zirconium tetraacetylacetonate, zirconium monoacetylacetonate and the like.

Examples of the catalyst containing Ti include tetraisopropyl titanate, tetra-n-butyl titanate, butyl titanate dimer, tetraoctyl titanate, titanium acetylacetonate, titanium tetraacetylacetonate, titanium ethylacetoacetate, titanium dodecylbenzenesulfonic acid compounds, phosphate ester titanium complexes, titanium octylene glycolate, titanium ethyl acetoacetate, titanium lactate ammonium salt, titanium lactate, titanium triethanolaminate and the like.

Examples of the catalyst containing Al include aluminum secondary butoxide, aluminum trisacetylacetonate, aluminum bisethylacetoacetate monoacetylacetonate, aluminum trisethylacetoacetate and the like.

Examples of the catalyst containing N include silazanes such as trimethylsilylamine, bis(trimethylsilyl)amine, tris(trimethylsilyl)amine, methyldiphenylsilylamine, bis(methyldiphenylsilyl)amine and tris(methyldiphenylsilyl)amine;
cyclic silazanes such as hexamethylcyclotrisilazane, octamethylcyclotetrasilazane, decamethylcyclopentasilazane, trimethyltriphenylcyclotrisilazane, tetramethyltetraphenylcyclotetrasilazane, pentamethylpentaphenylcyclopentasilazane, hexaphenylcyclotrisilazane, octaphenylcyclotetrasilazane and decafenylcyclopentasilazane;
inorganic polysilazanes such as perhydropolysilazane and organic polysilazanes such as methylpolysilazane;
organic guanidines such as aminoguanidine, 1,1,3,3-tetramethylguanidine, n-dodecylguanidine, methylolguanidine, dimethylolguanidine, 1-phenylguanidine, 1,3-diphenylguanidine, 1,3-di-o-tolylguanidine, triphenylguanidine and 1-benzyl-2,3-dimethylcyanoguanidine;
alkylimidazoles such as 2-ethyl-4-methylimidazole, 1-methylimidazole, 1,2-dimethylimidazole, 2-methylimidazole, 2-ethylimidazole, 2-undecylimidazole, 2-heptadecylimidazole and 2-isopropylimidazole, carbamylalkyl-substituted imidazoles such as 1-(2-carbamylethyl)imidazole, cyanoalkyl-substituted imidazoles such as 1-cyanoethyl-2-methylimidazole, aromatic substituted imidazoles such as 2-phenylimidazole, 2-phenyl-4-methyl imidazole and 1-benzyl-2-methylimidazole, alkenyl-substituted imidazoles such as 1-vinyl-2-methylimidazole, allyl-substituted imidazoles such as 1-allyl-2-ethyl-4-methylimidazole, and imidazoles such as polyimidazole;
furthermore, dicyandiamide, 1,8-diazabicyclo[5.4.0]82ndecane-7 (DBU), 1,5-diazabicyclo[4.3.0]nonene-5, 2-ethylhexanoate of the above DBU, formate of the above DBU, o-phthalate of the above DBU, p-toluenesulfonate of the above DBU, phenol novolac resin salts of the above DBU, trimellitate of the above DBU;
additionally, ketimine that is a reactant of a polyamine and a carbonyl compound. Examples of the polyamine include diamines such as ethylenediamine, propylenediamine, trimethylenediamine, tetramethylenediamine, 1,3-diaminobutane, 2,3-diaminobutane, pentamethylenediamine, 2,4-diaminopentane, hexamethylenediamine, p-phenylenediamine and p,p'-biphenylenediamine; polyvalent amines such as 1,2,3-triaminopropane, triaminobenzene, tris(2-aminoethyl)amine and tetra(aminomethyl)methane; polyalkylene polyamines such as diethylenetriamine, triethylenetriamine and tetraethylenepentamine; polyoxyalkylene-based polyamines, and examples of the carbonyl compound include aldehydes such as acetaldehyde, propionaldehyde, n-butyraldehyde, isobutyraldehyde, diethylacetaldehyde, glyoxal and benzaldehyde; cyclic ketones such as cyclopentanone, trimethylcyclopentanone, cyclohexanone and trimethylcyclohexanone; aliphatic ketones such as acetone, methyl ethyl ketone, methyl propyl ketone, methyl isopropyl ketone, methyl isobutyl ketone, diethyl ketone, dipropyl ketone, diisopropyl ketone, dibutyl ketone and diisobutyl ketone; β-dicarbonyl compounds such as acetylacetone, methyl acetoacetate, ethyl acetoacetate, dimethyl malonate, diethyl malonate, methylethyl malonate and dibenzoylylmethane.

Examples of the catalyst containing Pt include platinum-based compounds such as platinum fine powder, platinum black, platinum-supported silica fine powder, platinum-supported activated carbon, chloroplatinic acid, alcoholic solutions of chloroplatinic acid, platinum olefin complexes and platinum alkenylsiloxane complexes. Examples of alkenylsiloxanes include 1,3-divinyl-1,1,3,3-tetramethyldisiloxane, 1,3,5,7-tetramethyl-1,3,5,7-tetravinylcyclotetrasiloxane, alkenylsiloxanes in which some of methyl of these alkenylsiloxanes is substituted with ethyl, phenyl or the like and alkenylsiloxanes in which vinyl of these alkenylsiloxanes is substituted with allyl, hexenyl or the like.

Among these, dibutyltin dilaurate, normal propyl zirconate, normal butyl zirconate, zirconium tetraacetylacetonate, zirconium monoacetylacetonate, titanium acetylacetonate, titanium tetraacetylacetonate, titanium ethylacetoacetate, aluminum trisacetylacetonate, aluminum bisethylacetoacetate monoacetylacetonate, aluminum trisethylacetoacetate, 1,3-divinyl-1,1,3,3-tetramethyldisiloxane complexes of platinum, 1,3,5,7-tetramethyl- 1,3,5,7-tetravinylcyclotetrasiloxane complexes of platinum, alkenylsiloxanes in which some of methyl of these alkenylsiloxanes is substituted with ethyl, phenyl or the like and alkenylsiloxanes in which vinyl of these alkenylsiloxanes is substituted with allyl, hexenyl or the like are preferable.

The number of the kinds of the catalysts (D) may be one or plural.

The content of the catalyst (D) is preferably 0.00001-20 parts by weight, more preferably 0.00003-15 parts by weight and particularly preferably 0.00005-10 parts by weight with respect to 100 parts by weight of the silicon compound (A) and the crosslinking agent (C).

### <Different component>

The curable resin composition of the present invention may also contain a different component other than the above-described (A)-(D) components. Examples of the other component include other organopolisiloxane other than the silicon compound (A) and the crosslinking agent (C), a curing retarder, an adhesion agent, a filler, an ion scavenger, a surfactant, a flame retardant, an ultraviolet absorber, a light stabilizer, an antioxidant, a solvent and the like.

### <Other organopolisiloxane other than silicon compound (A) and crosslinking agent (C)>

The curable resin composition of the present invention may contain other organopolisiloxane other than the silicon compound (A) and the crosslinking agent (C).

The other organopolisiloxane is a compound having at least one structure of formulas (E-1)-(E-4) and does not have a group that crosslinks with the silicon compound (A).

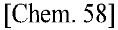

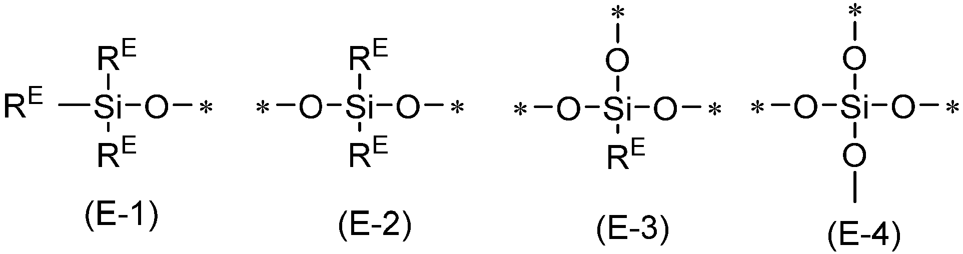

In formulas (E-1)-(E-4), R^{E,}s independently represent alkyl such as methyl, ethyl, propyl, isopropyl, butyl, isobutyl, tert-butyl, pentyl, neopentyl, hexyl, cyclohexyl, octyl, nonyl and decyl, aryl such as phenyl, tolyl, xylyl and naphthyl, aralkyl such as benzyl, phenylethyl and phenylpropyl, or the above-described group in which part or all of hydrogen atoms have been substituted with halogen atoms such as fluorine, bromine or chlorine, cyano groups or the like, for example, chloromethyl, chloropropyl, bromoethyl, trifluoropropyl, cyanoethyl and the like.

The structure of the other organopolisiloxane may be a linear structure or may be a partially branched structure, a cyclic structure or the like.

Examples of commercially available products thereof include KF-96L, KF-96A, KF-96, KF-96H, KF-50, KF-54, KF-965, KF-968, KF-410, KF-412 (all trade names) manufactured by Shin-Etsu Chemical Co., Ltd., TSF451-0.65, TSF451-5A, TSF451-10, TSF451-100 (all trade names) manufactured by Momentive, WACKER (registered trademark) SILICONE FLUID AK0.65-10, WACKER (registered trademark) SILICONE FLUID AK20-5,000, WACKER (registered trademark) SILICONE FLUID AS 100, WACKER (registered trademark) L053, WACKER (registered trademark) L060, WACKER (registered trademark) MQ803 (all trade names) manufactured by Wacker Asahikasei Silicone Co., Ltd. And the like.

The content of the other organopolisiloxane is 0.1-30 parts by weight, preferably 0.5-25 parts by weight and more preferably 1-20 parts by weight with respect to 100 parts by weight of the total weight of the silicon compound (A), the compound (B) having any one or more elements of Ce, La, Pr, Nd, Y and Fe, the crosslinking agent (C) and the catalyst (D) in the curable resin composition of the present invention.

### <Curing retarder>

The curable resin composition of the present invention may contain a curing retarder from the viewpoint of the preservation stability.

As the curing retarder, for example, well-known curing retarders that are used in addition-type curable compositions by a hydrosilylation catalyst can be used. Specific examples thereof include compounds containing two or more alkenyls, compounds containing an aliphatic unsaturated bond, organic phosphorus compounds, tin-based compounds and organic peroxides. These may be used singly or two or more thereof may be jointly used.

Examples of the compounds containing two or more alkenyls include disiloxanes and trisiloxanes containing vinyl or allyl at both ends such as 1,3-divinyl-1,1,3,3-tetramethyldisiloxane, 1,3-diallyl-1,1,3,3-tetramethyldisiloxane, 1,3-divinyl-1,3-dimethyl- 1,3-diphenyldisiloxane and 1,3-divinyl-1,1,3,3-tetraphenyldisiloxane, vinyl-containing cyclic siloxanes such as 1,3,5,7-tetravinyltetramethylcyclotetrasiloxane.

The compounds containing two or more alkenyls may also function as the crosslinking agent (C).

Examples of the compounds containing an aliphatic unsaturated bond include propargyl alcohols such as 3-methyl-1-dodecyn-3-ol, 3,5-dimethyl-1-hexyn-3-ol and 1-ethynyl-1-cyclohexanol, en-yne compounds, maleic anhydrides and maleic acid esters such as dimethyl maleate.

Examples of the organic phosphorus compounds include triorganophosphines, diorganophosphines, organophosphones and triorganophosphites.

Examples of the tin-based compounds include stannous halide dihydrate and stannous carboxylate. In addition, examples of the organic peroxides include di-t-butyl peroxide, dicumyl peroxide, benzoyl peroxide and t-butyl perbenzoate.

Among these, 1,3-divinyldisiloxane, 1,3,5,7-tetravinyltetramethylcyclotetrasiloxane or 1-ethynyl-1-cyclohexanol is preferable.

The content of the curing retarder is 250-200,000 times, preferably 500-100,000 times and more preferably 5,000-50,000 times the content (weight) of the catalyst (D).

### <Adhesion agent>

The curable resin composition of the present invention may contain an adhesion agent from the viewpoint of the adhesiveness.

As the adhesion agent, organic silicon compounds having a hydroxyl group, hydrogen bound to Si, alkoxy bound to Si and epoxy are preferable, and organic silicon compounds having at least one or more alkoxy bound to Si are more preferable. Such a compound is capable of performing a binding reaction with a compound such as a base material on which the curable resin composition of the present invention is laminated while performing a crosslinking reaction with other components in the curable resin composition of the present invention and is capable of enhancing the adhesiveness of a cured product to be obtained. Furthermore, the adhesion agent is more preferably an adhesion agent having a silsesquioxane structure from the viewpoint of the heat resistance or the like. Examples of such a suitable adhesion agent include compounds represented by formula (Z). The adhesion agent having a hydroxyl group, hydrogen bound to Si and alkoxy bound to Si may also function as the crosslinking agent (C).

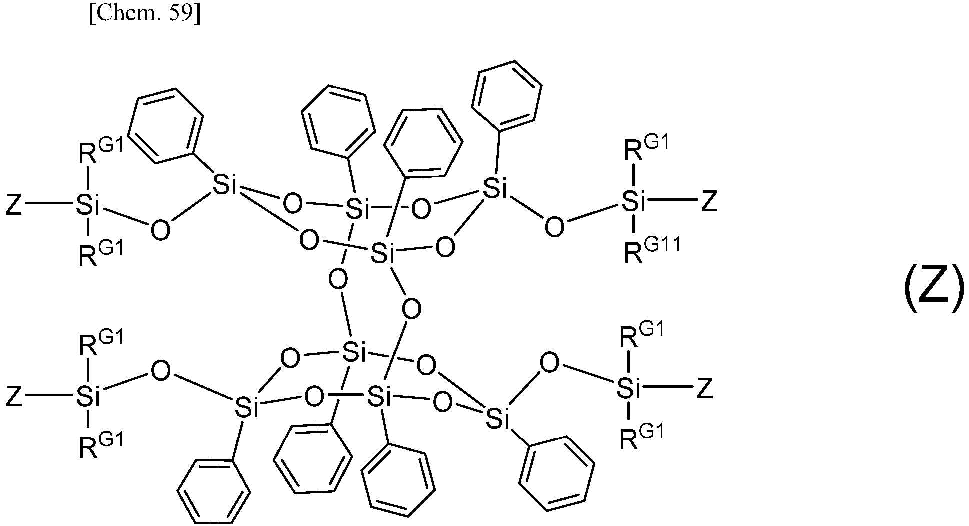

In formula (Z), R^{G1}'s are independently alkyl having 1-4 carbon atoms, cyclopentyl or cyclohexyl. Z's are independently groups represented by formula (Z1), formula (Z2), formula (Z31), formula (Z32), formula (Z33) or formula (Z41). When z₁ is the average number of the groups represented by formula (Z1) per molecule of the compound represented by formula (Z), z₂ is the average number of the groups represented by formula (Z2), z₃ is the average number of the groups represented by formula (Z31), formula (Z32) or formula (Z33), and z₄ is the average number of the groups represented by formula (Z41), z₁ + 2z₂ + z₃ + z₄ = 4w, 0.5w ≤ z₁ ≤ 3w, 0.25w ≤ z₂ ≤ w, 0.1w ≤ z₃ ≤ 2w and 0 ≤ z₄ ≤ w are satisfied. W is an average value satisfying 1-100.

R^{G1} is preferably alkyl and more preferably methyl. Z₁, z₂, z₃ and z₄ each preferably satisfy w ≤ z₁ ≤ 2w, 0.3w ≤ z₂ ≤ w, 0.3w ≤ z₃ ≤ w and 0.3 ≤ z₄ ≤ w. The lower limit of w may be 3 or may be 5. In addition, the upper limit of w may be 30 or may be 15.

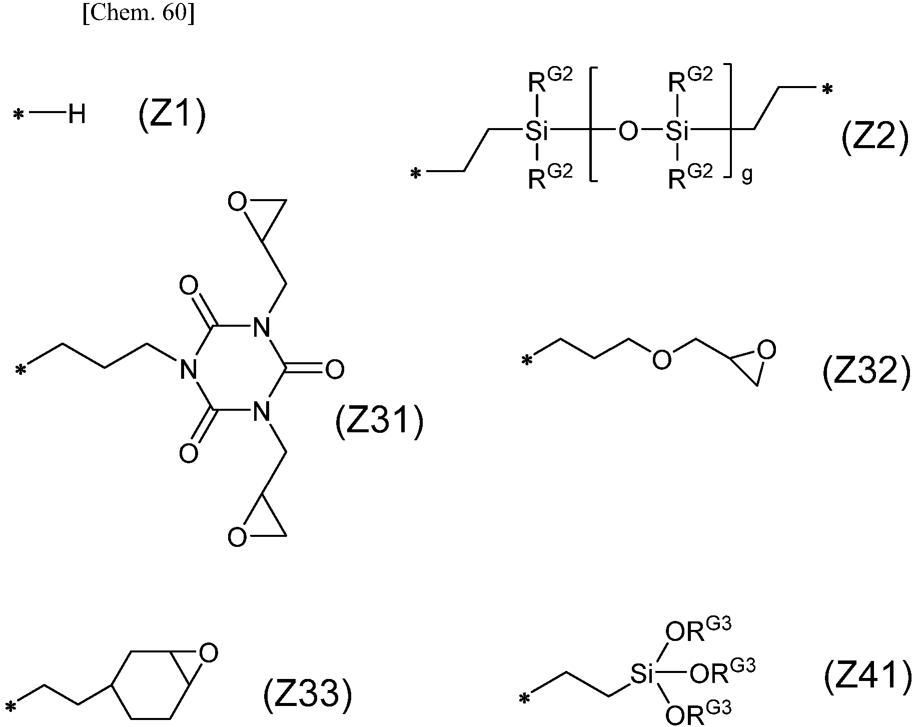

In formula (Z1), formula (Z2), formula (Z31), formula (Z32), formula (Z33) and formula (Z41), * represents a binding part as described above.

In formula (Z2), R^{G2,}s are independently alkyl having 1-4 carbon atoms, cyclopentyl, cyclohexyl or phenyl. G is an average value satisfying 1-20. R^{G2} is preferably alkyl and more preferably methyl.

In formula (Z41), R^{G3,}s are independently methyl, ethyl, butyl or isopropyl. R^{G3} is preferably methyl.

The amount of the adhesion agent added is preferably 0.1-10 parts by weight, preferably 0.3-9 parts by weight and more preferably 0.5-8 parts by weight with respect to 100 parts by weight of the total weight of the silicon compound (A), the compound (B) having any one or more elements of Ce, La, Pr, Nd, Y and Fe, the crosslinking agent (C) and the catalyst (D) in the curable resin composition of the present invention.

### <Filler>

The curable resin composition of the present invention may contain a filler from the viewpoint of the heat resistance, the optical characteristics, the thixotropy or the like.

The filler is not particularly limited, and well-known materials can be used. In addition, the structure of the filler may be amorphous or may form crystals. The combination of fillers is also not limited.

As the filler, for example, a variety of fluorescent substances, metal oxides or the like can be suitably used.

As the fluorescent substances, there are a variety of fluorescent substances such as a fluorescent substance emitting green light, a fluorescent substance emitting blue light, a fluorescent substance emitting yellow light and a fluorescent substances emitting red light. Specific examples of the fluorescent substances that can be used in the curable resin composition of the present invention include well-known fluorescent substances such as organic fluorescent substances, inorganic fluorescent substances, fluorescent pigments and fluorescent dyes. Examples of the organic fluorescent substances include allylsulfamide/melamine formaldehyde co-condensation dyes, perylene-based fluorescent substances and the like, and perylene-based fluorescent substances can be used for a long period of time and are thus preferably used. Fluorescent substances that are particularly preferably used in the present invention are inorganic fluorescent substances. Hereinafter, inorganic fluorescent substances that are used in the present invention will be described.

As the fluorescent substance emitting green light, for example, there are [SrAl₂O₄: Eu], [Y₂SiO₅: Ce, Tb], [MgAl₁₁O₁₉: Ce, Tb], [Sr₇Al₁₂O₂₅: Eu] and [(at least one of Mg, Ca, Sr or Ba)Ga₂S₄: Eu].

As the fluorescent substance emitting blue light, for example, there are [Sr₅(PO₄)₃Cl: Eu], [(SrCaBa)₅(PO₄)₃Cl: Eu], [(BaCa)₅(PO₄)₃Cl: Eu], [(at least one of Mg, Ca, Sr or Ba)₂B₅O₉Cl: Eu, Mn] and [(at least one of Mg, Ca, Sr or Ba)(PO₄)₆Cl₂: Eu, Mn].

As the fluorescent substance emitting green to yellow light, there are yttrium/aluminum oxide fluorescent substances activated with at least cerium, yttrium/gadolinium/aluminum oxide fluorescent substances activated with at least cerium, yttrium/aluminum/garnet oxide fluorescent substances activated with at least cerium, yttrium/gallium/aluminum oxide fluorescent substances activated with at least cerium, and the like (so-called YAG-based fluorescent substances). Specifically, it is possible to use [Ln₃M₅O₁₂: R (Ln is at least one selected from Y, Gd and La, M includes at least any one of Al and Ca, and R is lanthanoid series.)] and [(Y1-xGax)₃(Al1-yGay)₅O₁₂: R (R is at least one selected from Ce, Tb, Pr, Sm, Eu, Dy and Ho, 0 < Rx < 0.5, and 0 < y < 0.5.)].

As the fluorescent substances emitting red light, for example, there are [Y₂O₂S: Eu], [La₂O₂S: Eu], [Y₂O₃: Eu] and [Gd₂O₂S: Eu].

In addition, examples of fluorescent substances that correspond to currently mainstream blue LEDs and emit light include YAG-based fluorescent substances such as [Y₃(Al, Ga)₅O₁₂: Ce, (Y, Gd)₃Al₅O₁₂: Ce, L_{U3}Al₅O₁₂: Ce, Y₃Al₅O₁₂: Ce], TAG-based fluorescent substances such as [Tb₃Al₅O₁₂: Ce], [(Ba, Sr)₂SiO₄: Eu]-based fluorescent substances or [Ca₃Sc₂Si₃O₁₂: Ce]-based fluorescent substances, silicate-based fluorescent substances such as [(Sr, Ba, Mg)₂SiO₄: Eu], nitride-based fluorescent substances such as [(Ca, Sr)₂Si₅N₈: Eu], [(Ca, Sr)AlSiN₃: Eu] and [CaSiAlN₃: Eu], oxynitride-based fluorescent substances such as [Cax(Si, Al)₁₂(O, N)₁₆: Eu], furthermore, [(Ba, Sr, Ca)Si₂O₂N₂: Eu]-based fluorescent substances, [Ca₈MgSi₄O₁₆CL₂: Eu]-based fluorescent substances, [SrAl₂O₄: Eu, Sr₄Al₁₄O₂₅: Eu] fluorescent substances and the like.

Among these, YAG-based fluorescent substances, TAG-based fluorescent substances and silicate-based fluorescent substances are preferably used from the viewpoint of the light emitting efficiency, the brightness or the like. In addition, additionally, well-known fluorescent substances can be used depending on applications or intended colors of light to be emitted.

The amount of the fluorescent substance added is preferably 1-90 parts by weight and more preferably 2-50 parts by weight with respect to 100 parts by weight of the total weight of the silicon compound (A), the compound (B) having any one or more elements of Ce, La, Pr, Nd, Y and Fe, the crosslinking agent (C) and the catalyst (D) in the curable resin composition of the present invention.

Next, a case where the filler is a metal oxide will be described. As the metal oxide, silica, alumina, yttrium oxide, zinc oxide, magnesium oxide, antimony oxide, titanium oxide, zirconium oxide and the like can be suitably used.

The content of the metal oxide in the curable resin composition of the present invention is preferably 1-70 parts by weight, more preferably 1-65 parts by weight and still more preferably 1-60 parts by weight with respect to 100 parts by weight of the total weight of the silicon compound (A), the compound (B) having any one or more elements of Ce, La, Pr, Nd, Y and Fe, the crosslinking agent (C) and the catalyst (D) in the curable resin composition of the present invention.

In the case of using titanium oxide or aluminum oxide in the curable resin composition of the present invention, the curable resin composition can also be suitably used as a material for a reflector. Regarding the material for a reflector, polyphthalamide resins are in wide use. However, polyphthalamide resins are being pointed out to be likely to deteriorate, particularly, discolor due to long-term use, but the curable resin composition of the present invention is capable of solving this problem.

In the case of silica, silica obtained by refining naturally occurring silica stone (natural silica) may be used or industrially synthesized silica (synthetic silica) may be used. Natural silica is crystalline and thus has crystal axes. Therefore, optical characteristics derived from crystals can be expected, but the specific gravity is slightly high compared with that of synthetic silica, and there are thus cases where dispersion in the curable resin composition is affected. In addition, in the case of being obtained by crushing a natural product, natural silica is particles with irregular shapes or a material having a wide particle size distribution in some cases.

As synthesized silica, there are wet-type synthetic silica and dry-type synthetic silica, and there is no particular limitation on use in the present invention. However, synthetic silica has crystal water in some cases regardless of the production method, and, in a case where there is a possibility that the crystal water may have some influence on the curable resin composition of the present invention, a cured product, an electronic component or the like, it is preferable to select synthetic silica in consideration of the number of crystal waters.

Synthetic silica is not crystalline but amorphous and thus does not have any crystal axes and cannot be expected to have optical characteristics derived from crystals. However, it is possible to take advantage of characteristics that the particle distribution can be controlled and the particle diameters can be extremely decreased. In particular, fumed silica has nano-order particle diameters and is excellent in terms of thixotropy.

In addition, ordinarily, silica has a large surface area and is a hydrophilic material (hydrophilic silica) due to the effect of silanol present on the surface, but may be made into hydrophobic silica by chemical modification.

### <Ion scavenger>

The curable resin composition of the present invention may contain an ion scavenger from the viewpoint of the insulation reliability.

The ion scavenger is not particularly limited, and examples thereof include anion ion trappers, cation ion trappers and amphoteric ion trappers. Examples thereof include trade name DHT-4A manufactured by Kyowa Chemical Industry Co., Ltd., IXE 300 series, IXEPLAS-A series and IXEPLAS-B series manufactured by Toagosei Company, Limited. The average particle diameter of the ion scavenger is preferably 0.1-3.0 µm, and the maximum particle diameter is preferably 10 µm or less.

The content of the ion scavenger is preferably 0.1-10 parts by weight and more preferably 0.3-9 parts by weight with respect to 100 parts by weight of the total weight of the silicon compound (A), the compound (B) having any one or more elements of Ce, La, Pr, Nd, Y and Fe, the crosslinking agent (C) and the catalyst (D) in the curable resin composition of the present invention.

### <Surfactant>

The curable resin composition of the present invention may contain a surfactant for the purpose of curbing the paintability to base materials.

Specific examples of the surfactant include POLYFLOW No. 45, POLYFLOW KL-245, POLYFLOW No. 75, POLYFLOW No. 90, POLYFLOW No. 95 (all trade names, manufactured by Kyoeisha Chemical Co., Ltd.), DISPERBYK 161, DISPERBYK 162, DISPERBYK 163, DISPERBYK 164, DISPERBYK 166, DISPERBYK 170, DISPERBYK 180, DISPERBYK 181, DISPERBYK 182, BYK-300, BYK-306, BYK-310, BYK-320, BYK-330, BYK-342, BYK-344, BYK-346 (all trade names, manufactured by BYK Japan KK), KP-341, KP-358, KP-368, KF-96-50CS, KF-50-100CS (all trade names, manufactured by Shin-Etsu Chemical Co., Ltd.), SURFLON SC-101, SURFLON KH-40 (all trade names, manufactured by AGC Seimi Chemical Co., Ltd.), FTERGENT 222F, FTERGENT 251, FTX-218 (all trade names, manufactured by NEOS Company Limited), TEGO Rad 2100, 2200N, 2250, 2500, 2600, 2700 (all trade names, manufactured by Evonik Industries AG), EFTOP EF-351, EFTOP EF-352, EFTOP EF-601, EFTOP EF-801, EFTOP EF-802 (all trade names, manufactured by Mitsubishi Materials Corporation), MEGAFACE F-171, MEGAFACE F-177, MEGAFACE F-475, MEGAFACE F-477, MEGAFACE F-556, MEGAFACE R-08, MEGAFACE R-30 (all trade names, manufactured by DIC Corporation), fluoroalkylbenzene sulfonate, fluoroalkyl carboxylate, fluoroalkyl polyoxyethylene ether, fluoroalkylammonium iodide, fluoroalkyl betaine, fluoroalkyl sulfonate, diglycerin tetrakis(fluoroalkyl polyoxyethylene ether), fluoroalkyltrimethylammonium salt, fluoroalkylaminosulfonate, polyoxyethylene nonylphenyl ether, polyoxyethylene octylphenyl ether, polyoxyethylene lauryl ether, polyoxyethylene oleyl ether, polyoxyethylene tridecyl ether, polyoxyethylene cetyl ether, polyoxyethylene stearyl ether, polyoxyethylene laurate, polyoxyethylene oleate, polyoxyethylene stearate, polyoxyethylene laurylamine, sorbitan laurate, sorbitan palmitate, sorbitan stearate, sorbitan oleate, sorbitan fatty acid ester, polyoxyethylene sorbitan laurate, polyoxyethylene sorbitan palmitate, polyoxyethylene sorbitan stearate, polyoxyethylene sorbitan oleate, polyoxyethylene naphthyl ether, alkylbenzene sulfonate, alkyldiphenyl ether disulfonate and polyether modified polydimethylsiloxane.

One or more surfactants can be used.

When the content of the surfactant is 0-3 parts by weight with respect to 100 parts by weight of the total weight of the silicon compound (A), the compound (B) having any one or more elements of Ce, La, Pr, Nd, Y and Fe, the crosslinking agent (C) and the catalyst (D) in the curable resin composition of the present invention, there is a tendency that the paintability to base materials is excellent.

### <Flame retardant>

The curable resin composition of the present invention may contain a flame retardant from the viewpoint of the preservation stability. The curable resin composition of the present invention preferably contains a flame retardant since the flame retardance of a cured film to be obtained becomes high. The flame retardant is not particularly limited as long as the flame retardant is a compound capable of imparting flame retardance, but an organic phosphorus-based flame retardant is preferably used from the viewpoint of low toxicity, low pollution and safety.

Examples of the organic phosphorus-based flame retardant include triphenyl phosphate, tricresyl phosphate, trixylenyl phosphate, cresyl phenyl phosphate, 2-ethylhexyl diphenyl phosphate, 9,10-dihydro-9-oxa-10-phosphaphenanthrene-10-oxide, 10-(2,5-dihydroxyphenyl)-10H-9-oxa-10-phosphaphenanthrene-10-oxide and fused 9,10-dihydro-9-oxa-10-phosphaphenanthrene-10-oxide.

One or more flame retardants can be used.

The content of the flame retardant is preferably 0-50 parts by weight with respect to 100 parts by weight of the total weight of the silicon compound (A), the compound (B) having any one or more elements of Ce, La, Pr, Nd, Y and Fe, the crosslinking agent (C) and the catalyst (D) in the curable resin composition of the present invention.

### <Ultraviolet absorber and light stabilizer>

The curable resin composition of the present invention may contain an ultraviolet absorber and a light stabilizer (HALS) in order to prevent cured films to be obtained or the like from being degraded by light such as backlight.

Examples of the ultraviolet absorber include benzotriazole compounds such as 2-(5-methyl-2-hydroxyphenyl)benzotriazole, 2-(3,5-di-t-butyl-2-hydroxyphenyl)benzotriazole, 2-(3,5-di-t-butyl-2-hydroxyphenyl)-5-chlorobenzotriazole and 2-(3,5-di-t-amyl-2-hydroxyphenyl)benzotriazole; triazine compounds such as 2-(4,6-diphenyl-1,3,5-triazin-2-yl)-5-[(hexyl)oxy]-phenol; benzophenone compounds such as 2-hydroxy-4-n-octyloxybenzophenone; oxalic acid anilide compounds such as 2-ethoxy-2'-ethyloxalic acid bisanilide.

Examples of the light stabilizer (HALS) include TINUVIN (registered trademark) 5100, TINUVIN 292 (compound names: bis(1,2,2,6,6,-pentamethyl-4-piperidyl) sebacate, methyl(1,2,2,6,6-pentamethyl-4-piperidyl) sebacate), TINUVIN 152 (compound name: 2,4-bis[N-butyl-N-(1-cyclohexyloxy-2,2,6,6-tetramethylpiperidin-4-yl)amino]-6-(2-hydroxyethylamine)-1,3,5-triazine), TINUVIN 144 (compound name: bis(1,2,2,6,6-pentamethyl-4-piperidyl)-[[3,5-bis(1,1-dimethylethyl)-4-hydroxyphenyl]methyl]butylmaronate), TINUVIN 123 (compound name: decanedioic acid, reaction product of bis(2,2,6,6-tetramethyl-1-(octyloxy)-4-piperidyl) ester (in the presence of 1,1-dimethylethyl hydroperoxide and octane)), TINUVIN 111FDL (approximately 50%, TINUVIN 622, compound name: (butanedioic acid polymer (in the presence of 4-hydroxy-2,2,6,6-tetramethyl piperidyl-yl)ethanol), approximately 50%, CHIMASSORB 119, compound name: N-N'-N"-N‴-tetrakis(4,6-bis(butyl-(N-methyl-2,2,6,6-tetramethylpiperidin-4-yl)amino)trizain-2-yl)-4,7-diazadecane-1,10-diamine), (all manufactured by BASF), ADK STAB LA series (manufactured by ADEKA Corporation), specifically, LA-52, LA-57, LA-62 and LA-67.

One or more ultraviolet absorbers can be used, and one or more light stabilizers can be used.

The content of each of the ultraviolet absorber and the light stabilizer is preferably 0-20 parts by weight with respect to 100 parts by weight of the total weight of the silicon compound (A), the compound (B) having any one or more elements of Ce, La, Pr, Nd, Y and Fe, the crosslinking agent (C) and the catalyst (D) in the curable resin composition of the present invention.

### <Antioxidant>

The curable resin composition of the present invention may contain an antioxidant in order to prevent the oxidation of cured films to be obtained or the like.

Examples of the antioxidant include hindered phenol compounds such as pentaerythritol tetrakis [3 -(3,5 -di-t-butyl-4-hydroxyphenyl)propionate], triethylene glycol-bis-[3-(3-t-butyl-5-methyl-4-hydroxyphenyl) propionate], 1,6-hexanediol-bis[3-(3,5-di-t-butyl-4-hydroxyphenyl)propionate], octadecyl-3-(3,5-di-t-butyl-4-hydroxyphenyl) propionate and 3,5-di-t-butyl-4-hydroxybenzylphosphonate diethyl ester; amine compounds such as n-butylamine, triethylamine and diethylaminomethyl methacrylate; sulfur-based compounds such as dilauryl-3,3'-thiodipropionate, dimyristyl-3,3'-thiodipropionate and distearyl-3,3'-thiodipropionate; phosphorus-based compounds such as triphenyl phosphite, diphenylisodecyl phosphite, phenyl diisodecyl phosphite, tris(nonylphenyl) phosphite, diisodecyl pentaerythritol phosphite, tris(2,4-di-t-butylphenyl) phosphite, cyclic neopentane tetrayl bis(octadecyl) phosphite, cyclic neopentane tetrayl bi(2,4-di-t-butylphenyl) phosphite, cyclic neopentane tetrayl bi(2,4-di-t-butyl-4-methylphenyl) phosphite, bis[2-t-butyl-6-methyl-4-{2-(octadecyloxycarbonyl)ethyl}phenyl]hydrogen phosphite, oxaphosphaphenanthrene oxides (9,10-dihydro-9-oxa-10-phosphaphenanthrene-10-oxide, 10-(3,5-di-t-butyl-4-hydroxybenzyl)-9,10-dihydro-9-oxa-10-phosphaphenanthrene-10-oxide, 10-desyloxy-9,10-dihydro-9-oxa-10-phosphaphenanthrene-10-oxide).

One or more antioxidants can be used.

The content of the antioxidant is preferably 0-10 parts by weight with respect to 100 parts by weight of the total weight of the silicon compound (A), the compound (B) having any one or more elements of Ce, La, Pr, Nd, Y and Fe, the crosslinking agent (C) and the catalyst (D) in the curable resin composition of the present invention.

### <Solvent>

The curable resin composition of the present invention may contain a solvent.

Examples of a solvent that can be used in the present invention include methanol, ethanol, propanol, isopropanol, butanol, t-butyl alcohol, tetrahydrofuran, methyl ethyl ketone, methyl isobutyl ketone, acetonitrile, propionitrile, benzonitrile, ethyl acetate, isobutyl acetate, butyl acetate, butyl propionate, ethyl lactate, methyl oxyacetate, ethyl oxyacetate, butyl oxyacetate, methyl methoxy acetate, ethyl methoxy acetate, butyl methoxy acetate, methyl ethoxy acetate, ethyl ethoxy acetate, methyl 3-oxypropionate, ethyl 3-oxypropionate, methyl 3-methoxypropionate, ethyl 3-methoxypropionate, methyl 3-ethoxypropionate, ethyl 3-ethoxypropionate, methyl 2-hydroxyisobutyrate, methyl 2-oxypropionate, ethyl 2-oxypropionate, propyl 2-oxypropionate, methyl 2-methoxypropionate, ethyl 2-methoxypropionate, propyl 2-methoxypropionate, methyl 2-ethoxypropionate, ethyl 2-ethoxypropionate, methyl 2-oxy-2-methylpropionate, ethyl 2-oxy-2-methylpropionate, methyl 2-methoxy-2-methylpropionate, ethyl 2-ethoxy-2-methylpropionate, methyl pyruvate, ethyl pyruvate, propyl pyruvate, methyl acetoacetate, ethyl acetoacetate, methyl 2-oxobutanoate, ethyl 2-oxobutanoate, methyl xisobutyrate, acetylacetone, dioxane, ethylene glycol, diethyl ether, diethylene glycol, propylene glycol, dipropylene glycol, propylene glycol monomethyl ether, propylene glycol monoethyl ether, propylene glycol monopropyl ether, propylene glycol monobutyl ether, propylene glycol monophenyl ether, ethylene glycol monoisopropyl ether, ethylene glycol monobutyl ether, ethylene glycol monophenyl ether, diethylene glycol monomethyl ether, diethylene glycol monoethyl ether, diethylene glycol monopropyl ether, diethylene glycol monobutyl ether, diethylene glycol monophenyl ether, dipropylene glycol monomethyl ether, dipropylene glycol monoethyl ether, dipropylene glycol monopropyl ether, dipropylene glycol monobutyl ether, dipropylene glycol monophenyl ether, ethylene glycol, diethylene glycol, propylene glycol, dipropylene glycol, glycerin, cyclohexanol, 1,4-butanediol, triethylene glycol, tripropylene glycol, propylene glycol monomethyl ether acetate, propylene glycol monoethyl ether acetate, propylene glycol monopropyl ether acetate, dipropylene glycol monoethyl ether acetate, dipropylene glycol monobutyl ether acetate, ethylene glycol monobutyl ether acetate, cyclohexanone, cyclopentanone, diethylene glycol monomethyl ether acetate, diethylene glycol monoethyl ether acetate, diethylene glycol monobutyl ether acetate, diethylene glycol dimethyl ether, diethylene glycol diethyl ether, diethylene glycol ethyl methyl ether, tripropylene glycol dimethyl ether, triethylene glycol dimethyl ether, tetraethylene glycol dimethyl ether, hexane, heptane, cyclohexane, toluene, xylene, anisole, benzaldehyde, benzonitrile, 1,3-dimethoxybenzene, acetophenone, 4'-methoxyacetophenone, 4'-ethoxyacetophenone, phenylacetate, 3-methoxyphenol, 1,2-methylenedioxybenzene, 2-phenoxyethanol, diethylene glycol monophenyl ether, 1,2,4-trimethoxybenzene, 2'-hydroxyacetophenone, 1,4-diethoxybenzene, 1,3,5-trimethoxybenzene, t-butyl benzoate, benzyl alcohol, 1,4-dimethoxybenzene, 1,2,3-trimethoxybenzene, 2-methoxytoluene, 3-methoxytoluene, 4-methoxytoluene, 2,5-dimethylanisole, thioanisole, 4-ethylanisole, t-butylbenzene, 4-t-butyltoluene, 2-phenylanisole, t-anethole, 3,4-dimethoxytoluene, γ-butyrolactone, N,N-dimethylacetamide, N,N-dimethylformamide, N,N-diethylformamide, N-methyl-2-pyrrolidone, dimethylimidazolidinone, dimethylsulfoxide and the like.

Among these, from the viewpoint of the solubility in the curable resin composition, methyl ethyl ketone, methyl isobutyl ketone, ethyl acetate, isobutyl acetate, butyl acetate, methyl 3-methoxypropionate, acetylacetone, propylene glycol monomethyl ether acetate, toluene, anisole, benzaldehyde, benzonitrile, tetrahydrofuran, diethylene glycol ethyl methyl ether, tetraethylene glycol dimethyl ether, diethylene glycol dimethyl ether, tripropylene glycol dimethyl ether, triethylene glycol dimethyl ether, 1,3-dimethoxybenzene, acetophenone, 4'-methoxyacetophenone, 4'-ethoxyacetophenone, phenylacetate, 3-methoxyphenol, 1,2-methylenedioxybenzene, 2-phenoxyethanol, 1,2,4-trimethoxybenzene, 2'-hydroxyacetophenone, 1,4-diethoxybenzene, 1,3,5-trimethoxybenzene, benzyl alcohol, 1,4-dimethoxybenzene, 1,4-diethoxybenzene, 1,2,3-trimethoxybenzene, 2-methoxytoluene, 3-methoxytoluene, 4-methoxytoluene, 2,5-dimethylanisole, thioanisole, 4-ethylanisole, t-butylbenzene, 4-t-butyltoluene, 2-phenylanisole, 3,4-dimethoxytoluene, N,N-dimethylacetamide, N,N-dimethylformamide, N,N-diethylformamide, and dimethylsulfoxide are preferable.

One or more solvents can be used.

The content of the solvent is preferably 0-900 parts by weight and more preferably 0-400 parts by weight with respect to 100 parts by weight of the total weight of the silicon compound (A), the compound (B) having any one or more elements of Ce, La, Pr, Nd, Y and Fe, the crosslinking agent (C) and the catalyst (D) in the curable resin composition of the present invention.

### <Preparation method>

A method for preparing the curable resin composition of the present invention is not particularly limited, and the curable resin composition can be prepared by a method in which each component is mixed using a well-known mixer or the like.

Examples thereof include a method in which the silicon compound (A), the compound (B) having any one or more elements of Ce, La, Pr, Nd, Y and Fe, the crosslinking agent (C), the catalyst (D), other organopolisiloxane, a curing retarder, an adhesion agent, a filler, an ion scavenger, a surfactant, a flame retardant, an ultraviolet absorber, a light stabilizer, an antioxidant, a solvent and the like are each mixed in a prescribed quantity at normal temperature or while being heated using a mixer such as a stirrer, a homodisper, a homomixer, an all-purpose mixer, a planetarium mixer, a kneader, a three-roll or a bead mill.

In addition, the curable resin composition of the present invention may be produced by preparing and mixing each component such as a two-liquid type component or a three-liquid type component. Each component of the (A)-(D) and the other components can be used singly or two or more thereof can be used in a mixture form.

### (Applications)

The curable resin composition of the present invention is suitable as electronic components including printed circuit boards, semiconductor elements and light emitting diodes (LEDs), and automotive electronic components, and specific examples thereof include buffer coats, insulating films for rewiring, interlayer insulating films, planarizing films, insulating films, protective films, sealants, underfill materials, die attach materials, seal materials, optical lenses, adhesives that are included in electronic components. In addition, additionally, in a case where a fluorescent substance is contained in the curable resin composition of the present invention as a filler, the curable resin composition can be used as a forming material of wavelength conversion layers in light emitting devices such as optical semiconductor devices, and, in a case where a white pigment is contained as a filler, the curable resin composition can be suitably used as a forming material of light reflectors in light emitting devices such as optical semiconductor devices.

### <Cured product>

A cured product of the present invention is obtained by curing the above-described curable resin composition of the present invention and is specifically obtained by heating the curable resin composition and is formed on, for example, the surface of a base material.

The cured product of the present invention is capable of curbing heating-induced decomposition, discoloration, the generation of cracks or the like and has excellent heat resistance.

Therefore, the cured product of the present invention is suitable for buffer coats, insulating films for rewiring, interlayer insulating films, planarizing films, insulating films, protective films, sealants, underfill materials, die attach materials, seal materials, optical lenses, adhesives, wavelength conversion agents and light reflectors that are included in electronic components, and examples of the electronic components include printed circuit boards, semiconductor elements, light emitting diodes (LEDs) and the like.

### <Curing method>

The cured product of the present invention can be obtained by, for example, applying the curable resin composition of the present invention to the surface of a base material by a desired printing method with a dispenser, a spin coater or the like, drying the curable resin composition as necessary, forming a coated film (coated film formation step), performing a drying step on the obtained coated film and curing the coated film.

### <Coated film formation step>

In the coated film formation step, a coated film is formed by applying the curable resin composition of the present invention to the surface of a base material. Examples of the base material include semiconductor substrates such as an aluminum substrate, a glass substrate and a Si substrate (silicon wafer), copper substrates, copper alloy substrates, polyimide substrates, ceramic substrates, printed circuit boards, stainless steel substrates, fiber reinforced substrates such as CFRP and GFRP and the like.

In the case of a curable resin composition containing a solvent, a drying treatment may be performed for the purpose of removing the solvent before curing. While depending on the composition of the curable resin composition, the drying temperature is normally 50°C-250°C, and the drying time is 5-120 minutes. Such a drying treatment makes it possible to form a coated film that is viscous enough to hold the shape on the base material.

### <Heating step>

After the coated film is formed, normally, a heating treatment is performed at 70°C-350°C. The heating treatment is normally performed for 10-200 minutes.

The cured product may be a product for which a crosslinking reaction occurs in at least some of each component of the curable resin composition of the present invention and the flowability has deteriorated and is not limited to a fully cured product. That is, the cured product includes elastic or viscous cured products or cured products that are softened or melted by heating.

The cured product may be a B-stage cured product. The B-stage cured product refers to a cured product in a semi-cured state. Specifically, the B-stage cured product is preferably a cured product that is solid at 25°C and has a softening point in a range of 50°C or higher and 200°C or lower. The B-stage cured product can be obtained by, for example, heating the curable resin composition with a temperature range of 100°C-350°C for one to five hours.

The shape of the cured product is not particularly limited and may be, for example, powdery, granular, a plate shape, a sheet shape or the like. In addition, the cured product may be a product molded in a prescribed shape.

### <Molded article>

A molded article according to one embodiment of the present invention is a molded article that is obtained from the curable resin composition of the present invention or the cured product. Examples of the molded article include buffer coats, insulating films for rewiring, interlayer insulating films, planarizing films, insulating films, protective films, sealants, underfill materials, die attach materials, seal materials, optical lenses, adhesives, wavelength conversion agents and light reflectors that are included in electronic components.

The molded article may be a molded article formed by curing the curable resin composition of the present invention in a prescribed shape using a die or the like or a molded article formed by processing the cured product into a prescribed shape. In addition, a molded article formed by further heating and curing the cured product in a semi-cured state and the like is also included the molded article.

### <Electronic component>

An electronic component according to one embodiment of the present invention is an electronic component including the cured product of the present invention. The cured product is preferably produced from the curable resin composition of the present invention based on the above-described curing method. Examples of the electronic component include printed circuit boards, semiconductor elements, light emitting diodes (LEDs) and the like.

The electronic component of the present invention includes the cured product of the present invention having excellent heat resistance and thus becomes an electronic component having excellent reliability.

Hereinafter, the applications of the cured product of the present invention will be described again. The cured product of the present invention is excellent in terms of heat resistance, insulating properties and adhesiveness, is also excellent in terms of transparency and is flexible. Therefore, the cured product can be used in a variety of applications.

The cured product of the present invention has excellent transparency and is thus suitable as a material that configures all or part of optical components. In the present specification, "optical component" is used as a collective term of components having an optical function. Optical components are briefly classified into independent optical elements having a function of independently changing the characteristics of light and electronic optical elements that perform a prescribed function by an interaction with electrons.

Independent optical elements have a function of changing the transmission characteristics or reflection characteristics of incident light, and specific examples of the function include polarization adjustment, light intensity adjustment, color tone adjustment and optical path adjustment. Specific examples of the independent optical elements include polarizing members, coloring members, light control members, wavelength conversion members, light shielding members, light attenuation members, reflective members, lenses, mirrors and the like. Electronic optical elements have a function of changing the characteristics of incident light based on electrical signals or a function of converting light signals into electrical signals based on photoelectric conversion or of emitting light based on electrical signals. Specific examples of elements having the former function include electrochromic elements and liquid crystal elements. Specific examples of elements having the latter function include image sensors and light emitting elements such as LEDs and OLEDs.

The cured product of the present invention has transparency and has adhesiveness and can be thus suitably used as, similar to conventional optical transparent pressure-sensitive adhesives, protective members or joining members that are disposed on optical paths or vicinities thereof. Conventional optical transparent pressure-sensitive films (OCA) are basically composed of a pressure-sensitive material and are thus not likely to have high heat resistance, but the cured product of the present invention also has excellent heat resistance and can be thus suitably used in applications where the amount of transmitted light is large such as large projectors for projection mapping. In a case where the cured product of the present invention is a B-stage cured product, there is a possibility that the cured product of the present invention or resin-containing members containing the cured product of the present invention can be used as alternative materials of conventional OCAs.

Other examples of the applications of the cured product of the present invention include cases where a composite member including a resin-containing member including the cured product and another member (first member) provided in contact with this resin-containing member configures a part of an electrical element. Since the cured product of the present invention is excellent in terms of a variety of characteristics as described above, the resin-containing member may be composed of the cured product of the present invention alone, but another material may be contained to obtain intended characteristics. Examples of such materials include hard or soft resin materials and non-resin materials such as inorganic fillers.

Specific examples of the electrical element include integrated circuit devices, power elements, switching elements, sensor elements, actuator elements such as MEMS, the above-described electronic optical elements, storage elements such as capacitors, inductors such as choke coils and transformers, resistors and the like. As applications where such an electrical element is used, devices for movement in at least one region selected from the group consisting of on the ground, underground, in the air, in space, at sea and under the sea. Specific examples of such devices include vehicles, ships, aircrafts and the like, and these devices may be manned equipment or unmanned equipment (drones). Additional examples of the applications where the electrical element is used include electrical equipment selected from the group consisting of home appliances, information equipment, video equipment, audio equipment, play equipment and hybrid equipment thereof.

One example of the application of the resin-containing member in the above-described composite member is a protective film that covers at least a part of the first member. Specific examples of the first member include semiconductor base materials, specific examples of which include Si, GaN, SiC and the like, metal-based base materials, specific examples of which include copper-based materials, aluminum-based materials, steel materials represented by stainless steel and the like, ceramic substrates, specific examples thereof include alumina and the like, glass base material and resin-based base materials. The resin-containing member including the cured product of the present invention has excellent adhesiveness to such base materials and can be thus suitably used as protective films.

In particular, since the cured product of the present invention has a siloxane bond (Si-O-Si) such as a silsesquioxane group or a siloxane group and thus has excellent heat resistance compared with resin-based materials not having such a bond, the cured product has particularly excellent adhesiveness to glass base materials, semiconductor base materials and metal-based base materials. Since the cured product of the present invention has a siloxane bond (Si-O-Si) in a prescribed proportion, the amount of global warming gas generated per unit weight is small compared with those from resin cured products not having such a bond (specific examples thereof include epoxy resins).

The first member may be a wiring board including a wiring in a parent material. In this case, a protective film composed of a resin-containing substance including the cured product of the present invention preferably has insulating properties. At this time, the protective film becomes an insulating film that covers the wiring. The cured product of the present invention is also excellent in terms of insulating properties and is thus capable of appropriately functioning as a protective film even in a case where the resin-containing substance is composed of the cured product of the present invention.

In this case, a wiring may be further provided on the protective film to configure a laminate structure of wirings. At this time, the resin-containing substance including the cured product of the present invention is positioned as a planarizing film, an insulating film for rewiring or an interlayer insulating film in members having a multilayer wiring structure.

The first member may be a member including an integrated circuit in a parent material. Even in this case as well, the protective film composed of the resin-containing substance preferably has insulating properties, and, at this time, the protective film is positioned as a buffer coat that covers the integrated circuit.

Another specific example of the application of the resin-containing member in the composite member is a sealing material for which the adhesiveness is used. In this case, specific examples of the first member include integrated circuit devices, power elements, switching elements and sensor elements, and the resin-containing member has excellent heat resistance and can be thus suitably used particularly in high-temperature environment applications as alternative materials of sealing materials that are conventionally composed of an epoxy resin or the like.

The composite member may include a second member that is different from the first member and is in contact with the resin-containing member. In this case, the resin-containing member has a joining function of joining the first member and the second member. The specific examples of the first member also correspond to specific examples of the second member.

One specific example of the application of the resin-containing member with attention paid to the joining function is a filling member that is disposed in a gap between the first member and the second member. Since the cured product of the present invention is highly adhesive to the first member and the second member, the resin-containing member including the cured product of the present invention is capable of appropriately securing the gap between the first member and the second member even when an external force is exerted thereon. Specific examples of the filling member include underfill materials. There are cases where silica particles are contained in a underfill material as a filler, but the cured product of the present invention has a siloxane bond (Si-O-Si) and is thus excellent in terms of adhesiveness to silica particles. Therefore, an underfill material containing silica particles is a particularly suitable example of the application of the resin-containing member.

Another specific example of the resin-containing member with attention paid to the joining function is a seal material that is provided so as to cover the gap between the first member and the second member. Since the cured product of the present invention is highly adhesive to the first member and the second member and is thus flexible, the resin-containing member including the cured product of the present invention is capable of maintaining a state of being in contact with the first member and a state of being in contact with the second member even when an external force is exerted thereon.

In applications where the resin-containing member performs the joining function, the first member may be a mounted substrate, and the second member may be an electrical element provided with an electrode. There are cases where the electrical element generates heat or vibrates when electricity is conducted thereto, but the cured product of the present invention is excellent in terms of the heat resistance and the adhesiveness and is, furthermore, highly flexible and is thus capable of appropriately maintaining the electrical element on the mounted substrate. One of such application examples is die attach materials.

Furthermore, recently, there has been an increasing request for higher output or higher-density mounting of electrical elements, and there has been a demand for mounting techniques to be more highly heat-resistant, and the resin-containing member including the cured product of the present invention is capable of meeting such a request. One example of mounting techniques meeting such a request of higher heat resistance is a power overlay (POL) technique, and the resin-containing member including the cured product of the present invention can be suitably used as joining members in this application.

In one example of the POL technique, an adhesive layer is formed on a substrate made of a heat-resistant resin such as a polyimide, and the electrode-side surface of an electrical element is brought into contact with this adhesive layer, thereby fixing the electrical element onto the substrate. After that, the substrate is perforated from the surface (rear surface) opposite to the surface of the substrate on which the electrical element is disposed (front surface) (formation of a through hole by a removing process) to expose an electrode surface. In addition, the through hole is filled with a conductive material such as copper, and, furthermore, a wiring pattern is formed on the rear surface using a plating technique or the like. After the rear surface on which the wiring pattern has been formed is covered with an insulating film, a part of the insulating film is removed to form an external electrode that is connected to the wiring pattern. In addition, the front surface is sealed with a resin-based material so as to cover the electrical element on the front surface, and a heat dissipation member is additionally provided as necessary.

The resin-containing member including the cured product of the present invention has excellent adhesiveness and high heat resistance and can be thus suitably used as an adhesive layer that is formed on the front surface of the substrate. In addition, the resin-containing member can also be used as a resin-based material that covers the electrical element which generates heat when electricity is conducted thereto. In this case, there is a possibility that a resin-containing member in which a material having a high thermal conductivity such as alumina is dispersed is preferably used using the excellent heat resistance and excellent adhesiveness of the cured product of the present invention.

### [Examples]

The present invention will be described in more detail based on examples. The present invention is not limited by the following examples. Hereinafter, methods for analyzing synthesized organic silicon compounds will be described.

### <Number average molecular weight and weight average molecular weight>

For measurement, high-performance liquid chromatography systems (AS-4050, PU-4180, CO-4060 and RI-4030) manufactured by JASCO Corporation were used. A sample was prepared as a 0.5 wt% solution by being dissolved in tetrahydrofuran, and 100 µL of this solution was introduced into a sample chamber. Measurement was performed under the following conditions, and polystyrene conversion was performed, thereby obtaining the number average molecular weight and the weight average molecular weight.
Column: Shodex KF805L [manufactured by Showa Denko K.K.]
Column: Shodex KF804L [manufactured by Showa Denko K.K.]
(the two columns were connected together in series)
Column temperature: 40°C
Detector: RI
Eluent: Tetrahydrofuran
Eluent flow rate: 1.0 mL/minute

### <Nuclear magnetic resonance spectrum (NMR)>

For measurement, JNM-ECZ500R manufactured by JEOL Ltd. Was used. In the ¹H-NMR measurement, a sample was dissolved in a deuterated solvent such as heavy acetone (manufactured by Wako Pure Chemical Industries, Ltd.), and the magnetic field distribution was measured under conditions of room temperature, 500 MHz and a cumulative number of 16 times. From the integral ratio of the ¹H-NMR, the proportion (α) or (β) of siloxane groups with respect to introduced silsesquioxane groups in a synthesized silicon compound was determined. In the Si-NMR measurement, a sample was dissolved in tetrahydrofuran (manufactured by Wako Pure Chemical Industries, Ltd.), tetramethylsilane (99.9+%, NMR grade) (manufactured by Fisher Scientific Inc.) was added thereto, and the magnetic field distribution was measured under conditions of room temperature, 500 MHz and a cumulative number of 800 times. From the integral ratio of the Si-NMR, the proportion (β) of siloxane groups with respect to introduced silsesquioxane groups in a synthesized silicon compound was determined.

### [Synthesis Example 1]

### <Synthesis of silsesquioxane derivative (DD-4OH)>

A silsesquioxane derivative (DD-4OH) represented by the following formula was synthesized by a method described in Japanese Patent No. 5704168.

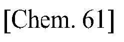

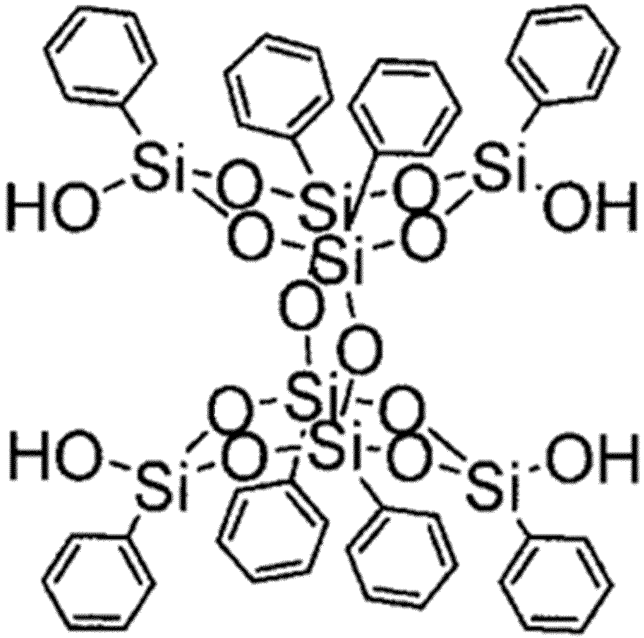

### [Synthesis Example 2]

### <Synthesis of silsesquioxane derivative (DD(Me)-OH)>

A silsesquioxane derivative (DD(Me)-OH) represented by the following formula was synthesized by a method described in Japanese Patent No. 4379120. As a raw material, the silsesquioxane derivative (DD-4OH) synthesized in Synthesis Example 1 was used.

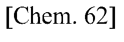

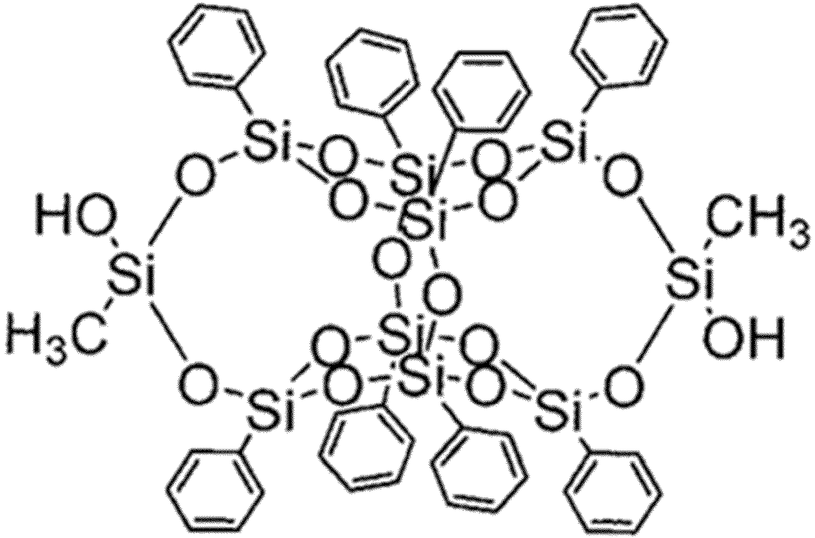

### [Synthesis Example 3]

### <Synthesis of silicon compound (A-I)>

The silsesquioxane derivative (DD(Me)-OH) (150 g), octamethylcyclotetasiloxane (D4) (33.8 g), sulfuric acid (11.8 g), toluene (156 g) and 4-methyltetrahydrofuran (39.1 g) were put into a reactor under a nitrogen atmosphere, heated to 100°C and stirred for five hours. Water was poured into a reaction mixture, and a water layer was extracted with toluene. A combined organic layer was washed with water, a sodium hydrogen carbonate aqueous solution and saturated saline water and then dried with anhydrous sodium sulfate. This solution was concentrated under reduced pressure, and the residue was purified with a reprecipitation (2-propanol:ethyl acetate = 50:7, weight ratio), thereby obtaining a compound (A-I) (161 g). It was confirmed by ¹H-NMR and GPC analysis that the obtained white solid was the silicon compound (A-I) that was the organic silicon compound represented by formula (8) described in the section "solution to problem", in which R¹ in formula (8) was phenyl, R⁸ was methyl, R¹⁰ was hydrogen, the proportion (α) of the siloxane groups with respect to the silsesquioxane groups was 3.0, the number average molecular weight was 23,000, and the weight average molecular weight was 46,000.

### [Synthesis Example 4]

### <Synthesis of silicon compound (A-II)>

The silsesquioxane derivative (DD(Me)-OH) (150 g), octamethylcyclotetasiloxane (D4) (54.4 g), sulfuric acid (15.2 g), toluene (176 g) and 4-methyltetrahydrofuran (43.9 g) were put into a reactor under a nitrogen atmosphere, heated to 100°C and stirred for five hours. Water was poured into a reaction mixture, and a water layer was extracted with toluene. A combined organic layer was washed with water, a sodium hydrogen carbonate aqueous solution and saturated saline water and then dried with anhydrous sodium sulfate. This solution was concentrated under reduced pressure, and the residue was purified with a reprecipitation (2-propanol:ethyl acetate = 50:7, weight ratio), thereby obtaining a compound (A-II) (152 g). It was confirmed by ¹H-NMR and GPC analysis that the obtained white solid was the silicon compound (A-II) that was the organic silicon compound represented by formula (8) described in the section "solution to problem", in which R¹ in formula (8) was phenyl, R⁸ was methyl, R¹⁰ was hydrogen, the proportion (α) of the siloxane groups with respect to the silsesquioxane groups was 4.1, the number average molecular weight was 21,000, and the weight average molecular weight was 36,000.

### [Synthesis Example 5]

### <Synthesis of silicon compound (A-III)>

The silsesquioxane derivative (DD(Me)-OH) (150 g), octamethylcyclotetasiloxane (D4) (56.3 g), sulfuric acid (6.20 g), toluene (170 g) and 4-methyltetrahydrofuran (42.5 g) were put into a reactor under a nitrogen atmosphere, heated to 100°C and stirred for five hours. Water was poured into a reaction mixture, and a water layer was extracted with toluene. A combined organic layer was washed with water, a sodium hydrogen carbonate aqueous solution and saturated saline water and then dried with anhydrous sodium sulfate. This solution was concentrated under reduced pressure, and the residue was purified with a reprecipitation (2-propanol:ethyl acetate = 50:7, weight ratio), thereby obtaining a compound (A-III) (157 g).

It was confirmed by ¹H-NMR and GPC analysis that the obtained white solid was the silicon compound (A-III) that was the silicon compound represented by formula (8) described in the section "solution to problem", in which R¹ in formula (8) was phenyl, R⁸ was methyl, R¹⁰ was hydrogen, the proportion (α) of the siloxane groups with respect to the silsesquioxane groups was 4.2, the number average molecular weight was 29,000, and the weight average molecular weight was 55,000.

### [Synthesis Example 6]

### <Synthesis of silicon compound (A-IV)>

The silsesquioxane derivative (DD(Me)-OH) (150 g), octamethylcyclotetasiloxane (D4) (68.7 g), sulfuric acid (7.02 g), toluene (181 g) and 4-methyltetrahydrofuran (45.1 g) were put into a reactor under a nitrogen atmosphere, heated to 100°C and stirred for six hours. Water was poured into a reaction mixture, and a water layer was extracted with toluene. A combined organic layer was washed with water, a sodium hydrogen carbonate aqueous solution and saturated saline water and then dried with anhydrous sodium sulfate. This solution was concentrated under reduced pressure, and the residue was purified with a reprecipitation (2-propanol:ethyl acetate = 29:2, weight ratio), thereby obtaining a compound (A-IV) (156 g).

It was confirmed by ¹H-NMR and GPC analysis that the obtained white solid was the silicon compound (A-IV) that was the silicon compound represented by formula (8) described in the section "solution to problem", in which R¹ in formula (8) was phenyl, R⁸ was methyl, R¹⁰ was hydrogen, the proportion (α) of the siloxane groups with respect to the silsesquioxane groups was 4.9, the number average molecular weight was 29,000, and the weight average molecular weight was 52,000.

### [Synthesis Example 7]

### <Synthesis of silicon compound (A-V)>

A silicon compound (A-V) was obtained by a method described in International Publication No. WO 2022/030353.

¹H-NMR, ²⁹Si-NMR and GPC analysis showed that the obtained white solid was the silicon compound represented by formula (21) described in the section "solution to problem", in which R¹ in formula (21) was phenyl, R² was methyl, R¹⁵ was represented by formula (24), in formula (24), R¹⁴ was methyl, the proportion (β) of the siloxane groups with respect to the silsesquioxane groups was 4.4, the number average molecular weight was 33,000, and the weight average molecular weight was 68,000. In addition, it was confirmed that the obtained white solid was the silicon compound (A-V) in which the average values of x and y in X¹ and X² in formula (21) were 2.8 and 1.6, respectively, and z was zero.

### [Synthesis Example 8]

### <Synthesis of silsesquioxane derivative (POSS-2)>

A silsesquioxane derivative (POSS-2) represented by the following formula was synthesized by a method described in International Publication No. WO 2022/030353.

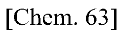

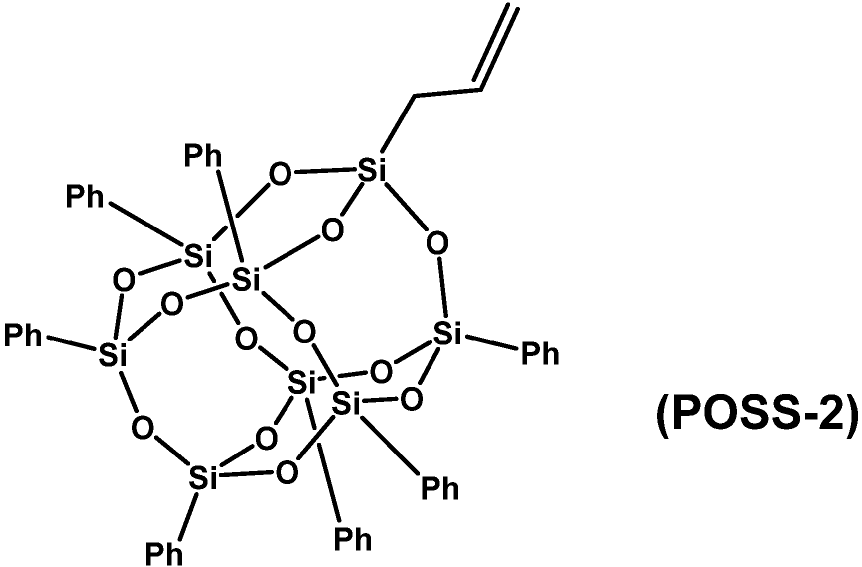

### [Synthesis Example 9]

### <Synthesis of silicon compound (A-VI)>

A silicon compound (A-VI) was obtained by a method described in International Publication No. WO 2022/030353.

¹H-NMR and GPC analysis showed that the obtained white solid was the silicon compound represented by formula (21) described in the section "solution to problem", in which R¹ in formula (21) was phenyl, R² was methyl, R¹⁵ was represented by formula (24), in formula (24), R¹⁴ was methyl, the proportion (β) of the siloxane groups with respect to the silsesquioxane groups was 4.4, the number average molecular weight was 35,000, and the weight average molecular weight was 100,000. In addition, it was confirmed that the obtained white solid was the silicon compound (A-VI) in which the average values of x, y and z in X¹ and X² in formula (21) were 2.8, 1.12 and 0.48, respectively.

Hereinafter, each component used for the preparation of curable resin compositions will be described.

### <Silicon compound (A)>

Silicon compounds (A-I)-(A-IV): Silicon compounds (A-I)-(A-IV) synthesized in Synthesis Examples 3-6

### <Compound (B) having any one or more elements of Ce, La, Pr, Nd, Y and Fe>

Ce(acac)₃·nH₂O: Cerium (III) acetylacetonate·n hydrate (manufactured by Sigma-Aldrich Co. LLC)
Ce(acac)₃: Cerium (III) acetylacetonate (manufactured by Strem Chemicals, Inc.)
Ce(NO₃)₃·6H₂O: Cerium (III) nitrate hexahydrate (manufactured by FUJIFILM Wako Pure Chemical Corporation)
Fe(acac)₃: Iron (III) acetylacetonate (manufactured by Strem Chemicals, Inc.)

### <Crosslinking agent (C)>

MS51: Partial condensate of tetramethoxysilane ("MKC SILICATE MS51" manufactured by Mitsubishi Chemical Corporation)
ES40: Partial condensate of tetraethoxysilane ("ETHYL SILICATE 40" manufactured by Colcoat Co., Ltd.)
TMPS: Trimethoxyphenylsilane (manufactured by Tokyo Chemical Industry Co., Ltd.)
DVTS: 1,5-Divinylhexamethyltrisiloxane (manufactured by FUJIFILM Wako Pure Chemical Corporation)

### <Catalyst (D)>

ZC150: Zirconium tetraacetylacetonate (manufactured by Matsumoto Fine Chemical Co., Ltd.)
Pt-VTSC-3.0X: 1,3-Divinyl-1,1,3,3-tetramethyldisiloxane complex of platinum (manufactured by Umicore S.A.)

### <Solvent>

Anisole (manufactured by FUJIFILM Wako Pure Chemical Corporation)

### [Examples 1-10 and Comparative Examples 1-5]

### <Preparation of curable resin compositions 1-9 and R1-R4>

Each component was uniformly mixed and dissolved in a weight shown in Tables 1-4, thereby adjusting curable resin compositions 1-9 and R1-R4.

### <Fabrication of cured product>

Each of the obtained curable resin compositions was applied to a 10 cm glass substrate using an applicator. After that, the curable resin composition was put into an oven and heated at 200°C for one hour and at 300°C for two hours, thereby obtaining a cured product having a thickness of 100 µm. The thickness of the obtained cured product was measured with a digimatic indicator ("ID-H0530" manufactured by Mitutoyo Corporation).

### <Evaluation of heat resistance (TG-DTA)>

The obtained cured product was scraped off with a cutter, and the heat resistance was evaluated at a heating rate of 10 °C/min in a nitrogen atmosphere using TG-DTA (Thermo plus EVOII TG8120 manufactured by Rigaku Corporation). As the index of the heat resistance, a temperature at which the weight decreased by 1% (Td1) and a temperature at which the weight decreased by 3% (Td3) with an assumption that the weight before heating was regarded as 100% were used.

### <Evaluation of heat resistance (solid NMR)>

Cured films obtained in Example 2 and Comparative Example 2 were scraped off with a cutter and heated at 400°C for three hours in a nitrogen atmosphere using the TG-DTA (the heating rate was 20 °C/min). For samples before and after the heating, changes in the structure by heating were evaluated using solid NMR (VARIAN NMR SYSTEM manufactured by Varian Medical Systems, Inc.). As the evaluation index, the integral values of (C₆H₅)SiO₃-derived absorption (-80 ppm) were unified between the samples, and the decrease rate of a D body was estimated from the following equation using the integral value of Me₂SiO₂ (D body)-derived absorption (-23 ppm). Measurement was performed under conditions of a cumulative number of 6,000 scans and a recycle time of 10 seconds. The present evaluation results are shown in Table 4 as Example 10 and Comparative Example 5. D body decrease rate = (integral value of D body-derived absorption after heating - integral value of D body-derived absorption before heating)/(integral value of D body-derived absorption before heating)

The results are shown in Tables 1-4. The unit of the amount of each component in Tables 1-4 is "g."

**[Table 1]**

| Table 1 | | Example 1 | Example 2 | Example 3 | Example 4 | Example 5 |
|---|---|---|---|---|---|---|
| Curable resin composition | | 1 | 2 | 3 | 4 | 5 |
| Silicon compound (A) | A-I | 10 | | | | |
| | A-II | | 10 | 10 | | |
| | A-III | | | | 10 | |
| | A-IV | | | | | 10 |
| Compound (B) | Ce(acac)₃·nH₂O | 0.001 | 0.001 | 0.002 | 0.001 | 0.001 |
| | Ce(acac)₃ | | | | | |
| | Ce(NO₃)₃·6H₂O | | | | | |
| Crosslinking agent (C) | MS51 | 0.63 | 0.69 | 0.69 | 0.5 | 0.5 |
| | ES40 | | | | | |
| | TMPS | | | | | |
| Catalyst (D) | ZC 150 | 0.01 | 0.01 | 0.01 | 0.01 | 0.01 |
| Solvent | Anisole | 6.8 | 8.26 | 8.26 | 8.1 | 8.3 |
| Heat resistance TG-DTA (nitrogen atmosphere) | Td1 [°C] | 461 | 468 | 473 | 479 | 472 |
| | Td3 [°C] | 491 | 495 | 498 | 496 | 490 |

**[Table 2]**

| Table 2 | | Example 6 | Example 7 | Example 8 | Example 9 |
|---|---|---|---|---|---|
| Curable resin composition | | 6 | 7 | 8 | 9 |
| Silicon compound (A) | A-I | | | | |
| | A-II | 10 | 10 | 10 | 10 |
| | A-III | | | | |
| | A-IV | | | | |
| Compound (B) | Ce(acac)₃·nH₂O | 0.001 | 0.001 | | |
| | Ce(acac)₃ | | | 0.001 | |
| | Ce(NO₃)₃·6H₂O | | | | 0.001 |
| Crosslinking agent (C) | MS51 | | | 0.69 | 0.69 |
| | ES40 | 0.89 | | | |
| | TMPS | | 0.24 | | |
| Catalyst (D) | ZC 150 | 0.01 | 0.01 | 0.01 | 0.01 |
| Solvent | Anisole | 8.26 | 8.26 | 8.26 | 8.26 |
| Heat resistance TG-DTA (nitrogen atmosphere) | Td1 [°C] | 473 | 464 | 468 | 457 |
| | Td3 [°C] | 495 | 493 | 496 | 487 |

**[Table 3]**

| Table 3 | | Comparative Example 1 | Comparative Example 2 | Comparative Example 3 | Comparative Example 4 |
|---|---|---|---|---|---|
| Curable resin composition | | R1 | R2 | R3 | R4 |
| Silicon compound (A) | A-I | 10 | | | |
| | A-II | | 10 | | |
| | A-III | | | 10 | |
| | A-IV | | | | 10 |
| Compound (B) | Ce(acac)₃·nH₂O | | | | |
| | Ce(acac)₃ | | | | |
| | Ce(NO₃)₃·6H₂O | | | | |
| Crosslinking agent (C) | MS51 | 0.63 | 0.69 | 0.5 | 0.5 |
| | ES40 | | | | |
| | TMPS | | | | |
| Catalyst (D) | ZC 150 | 0.01 | 0.01 | 0.01 | 0.01 |
| Solvent | Anisole | 6.8 | 8.3 | 8.1 | 8.3 |
| Heat resistance TG-DTA (nitrogen atmosphere) | Td1 [°C] | 443 | 449 | 459 | 454 |
| | Td3 [°C] | 476 | 479 | 484 | 478 |

As shown in Tables 1-3, it is found that the cured products obtained in the examples were superior in terms of the heat resistance to comparative examples.

It is found that the cured products obtained in the examples shown in Tables 1-3 have the silicon compound (A) and the compound (B) and are closer than the comparative examples having only the silicon compound (A) by 10°C-20°C and the heat resistance thereof improves.

In addition, Examples 1, 2, 4 and 5 and Comparative Examples 1-4 show that improvement in heat resistance is observed in all of the silicon compounds (A) in which the ratio between the silsesquioxane groups and the siloxane groups or the weight average molecular weight is different.

Examples 2 and 6-9 show that the same improvement in heat resistance is observed even when the compound (B) or the crosslinking agent (C) is different.

Furthermore, as in Example 3, additional improvement in heat resistance by an increase in the amount of the compound (B) added is also observed.

**[Table 4]**

| Table 4 | | Example 10 | Comparative Example 5 |
|---|---|---|---|
| Curable resin composition | | 2 | R2 |
| Silicon compound (A) | A-II | 10 | 10 |
| Compound (B) | Ce(acac)₃·nH₂O | 0.001 | |
| Crosslinking agent (C) | MS51 | 0.69 | 0.69 |
| Catalyst (D) | ZC150 | 0.01 | 0.01 |
| Solvent | Anisole | 8.26 | 8.3 |
| Heat resistance solid NMR | D body decrease rate [%] | -8 | -26 |

As shown in Table 4, it is found that, compared with the cured product not containing the compound (B) (Comparative Example 5), in the cured product having the silicon compound (A) and the compound (B) (Example 10), the decrease rate of the D body is small, and the structural change by heating is curbed.

### [Example 11 and Comparative Example 6]

### <Evaluation of heat resistance (TG-DTA)>

The cured films obtained in Example 2 and Comparative Example 2 were scraped off with a cutter, and the heat resistance was evaluated at a heating rate of 10 °C/min in an air atmosphere using TG-DTA (manufactured by Rigaku Corporation). As the index of the heat resistance, a temperature at which the weight decreased by 1% (Td1) and a temperature at which the weight decreased by 3% (Td3) with an assumption that the weight before heating was regarded as 100% were used. The present evaluation results are shown in Table 5 as Example 11 and Comparative Example 6.

The results are shown in Table 5. The unit of the amount of each component in Table 5 is "g."

**[Table 5]**

| Table 5 | | Example 11 | Comparative Example 6 |
|---|---|---|---|
| Curable resin composition | | 2 | R2 |
| Silicon compound (A) | A-II | 10 | 10 |
| Compound (B) | Ce(acac)₃·nH₂O | 0.001 | |
| Crosslinking agent (C) | MS51 | 0.69 | 0.69 |
| Catalyst (D) | ZC 150 | 0.01 | 0.01 |
| Solvent | Anisole | 8.26 | 8.3 |
| Heat resistance TG-DTA (air atmosphere) | Td1 [°C] | 455 | 410 |
| | Td3 [°C] | 472 | 457 |

As is clear from Table 5, it is found that the cured films have favorable heat resistance even in the air atmosphere.

### [Example 12]

### <Evaluation of heat resistance (TG-DTA)>

A curable composition 10 shown in Table 6 was prepared and a cured product was fabricated by the same method as in Examples 1-9. Furthermore, the evaluation (TG-DTA) of the heat resistance was performed by the same method as in Comparative Example 6, and, as the index of the heat resistance, a temperature at which the weight decreased by 1% (Td1) and a temperature at which the weight decreased by 3% (Td3) with an assumption that the weight before heating was regarded as 100% were used. The present evaluation results are shown in Table 6 as Example 12 together with Comparative Example 6 and Example 11 for comparison.

The results are shown in Table 6. The unit of the amount of each component in Table 6 is "g."

**[Table 6]**

| Table 6 | | Example 11 | Example 12 | Comparative Example 6 |
|---|---|---|---|---|
| Curable resin composition | | 2 | 10 | R2 |
| Silicon compound (A) | A-II | 10 | 10 | 10 |
| Compound (B) | Ce(acac)₃·nH₂O | 0.001 | | |
| | Ce(acac)₃ | | 0.001 | |
| Crosslinking agent (C) | MS51 | 0.63 | 0.69 | 0.69 |
| Catalyst (D) | ZC 150 | 0.01 | 0.01 | 0.01 |
| Solvent | Anisole | 8.26 | 8.26 | 8.3 |
| Heat resistance TG-DTA (air atmosphere) | Td1 [°C] | 455 | 450 | 410 |
| | Td3 [°C] | 472 | 477 | 457 |

As is clear from Table 6, in Example 12, the heat resistance was approximately as high as that in Example 11. This result suggests that, even when the compound (B) is not a cerium compound, the cured product of the curable resin composition has favorable heat resistance.

### [Examples 13-15 and Comparative Examples 7-8]

### <Evaluation of heat resistance (TG-DTA)>

Curable compositions 11-13 and R8-R9 shown in Table 7 were prepared by the same method as in Examples 1-9, and cured products were fabricated by the same method as in Examples 1-9 except that the curable compositions were heated at 100°C for one hour and at 250°C for three hours. Furthermore, the evaluation (TG-DTA) of the heat resistance was performed by the same method as in Example 12, and, as the index of the heat resistance, a temperature at which the weight decreased by 1% (Td1) and a temperature at which the weight decreased by 3% (Td3) with an assumption that the weight before heating was regarded as 100% were used. The present evaluation results are shown in Table 7 as Examples 13-15 and Comparative Examples 7-8.

The results are shown in Table 7. The unit of the amount of each component in Table 7 is "g."

**[Table 7]**

| Table 7 | | Example 13 | Example 14 | Example 15 | Comparative Example 7 | Comparative Example 8 |
|---|---|---|---|---|---|---|
| Curable resin composition | | 11 | 12 | 13 | R8 | R9 |
| Silicon compound (A) | A-I | 10 | 10 | | 10 | |
| | A-VI | | | 10 | | 10 |
| Compound (B) | Ce(acac)₃ | 0.001 | 0.001 | 0.001 | | |
| Crosslinking agent (C) | DVTS | | 0.75 | | | |
| Catalyst (D) | Pt-VTSC-3.0X | 0.00001 | 0.00001 | | 0.00001 | |
| Solvent | PGMEA | 10 | 10 | 9.44 | 10 | 9.33 |
| Heat resistance TG-DTA (air atmosphere) | Td1 [°C] | 428 | 425 | 404 | 411 | 389 |
| | Td3 [°C] | 448 | 444 | 425 | 433 | 410 |

As is clear from Table 7, it is found that, even in A-V and A-VI, which are the silicon compounds (A) having a different skeleton from A-I-A-IV, since the compound (B) is contained, the cured product having favorable heat resistance can be obtained from the curable resin compositions.

### [Examples 16-21]

### <Evaluation of adhesiveness>

The curable resin compositions (1, 2, 4, 5, 11 and 13) of Examples 1, 2, 4, 5, 13 and 15 were applied and heated by the same method as the above-described method for fabricating a cured product except that the coated substrate was changed to each of the following base materials, thereby fabricating cured film-attached substrates having a film thickness of 10 µm. Before the application, a reforming treatment was performed on each base material for 10 minutes using a UV/O3 washing and reforming device ASM2001N manufactured by Asumi Giken, Limited. Adhesiveness was evaluated using the fabricated cured film-attached substrates by a cross-cut method (1 mm intervals, 10 × 10 squares) based on the following evaluation standards. As tape, No. 31B manufactured by Nitto Denko Corporation was used. The present evaluation results are shown in Table 8 as Examples 16-21.

### <Base materials>

Glass: Eagle-XG (trade name, manufactured by Musashino Fine Glass Co., Ltd.)
Si: High-purity silicon wafer for research (4xP type) (AS ONE Corporation)
Cu: C1020P-1/2H (trade name, manufactured by Standard-testpiece)
Al: A1050P-H24 (trade name, manufactured by Standard-testpiece)
SUS: SUS304-2B (trade name, manufactured by Standard-testpiece)
Fe: SPCC-SD (trade name, manufactured by Standard-testpiece)

### <Evaluation standards>

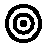 : The peeled area is 3% or less
O: The peeled area is more than 3% and 5% or less
Δ: The peeled area is more than 5% and 50% or less
X: The peeled area is 51% or more

The results are shown in Table 8. The unit of the amount of each component in Table 8 is "g."

**[Table 8]**

| Table 8 | | Example 16 | Example 17 | Example 18 | Example 19 | Example 20 | Example 21 |
|---|---|---|---|---|---|---|---|
| Curable resin composition | | 1 | 2 | 4 | 5 | 11 | 13 |
| Silicon compound (A) | A-I | 10 | | | | | |
| | A-II | | 10 | | | | |
| | A-III | | | 10 | | | |
| | A-IV | | | | 10 | | |
| | A-V | | | | | 10 | |
| | A-VI | | | | | | 10 |
| Compound (B) | Ce(acac)₃·nH₂O | 0.001 | 0.001 | 0.001 | 0.001 | | |
| | Ce(acac)₃ | | | | | 0.001 | 0.001 |
| Crosslinking agent (C) | MS51 | 0.63 | 0.69 | 0.5 | 0.5 | | |
| Catalyst (D) | ZC150 | 0.01 | 0.01 | 0.01 | 0.01 | | |
| | Pt-VTSC-3.0X | | | | | 0.00001 | |
| Solvent | Anisole | 6.8 | 8.26 | 8.1 | 8.3 | | |
| | PGMEA | | | | | 10 | 9.44 |
| Adhesiveness | Glass | 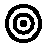 | 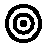 | 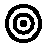 | 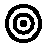 | 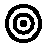 | 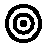 |
| | Si | 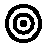 | 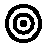 | 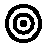 | 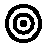 | 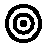 | 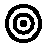 |
| | Cu | O | O | O | O | 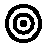 | O |
| | Al | O | O | O | O | O | O |
| | SUS | 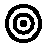 | 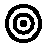 | 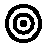 | 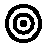 | 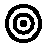 | O |
| | Fe | 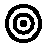 | 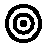 | 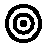 | 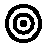 | 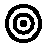 | O |

From the results shown in Table 8, it is found that, even in cases where any of A-I-A-VI is used as the silicon compound (A), the cured films of the curable resin composition containing the compound (B) have favorable adhesiveness to a variety of base materials.

### [Examples 22-23]

### <Evaluation of adhesiveness>

Adhesiveness was evaluated using the same evaluation standards by the same method as in Examples 16-21 except that the heating conditions at the time of fabricating the cured film-attached substrates were changed to heating at 70°C for 20 minutes, then, at 100°C for 20 minutes and, furthermore, at 200°C for two hours and the base material was changed to a polyimide film (R)200H (PI: polyimide (manufactured by AS ONE Corporation)).

The results are shown in Table 9. The unit of the amount of each component in Table 9 is "g."

**[Table 9]**

| Table 9 | | Example 22 | Example 23 |
|---|---|---|---|
| Curable resin composition | | 2 | 4 |
| Silicon compound (A) | A-II | 10 | |
| | A-III | | 10 |
| Compound (B) | Ce(acac)₃·nH₂O | 0.001 | 0.001 |
| Crosslinking agent (C) | MS51 | 0.69 | 0.5 |
| Catalyst (D) | ZC150 | 0.01 | 0.01 |
| Solvent | Anisole | 8.26 | 8.1 |
| Adhesiveness | PI | O | O |

From the results shown in Table 9, it is found that the cured films of the curable resin composition containing the compound (B) have favorable adhesiveness to base materials of a polyimide.

### [Examples 24-29]

### <Evaluation of total light transmittance>

The curable resin compositions 1, 2, 4, 5, 11 and 13 were used and applied and heated by the same method as in Examples 1, 2, 4, 5, 13 and 15 except that the coated substrate was changed to mold release-treated Eagle-XG (manufactured by Musashino Fine Glass Co., Ltd.). After the heating, the films were peeled off from the base materials to fabricate cured films having a film thickness of 100 µm.

The total light transmittance was measured by the following method using the fabricated cured films. The present evaluation results are shown in Table 10 as Examples 24-29.

### <Total light transmittance>

As the index of the transparency of the cured film, a haze meter (NDH-5000SP, manufactured by Denshoku Industries Co., Ltd.) was used to measure the total light transmittance.

The results are shown in Table 10. The unit of the amount of each component in Table 10 is "g."

**[Table 10]**

| Table 10 | | Example 24 | Example 25 | Example 26 | Example 27 | Example 28 | Example 29 |
|---|---|---|---|---|---|---|---|
| Curable resin composition | | 1 | 2 | 4 | 5 | 11 | 13 |
| Silicon compound (A) | A-I | 10 | | | | | |
| | A-II | | 10 | | | | |
| | A-III | | | 10 | | | |
| | A-IV | | | | 10 | | |
| | A-V | | | | | 10 | |
| | A-VI | | | | | | 10 |
| Compound (B) | Ce(acac)₃·nH₂O | 0.001 | 0.001 | 0.001 | 0.001 | | |
| | Ce(acac)₃ | | | | | 0.001 | 0.001 |
| Crosslinking agent (C) | MS51 | 0.63 | 0.69 | 0.5 | 0.5 | | |
| Catalyst (D) | ZC 150 | 0.01 | 0.01 | 0.01 | 0.01 | | |
| | Pt-VTSC-3.0X | | | | | 0.00001 | |
| Solvent | Anisole | 6.8 | 8.26 | 8.1 | 8.3 | | |
| | PGMEA | | | | | 10 | 9.44 |
| Total light transmittance | % | 92.3 | 91.6 | 91.7 | 91.5 | 92.8 | 92.5 |

From the results shown in Table 10, it is found that all of the cured films of the examples each have high transparency.

### [Examples 30-35]

### <Evaluation of volume resistivity>

The curable resin compositions 1, 2, 4, 5, 11 and 13 were used and applied and heated by the same method as in Examples 16-21 except that the base material was changed to the following chromium base material (manufactured by Mitsuru Optical Laboratory), thereby fabricating cured film-attached substrates having a film thickness of 15 um. A femto-picoammeter B2981A (manufactured by Keysight Technolgies) and a high-voltage power supply HER-3P10 (manufactured by Matsusada Precision Inc.) were connected to these cured film-attached substrates, and the volume resistivity at the time of applying 250 V was measured.

The results are shown in Table 11. The unit of the amount of each component in Table 11 is "g."

**[Table 11]**

| Table 11 | | Example 30 | Example 31 | Example 32 | Example 33 | Example 34 | Example 35 |
|---|---|---|---|---|---|---|---|
| Curable resin composition | | 1 | 2 | 4 | 5 | 11 | 13 |
| Silicon compound (A) | A-I | 10 | | | | | |
| | A-II | | 10 | | | | |
| | A-III | | | 10 | | | |
| | A-IV | | | | 10 | | |
| | A-V | | | | | 10 | |
| | A-VI | | | | | | 10 |
| Compound (B) | Ce(acac)₃·nH₂O | 0.001 | 0.001 | 0.001 | 0.001 | | |
| | Ce(acac)₃ | | | | | 0.001 | 0.001 |
| Crosslinking agent (C) | MS51 | 0.63 | 0.69 | 0.5 | 0.5 | | |
| Catalyst (D) | ZC 150 | 0.01 | 0.01 | 0.01 | 0.01 | | |
| | Pt-VTSC-3.0X | | | | | 0.00001 | |
| Solvent | Anisole | 6.8 | 8.26 | 8.1 | 8.3 | | |
| | PGMEA | | | | | 10 | 9.44 |
| Volume resistivity | Ω·cm | 10¹⁶ | 10¹⁶ | 10¹⁶ | 10¹⁶ | 10¹⁶ | 10¹⁶ |

From the results shown in Table 11, it is found that the cured films formed from the curable resin composition of each example all have high insulating properties.

### [Industrial Applicability]

The curable resin composition of the present invention makes it possible to provide a curable resin composition making it possible to form a cured product having heat resistance suited for use in applications such as electronic components including printed circuit boards, semiconductor elements and light emitting diodes (LEDs), and automotive electronic components, and an electronic component, an optical component, and a composite member each having the cured product.

## Claims

1. A curable resin composition comprising:
a silicon compound (A) that is formed from any one or more of silsesquioxane groups represented by formula (1) or (2) and from any one or more of siloxane groups represented by formulas (3)-(5), and that has a weight average molecular weight of 3,000-1,000,000; and
a compound (B) that contains any one or more elements of Ce, La, Pr, Nd, Y and Fe, 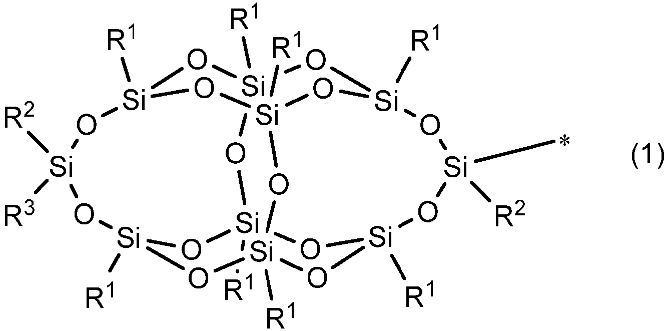 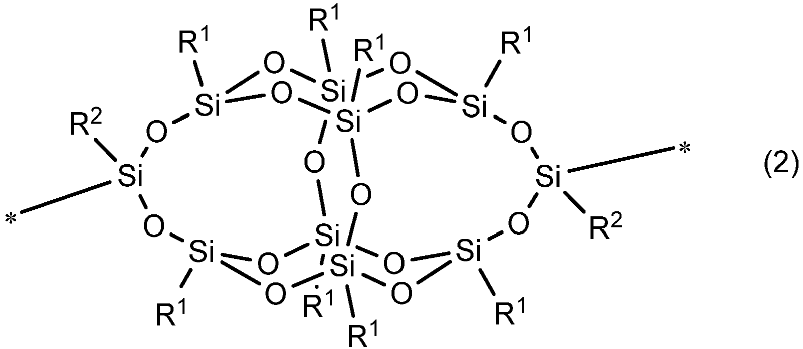 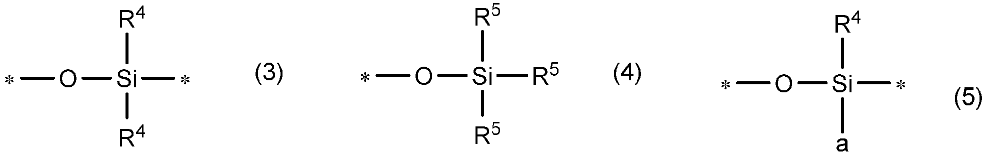
(R¹'s independently represent aryl having 6-20 carbon atoms, cycloalkyl having 5 or 6 carbon atoms, arylalkyl having 7-40 carbon atoms or alkyl having 1-40 carbon atoms, in the aryl having 6-20 carbon atoms, the cycloalkyl having 5 or 6 carbon atoms and the arylalkyl having 7-40 carbon atoms, an arbitrary hydrogen atom may be independently substituted with a fluorine atom or alkyl having 1-20 carbon atoms, in alkylene in the arylalkyl having 7-40 carbon atoms, an arbitrary hydrogen atom may be substituted with a fluorine atom, arbitrary -CH₂- may be independently substituted with -O-, -CH=CH- or cyclolalkylene having 5-20 carbon atoms, in the alkyl having 1-40 carbon atoms, an arbitrary hydrogen atom may be independently substituted with a fluorine atom, arbitrary -CH₂- may be independently substituted with -O- or cyclolalkylene having 5-20 carbon atoms;
R²'s independently represent alkyl having 1-8 carbon atoms or aryl having 6-20 carbon atoms;
R³ represents a hydroxyl group;
R⁴'s independently represent a hydroxyl group, hydrogen, alkyl having 1-8 carbon atoms or aryl having 6-20 carbon atoms;
R⁵'s represent a hydroxyl group, alkoxy having 1-8 carbon atoms, hydrogen, alkenyl having 2-40 carbon atoms, alkyl having 1-8 carbon atoms or aryl having 6-20 carbon atoms;
a represents the following structure; 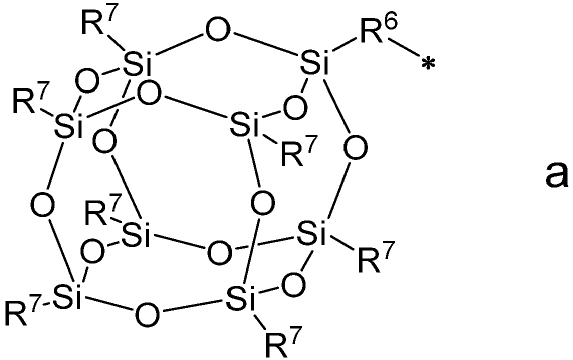
R⁶'s each independently represent alkylene having 1-40 carbon atoms, in the alkylene having 1-40 carbon atoms, arbitrary -CH₂- may be independently substituted with -O- or cyclolalkylene having 5-20 carbon atoms;
R⁷'s each independently represent aryl having 6-20 carbon atoms, cycloalkyl having 5-6 carbon atoms, arylalkyl having 7-40 carbon atoms or alkyl having 1-40 carbon atoms, in the aryl having 6-20 carbon atoms, the cycloalkyl having 5-6 carbon atoms and the arylalkyl having 7-40 carbon atoms, an arbitrary hydrogen atom may be independently substituted with a fluorine atom or alkyl having 1-20 carbon atoms, in alkylene in the arylalkyl having 7-40 carbon atoms, an arbitrary hydrogen atom may be independently substituted with a fluorine atom or alkyl having 1-20 carbon atoms, in alkylene in the arylalkyl having 7-40 carbon atoms, an arbitrary hydrogen atom may be substituted with a fluorine atom, arbitrary -CH₂- may be independently substituted with -O-, -CH=CH- or cyclolalkylene having 5-20 carbon atoms, in the alkyl having 1-40 carbon atoms, an arbitrary hydrogen atom may be independently substituted with a fluorine atom, arbitrary -CH₂- may be independently substituted with -O- or cyclolalkylene having 5-20 carbon atoms, and * in formulas represents a binding part).

2. The curable resin composition according to Claim 1,
wherein the silicon compound (A) is formed from any one or more of the silsesquioxane groups represented by formula (1) or (2) and from any one or more of siloxane groups represented by formula (6) or (7), 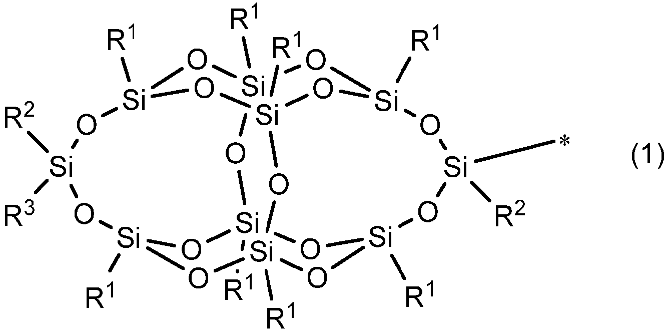 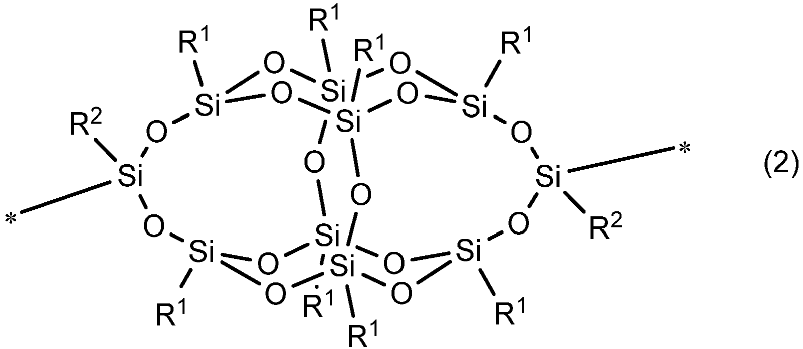 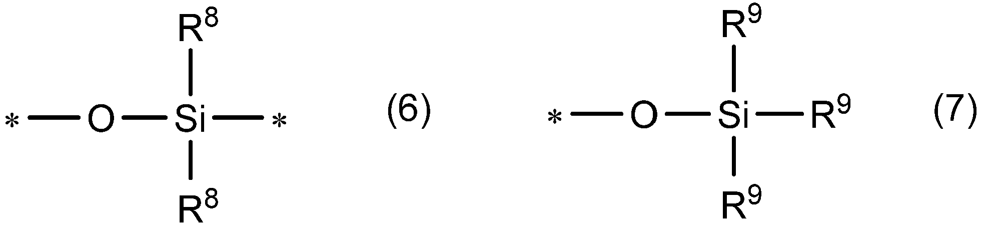
(R⁸'s each independently represent a hydroxyl group, alkyl having 1-8 carbon atoms or a group represented by aryl having 6-20 carbon atoms;
R⁹'s independently represent a hydroxyl group, alkoxy having 1-8 carbon atoms, alkyl having 1-8 carbon atoms or aryl having 6-20 carbon atoms, and, in a group represented by formula (7), at least one R⁹ represents a hydroxyl group or alkoxy having 1-8 carbon atoms).

3. The curable resin composition according to Claim 1,
wherein the silicon compound (A) is a compound represented by formula (8), 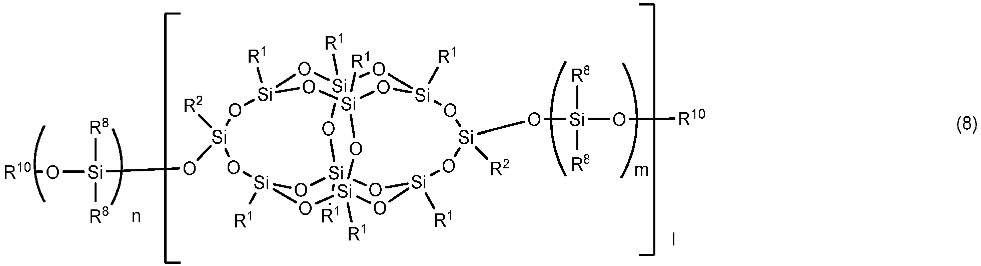 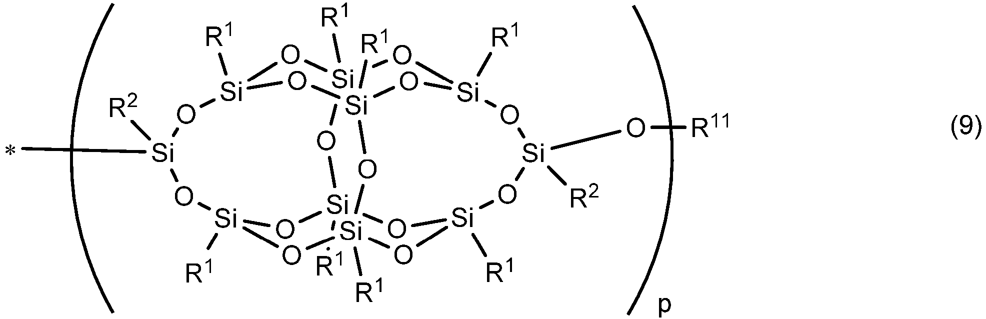 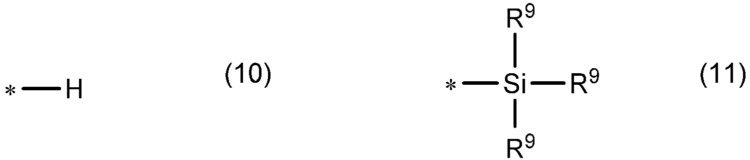
(R¹ and R² represent groups defined as the same as R¹ and R² in the group represented by formula (1) in Claim 1;
R⁸ and R⁹ represent groups defined as the same as R⁸ and R⁹ in the groups represented by formulas (6) and (7) in Claim 2, in a group represented by formula (11), at least one R⁹ represents a hydroxyl group or alkoxy having 1-8 carbon atoms;
R¹⁰ represents a group represented by formula (9);
R¹¹ represents a group represented by formula (10) or formula (11);
n is an average value satisfying 1-30;
m is a positive average value satisfying 0-30;
l is a numerical value satisfying a weight average molecular weight of 3,000-1,000,000; and
p is 0 or 1).

4. The curable resin composition according to Claim 2, further comprising:
a crosslinking agent (C) other than the silicon compound (A) having two or more crosslinkable groups that can be chemically bound to the silicon compound (A).

5. The curable resin composition according to Claim 2,
wherein the crosslinkable group is a group of any of formulas (12)-(17) bound to Si,
*-OR¹² (12) 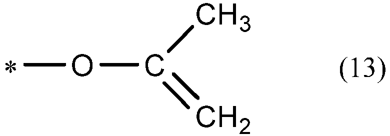 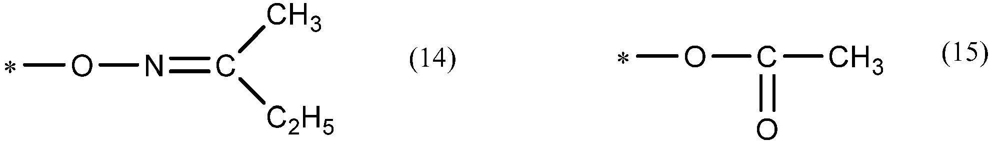
*-OH (16)
*-H (17)
(R¹² represents alkyl having 1-8 carbon atoms).

6. The curable resin composition according to Claim 2, further comprising:
a catalyst (D).

7. The curable resin composition according to Claim 2,
wherein the catalyst (D) has any one or more of Sn, Zr, Ti, Al, N and Pt.

8. The curable resin composition according to Claim 1,
wherein the silicon compound (A) is formed from any one or more of silsesquioxane groups represented by formula (1) or (2) and from at least one of siloxane groups represented by formulas (18)-(20), 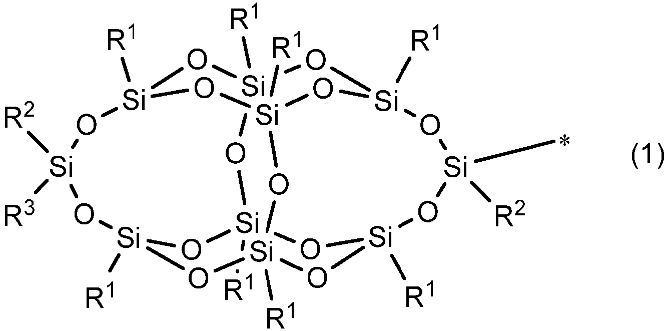 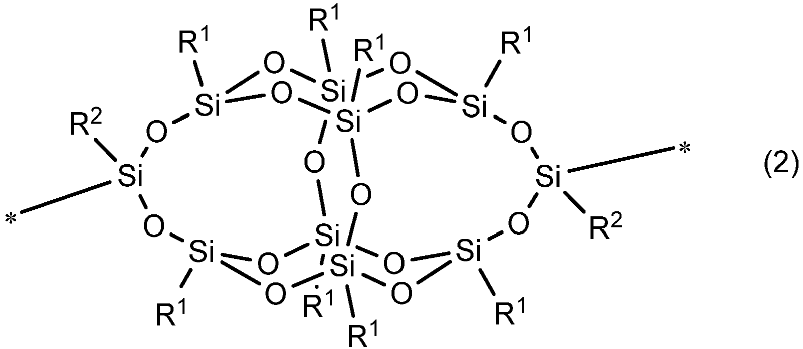 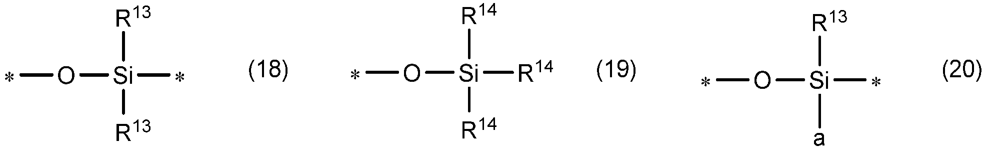
(R¹³'s independently represent hydrogen, alkyl having 1-8 carbon atoms or aryl having 6-20 carbon atoms;
R¹⁴'s independently represent hydrogen, a hydroxyl group, alkoxy having 1-8 carbon atoms, alkenyl having 2-40 carbon atoms, alkyl having 1-8 carbon atoms or aryl having 6-20 carbon atoms; and
a represents the same group as a in Claim 1).

9. The curable resin composition according to Claim 1,
wherein the silicon compound (A) is a compound represented by formula (21), 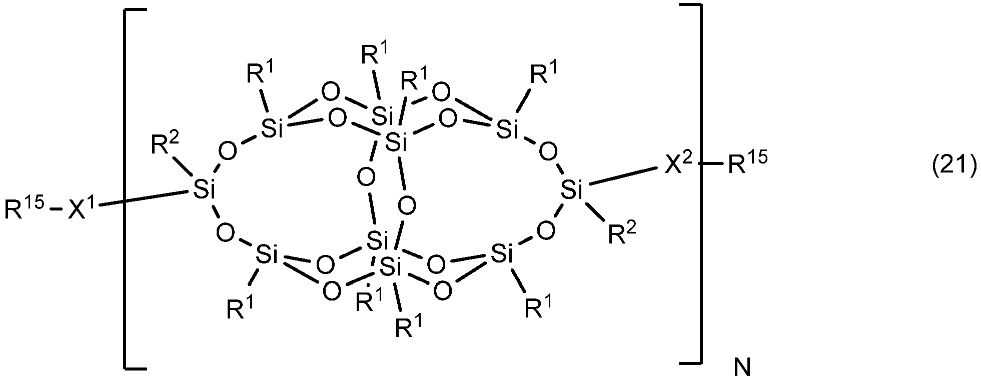 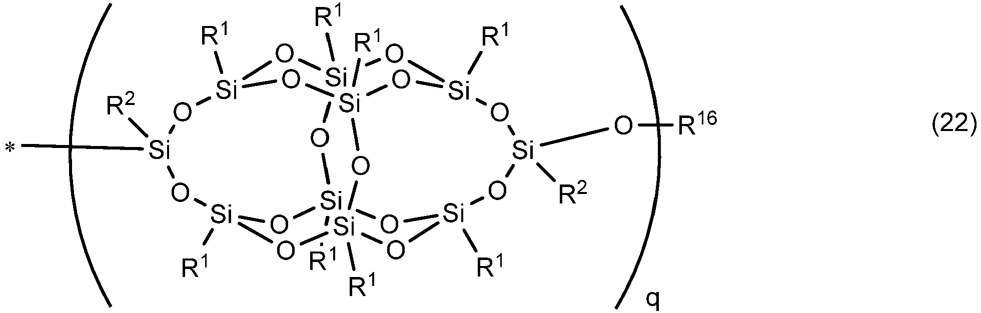
*-H (23) 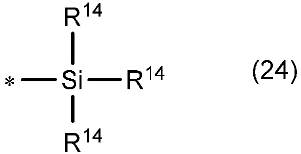
(N is a value satisfying a weight average molecular weight of 3,000-1,000,000; and;
R¹ and R² represent groups defined as the same as R¹ and R² in the group represented by formula (1) in Claim 1;
R¹⁵ represents a group represented by formula (22);
R¹⁶ represents a group represented by formula (23) or formula (24);
in the group represented by formula (24), R¹⁴ represents a group defined as the same as R¹⁴ in the group represented by formula (19);
q is 0 or 1;
X¹ and X² independently represent at least one selected from repeating units represented by formulas (25)-(30); 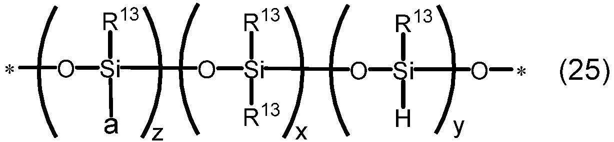 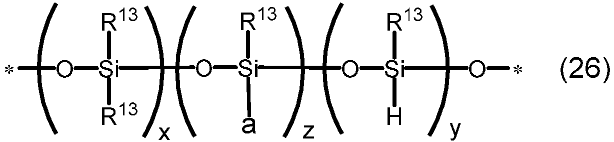 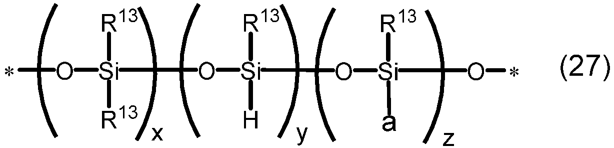 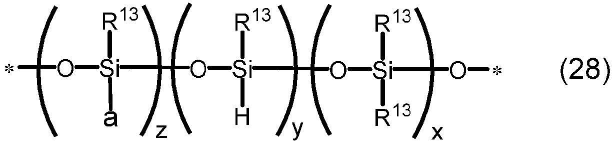 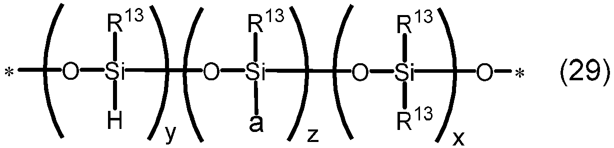 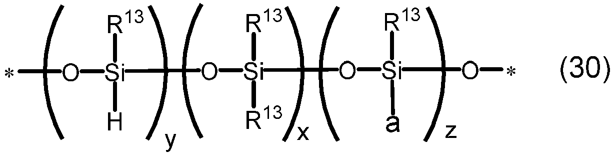
a represents a group defined as the same as a in Claim 1;
R¹³ represents a group defined as the same as R¹³ in the group represented by formula (18) in Claim 8;
x and z are average values satisfying 0-30, and y is a positive average value satisfying 1-30).

10. The curable resin composition according to Claim 8, further comprising:
a crosslinking agent (C) other than the silicon compound (A) having two or more crosslinkable groups that can be chemically bound to the silicon compound (A).

11. The curable resin composition according to Claim 8,
wherein the crosslinkable group is a group of any of formulas (12)-(17) or (31) bound to Si,
*-OR¹² (12) 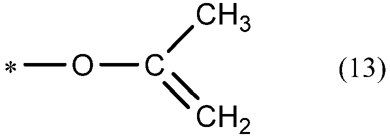 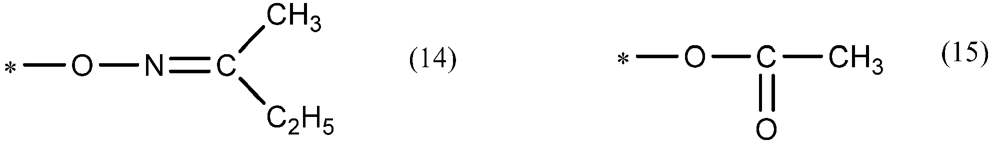
*-OH (16)
*-H (17)
(R¹² represents alkyl having 1-8 carbon atoms).

12. The curable resin composition according to Claim 8, further containing:
a catalyst (D).

13. The curable resin composition according to Claim 8,
wherein the catalyst (D) has any one or more of Sn, Zr, Ti, Al, N and Pt.

14. A cured product formed by curing the curable resin composition according to any one of Claims 1-13.

15. An electronic component comprising:
the cured product according to Claim 14.

16. An optical component comprising:
the cured product according to Claim 14.

17. A composite member comprising:
a first member; and
a resin-containing member in contact with the first member and configuring a part of an electrical element,
wherein the resin-containing member contains the cured product according to Claim 14.

18. The composite member according to Claim 17,
wherein the resin-containing member is a protective film that coats at least a part of the first member.

19. The composite member according to Claim 18,
wherein the first member is a wiring board including a wiring in a parent material, and the protective film has insulating properties and covers the wiring.

20. The composite member according to Claim 17, further comprising:
a second member in contact with the resin-containing member.
